# EUROPÄISCHE PATENTSCHRIFT

(11) **EP 1 888 706 B1**
(45) Veröffentlichungstag und Bekanntmachung des Hinweises auf die Patenterteilung: **01.03.2017**
(21) Anmeldenummer: 06724095.2
(22) Anmeldetag: 06.04.2006
(51) Int. Cl.: C09K 11/06, H05B 33/14, C07F 5/02, C07F 5/05, C07F 15/00, H01L 51/00, H01L 51/50, C09B 23/14, C09B 57/00, C09B 57/10, C09B 1/00, C09B 1/02, C09B 3/02, C09B 3/78, C07F 9/46, C08G 79/08

(54) **ORGANISCHE ELEKTROLUMINESZENZVORRICHTUNG UND IN DEREN HERSTELLUNG VERWENDETE BORONSÄURE- UND BORINSÄURE-DERIVATE**
ORGANIC ELECTROLUMINESCENT DEVICE AND BORIC ACID AND BORINIC ACID DERIVATIVES USED THEREIN
DISPOSITIF ELECTROLUMINESCENT ORGANIQUE, ET DERIVES D'ACIDE BORONIQUE ET D'ACIDE BORINIQUE UTILISES POUR PRODUIRE CE DISPOSITIF ELECTROLUMINESCENT ORGANIQUE

(30) Priorität: 03.05.2005 EP 05009643
(43) Veröffentlichungstag der Anmeldung: 20.02.2008
(73) Patentinhaber: Merck Patent GmbH, 64293 Darmstadt (DE)
(72) Erfinder: STOESSEL, Philipp, 60487 Frankfurt am Main (DE); BREUNING, Esther, 65527 Niedernhausen (DE); BUESING, Arne, 65959 Frankfurt/Main (DE); PARHAM, Amir, 65929 Frankfurt/Main (DE); HEIL, Holger, 64285 Darmstadt (DE); VESTWEBER, Horst, 34630 Gilersberg-Winterscheid (DE)
(86) Internationale Anmeldenummer: PCT/EP2006/003150
(87) Internationale Veröffentlichungsnummer: WO 2006/117052

(56) Entgegenhaltungen:
- EP-A- 1 142 895
- WO-A-02/051850
- WO-A-02/052661
- WO-A-03/033617
- WO-A-03/095445
- WO-A-2005/020283
- US-A1- 2002 019 527
- US-A1- 2003 229 096
- US-A1- 2004 147 742
- US-A1- 2004 260 090
- PATENT ABSTRACTS OF JAPAN Bd. 2003, Nr. 05, 12. Mai 2003 (2003-05-12) -& JP 2003 031368 A (KONICA CORP; SHIROTA YASUHIKO), 31. Januar 2003 (2003-01-31) in der Anmeldung erwähnt
- KAUPP GERD ET AL: "Waste-free and facile solid-state protection of diamines, anthranilic acid, diols, and polyols with phenylboronic acid." CHEMISTRY, A EUROPEAN JOURNAL, Bd. 9, Nr. 17, 5. September 2003 (2003-09-05), Seiten 4156-4161, XP009060528 ISSN: 0947-6539 in der Anmeldung erwähnt
- WONG KEN-TSUNG ET AL: "Efficient and convenient nonaqueous workup procedure for the preparation of arylboronic esters." JOURNAL OF ORGANIC CHEMISTRY, Bd. 67, Nr. 3, 8. Februar 2002 (2002-02-08), Seiten 1041-1044, XP009060532 ISSN: 0022-3263 in der Anmeldung erwähnt
- PATENT ABSTRACTS OF JAPAN Bd. 2003, Nr. 12, 5. Dezember 2003 (2003-12-05) & JP 2004 189705 A (KOEI CHEM CO LTD), 8. Juli 2004 (2004-07-08) in der Anmeldung erwähnt
- GOSWAMI A ET AL: "Cobalt-mediated cyclooligomerisation reactions of borylacetylenes" EUROPEAN JOURNAL OF INORGANIC CHEMISTRY, Nr. 13, Juli 2004 (2004-07), Seiten 2635-2645, XP009060530 in der Anmeldung erwähnt
- ISHIYAMA T ET AL: "Synthesis of arylboronates via palladium-catalysed cross-coupling reaction of alkoxydiboron with aryl halides or triflates" SPECIAL PUBLICATION - ROYAL SOCIETY OF CHEMISTRY, Bd. 201, 1997, Seiten 92-95, XP009060529 in der Anmeldung erwähnt
- BAUMGARTEN M ET AL: "Electronic decoupling in ground and excited states of asymmetric biaryls" JOURNAL OF PHYSICAL CHEMISTRY A, Bd. 104, Nr. 6, 17. Februar 2000 (2000-02-17), Seiten 1130-1140, XP009060435 ISSN: 1089-5639
- RAMSEY B G ET AL: "A laser desorption ionization mass spectrometry investigation of triarylboranes and tri-9-anthrylborane photolysis products" JOURNAL OF ORGANOMETALLIC CHEMISTRY, Bd. 690, Nr. 4, 14. Februar 2005 (2005-02-14), Seiten 962-971, XP004736553 ISSN: 0022-328X
- YAMASHITA M ET AL: "Synthesis of a versatile tridentate anthracene ligand and its application for the synthesis of hypervalent pentacoordinate boron compounds (10-B-5)" ANGEWANDTE CHEMIE INTERNATIONAL EDITION, Bd. 39, Nr. 22, 17. November 2000 (2000-11-17), Seiten 4055-4058, XP009060434 ISSN: 1433-7851 in der Anmeldung erwähnt
- AMANN N ET AL: "Preparation of pyrenyl-modified nucleosides via Suzuki-Miyaura cross-coupling reactions" SYNLETT, Nr. 5, Mai 2002 (2002-05), Seiten 687-691, XP009060442 ISSN: 0936-5214
- BEINHOFF M ET AL: "Synthesis and spectroscopic properties of arene-substituted pyrene derivatives as moel compounds for fluorescent polarity probes" EUROPEAN JOURNAL OF ORGANIC CHEMISTRY, Nr. 20, Oktober 2001 (2001-10), Seiten 3819-3829, XP009060439 ISSN: 1434-193X
- AMANN N ET AL: "Electron injection into DNA: synthesis and spectroscopic properties of pyrenyl-modified oligonucleotides" CHEMISTRY, A EUROPEAN JOURNAL, Bd. 8, Nr. 21, 4. November 2002 (2002-11-04), Seiten 4877-4883, XP009060440 ISSN: 0947-6539
- MODRAKOWSKI C ET AL: "Synthesis of pyrene containing building blocks for dendrimer synthesis" SYNTHESIS, Nr. 14, 2001, Seiten 2143-2155, XP002970491 ISSN: 0039-7881
- CHOW H F ET AL: "Atropisomerism of the C-1-C'-1 axis of 2,2',8,8'-unsubstituted 1,1'-binaphthyl derivatives." JOURNAL OF ORGANIC CHEMISTRY, Bd. 66, Nr. 15, 27. Juli 2001 (2001-07-27), Seiten 5042-5047, XP001206512 ISSN: 0022-3263
- KOCH K-H ET AL: "Polyarylenes and poly(arylenevinylene)s, V. Synthesis of tetraalkyl-substituted oligo(1,4-naphthylene)s and cyclisation to soluble oligo(peri-naphthylene)s" CHEMISCHE BERICHTE, Bd. 124, Nr. 9, 1991, Seiten 2091-2100, XP009060533 ISSN: 0009-2940
- CHOW H-F ET AL: "Multicenter homogeneous dendritic catalysts: The higher the generation, the better the reactivity and selectivity? - A comparative study of the catalytic efficiency of dendrimeric [1,1'-binaphthalene]-2,2'-diol-derived catalysts" HELVETICA CHIMICA ACTA, Bd. 85, Nr. 10, Oktober 2002 (2002-10), Seiten 3444-3454, XP009060464 ISSN: 0018-019X
- ISHIKURA M ET AL: "A simple and regioselective preparation of 2 or 3 substituted quinoline derivatives via dialkylquinolylboranes" HETEROCYCLES, Bd. 23, Nr. 9, 1985, Seiten 2375-2386, XP009060474 ISSN: 0385-5414
- MICHELS J J ET AL: "Synthesis of Conjugated Polyrotaxanes" CHEMISTRY, A EUROPEAN JOURNAL, Bd. 9, Nr. 24, 15. Dezember 2003 (2003-12-15), Seiten 6167-6176, XP009060485 ISSN: 0947-6539
- TIRAPATTUR S ET AL: "Spectroscopic study of intermolecular interactions in various oligofluorenes: precursors of light-emitting polymers" JOURNAL OF PHYSICAL CHEMISTRY B, Bd. 106, Nr. 25, 5. September 2002 (2002-09-05), Seiten 8959-8966, XP009060470 ISSN: 1089-5647
- WONG K-T ET AL: "Ter(9,9-diarylfluorene)s: Highly efficient blue emitter with promising electrochemical and thermal stability" JOURNAL OF THE AMERICAN CHEMICAL SOCIETY, Bd. 124, Nr. 39, 2. Oktober 2002 (2002-10-02), Seiten 11576-11577, XP009060461 ISSN: 0002-7863
- FINOCCHIARO P ET AL: "Conformational dynamics of alkoxydiarylboranes" JOURNAL OF THE AMERICAN CHEMICAL SOCIETY USA, Bd. 95, Nr. 21, 17. Oktober 1973 (1973-10-17), Seiten 7029-7036, XP009060436 ISSN: 0002-7863

## Beschreibung

In einer Reihe verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft erwartet. Der allgemeine Aufbau organischer Elektrolumineszenzvorrichtungen ist beispielsweise in US 4539507, US 5151629, EP 0676461 und WO 98/27136 beschrieben. Allerdings zeigen diese Vorrichtungen noch erhebliche Probleme, die einer dringenden Verbesserung bedürfen:
1. Die operative Lebensdauer ist insbesondere bei blauer Emission immer noch gering, so dass bis dato nur einfache Anwendungen kommerziell realisiert werden konnten.
2. Es werden teilweise Mischungen isomerer Verbindungen verwendet, die unterschiedliche physikalische Eigenschaften (Glasübergangstemperatur, Glasbildungseigenschaften, Absorption, Photolumineszenz) aufweisen können. Da diese Stereoisomeren teilweise auch bei der Verarbeitungstemperatur unterschiedliche Dampfdrücke aufweisen, ist keine einheitliche, reproduzierbare Herstellung der organischen elektronischen Vorrichtung möglich. Dieses Problem ist in der nicht offen gelegten Anmeldung EP 04026402.0 ausführlich beschrieben.
3. Die verwendeten Verbindungen sind teilweise nur schwer in gängigen organischen Lösemitteln löslich, was ihre Reinigung bei der Synthese, aber auch die Reinigung der Anlagen bei der Herstellung der organischen elektronischen Vorrichtungen erschwert.
4. Viele der verwendeten Verbindungen, insbesondere solche, die als Hostmaterialien in fluoreszierenden oder phosphoreszierenden Vorrichtungen verwendet werden, sind nur in mehrstufigen Synthesen zugänglich, und auch die Reinigung der Verbindung ist häufig sehr aufwändig, was einen deutlichen Nachteil für die Verwendung dieser Verbindungen darstellt.
5. Viele der verwendeten Materialien sind nicht ausreichend thermisch stabil oder weisen eine sehr hohe Verdampfungstemperatur auf, was eine hohe thermische Belastung empfindlicher Geräteteile, wie beispielsweise der Schattenmaske, mit sich bringt. Dies gilt insbesondere für Stilbenamin-Verbindungen und für ortho-metallierte Iridiumkomplexe.

Als nächstliegender Stand der Technik kann in fluoreszierenden OLEDs die Verwendung verschiedener kondensierter Aromaten, insbesondere Anthracen- oder Pyrenderivate, als Host-Materialien vor allem für blau emittierende Elektrolumineszenzvorrichtungen genannt werden, z. B. 9,10-Bis(2-naphthyl)anthracen (US 5935721). In WO 03/095445 und in CN 1362464 werden 9,10-Bis(1-naphthyl)anthracen-Derivate für die Verwendung in OLEDs beschrieben. Weitere Anthracen-Derivate, die sich als Host-Materialien eignen, sind in WO 01/076323, in WO 01/021729, in WO 04/013073, in WO 04/018588, in WO 03/087023 oder in WO 04/018587 beschrieben. Host-Materialien, basierend auf arylsubstituierten Pyrenen und Chrysenen, werden in WO 04/016575 beschrieben, wobei hier prinzipiell auch entsprechende Anthracen- und Phenanthren-Derivate mit umfasst sind. Auch wenn mit diesen Verbindungen bereits gute Ergebnisse erzielt wurden, ist es für hochwertige Anwendungen notwendig, verbesserte Host-Materialien zur Verfügung zu haben. Außerdem sind diese Verbindungen teilweise nur aufwändig in mehrstufigen Synthesen zugänglich.

In phosphoreszierenden OLEDs wird als Matrixmaterial häufig 4,4'-Bis-(N-carbazolyl)biphenyl (CBP) verwendet. Die Nachteile sind unter anderem kurze Lebensdauern der mit ihnen hergestellten Devices und häufig hohe Betriebsspannungen, die zu geringen Leistungseffizienzen führen. Des Weiteren hat sich gezeigt, dass aus energetischen Gründen CBP für blau emittierende Elektrolumineszenzvorrichtungen ungeeignet ist, was in einer schlechten Effizienz resultiert. Außerdem ist der Aufbau der Devices komplex, wenn CBP als Matrixmaterial verwendet wird, da zusätzlich eine Lochblockierschicht und eine Elektronentransportschicht verwendet werden müssen. Verbesserte Triplett-Matrixmaterialien, basierend auf Ketoverbindungen von Spirobifluoren, sind in WO 04/093207 beschrieben. Für die besten der dort beschriebenen Matrixmaterialien werden jedoch in der Synthese giftige anorganische Cyanide benötigt, so dass die Herstellung dieser Materialien ökologisch bedenklich ist.

Als Elektronentransportverbindung in organischen Elektrolumineszenzvorrichtungen wird meist AlQ₃ (Aluminium-tris-hydroxychinolinat) verwendet (US 4539507). Dieses hat mehrere Nachteile: Es lässt sich nicht rückstandsfrei aufdampfen, da es sich bei der Sublimationstemperatur teilweise zersetzt, was insbesondere für Produktionsanlagen ein großes Problem darstellt. Ein entscheidender praktischer Nachteil ist die starke Hygroskopie von AlQ₃. Für die Verwendung in OLEDs muss AlQ₃ deshalb in komplizierten, mehrstufigen Sublimationsverfahren aufwändig gereinigt und im Anschluss daran unter Wasserausschluss in einer Schutzgasatmosphäre gelagert und gehandhabt werden. AlQ₃ hat außerdem eine niedrige Elektronenbeweglichkeit, was zu höheren Spannungen und damit zu einer niedrigeren Leistungseffizienz führt. Um Kurzschlüsse im Display zu vermeiden, würde man gern die Schichtdicke erhöhen; dies ist mit AlQ₃ wegen der geringen Ladungsträgerbeweglichkeit und der daraus resultierenden Spannungserhöhung nicht möglich. Als sehr ungünstig erweist sich weiterhin die Eigenfarbe von AlQ₃ (im Feststoff gelb), die gerade bei blauen OLEDs durch Reabsorption und schwache Reemission zu Farbverschiebungen führen kann. Hier sind blaue OLEDs nur mit starken Effizienz- bzw. Farborteinbußen darstellbar. Weiterer Nachteil von AlQ₃ ist die Instabilität gegenüber Löchern (Z. Popovic et al., Proceedings of SPIE 1999, 3797, 310-315), was bei einem Langzeiteinsatz immer zu Problemen im Bauelement führen kann. Trotz der genannten Nachteile stellt AlQ₃ in OLEDs bislang immer noch den besten Kompromiss für die verschiedenartigen Anforderungen an ein Elektronentransportmaterial in OLEDs dar.

Es besteht also weiterhin Bedarf an verbesserten Materialien, die in organischen elektronischen Vorrichtungen zu guten Effizienzen und gleichzeitig zu hohen Lebensdauern führen, die bei der Herstellung und beim Betrieb der Vorrichtung zu reproduzierbaren Ergebnissen führen und die synthetisch einfach zugänglich sind.

Überraschend wurde gefunden, dass organische Elektrolumineszenzvorrichtungen, die aromatische Boronsäure-Derivate enthalten, deutliche Verbesserungen gegenüber dem Stand der Technik aufweisen. Mit diesen Materialien ist eine Steigerung der Effizienz und der Lebensdauer der organischen elektronischen Vorrichtung im Vergleich zu Materialien gemäß dem Stand der Technik möglich. Da diese Materialien keine Atropisomerie um die Aryl-Bor-Bindung zeigen können, die zu Diastereomeren führt, ist damit die reproduzierbare Herstellung der organischen elektronischen Vorrichtungen möglich. Weiterhin haben diese Materialien den Vorteil gegenüber Materialien gemäß dem Stand der Technik, dass sie mit Standardmethoden der organischen Chemie einfach zugänglich und außerdem leicht zu reinigen sind. Insbesondere überraschend ist die Beobachtung, dass diese Materialien trotz des höheren Molekulargewichts eine niedrigere Verdampfungstemperatur aufweisen. Die Verwendung dieser Materialien in organischen elektronischen Vorrichtung ist daher der Gegenstand der vorliegenden Erfindung.

Die Verwendung von Bor-Stickstoff-Verbindungen mit vierfach substituiertem Bor ist in der Literatur beschrieben (z. B. US 2005/0048311). Diese Verbindungen tragen eine negative Ladung am Bor und eine positive Ladung am Stickstoff und weisen dadurch gänzlich andere elektronische Eigenschaften auf als Bor-Stickstoff-Verbindungen, in denen das Boratom nur dreifach substituiert ist. Die Verwendung von Bor-Stickstoff-Verbindungen mit dreifach substituiertem Bor, insbesondere solche, die noch eine Bor-Kohlenstoff-Bindung aufweisen, geht aus der Beschreibung nicht hervor.

Weiterhin wird in WO 02/052661 und WO 02/051850 die Verwendung aromatischer Borane, also Borverbindungen, die drei Bor-Aryl-Bindungen aufweisen, in OLEDs beschrieben. In JP 2003/031368 werden Bisborane beschrieben, in denen zwei substituierte Borangruppen durch eine aromatische Gruppe verbrückt werden, wobei am Bor noch weitere aromatische oder aliphatische Gruppen gebunden sind. Diese Materialien werden als Elektronentransport- bzw. Lochblockiermaterialien und als Hostmaterialien beschrieben. Borane weisen jedoch generell das Problem einer hohen chemischen Reaktivität auf. Insbesondere sind diese Verbindungen stark oxidationsempfindlich, was ihre Synthese und Handhabung deutlich erschwert. So zersetzen sich sterisch wenig gehinderte Borane bereits innerhalb kurzer Zeit an der Luft (A. Schulz, W. Kaim, Chem. Ber. 1989, 122, 1863-1868), und selbst sterisch gehinderte Borane, wie beispielsweise Mesityl-substituierte Borane, sind immer noch so empfindlich, dass ihre Handhabung unter Schutzgas erforderlich ist. Diese Empfindlichkeit schränkt Verwendungsmöglichkeit dieser Verbindungen deutlich ein.

Arylboronsäure-Derivate weisen die oben genannten Nachteile der Borane nicht oder in deutlich vermindertem Maße auf. Derartige Boronsäure- bzw. Borinsäure-Derivate sind Schlüssel-Zwischenprodukte für Kupplungsreaktionen gemäß Suzuki und wurden bisher häufig als Edukte bzw. Zwischenprodukte für die Synthese organischer Halbleiter eingesetzt. Ihre Verwendung als aktive Komponente in OLEDs ist jedoch unbekannt.

Gegenstand der Erfindung ist die Verwendung aromatischer Boronsäure-Derivate gemäß der Formel (2), wie in Anspruch 1 definiert, in organischen elektronischen Vorrichtungen.

Dabei ist mit der Verwendung gemeint, dass die entsprechenden Verbindungen direkt in der organischen elektronischen Vorrichtung als aktive Komponente eingesetzt werden und nicht als Zwischenprodukt für die Synthese weiterer Verbindungen.

Gegenstand der Erfindung sind weiterhin organische elektronische Vorrichtungen, enthaltend mindestens eine organische Schicht, die mindestens ein aromatisches Boronsäure-Derivat enthält, wobei das Boratom dreifach substituiert ist und das Boronsäure-Derivat ein cyclisches Boronsäureanhydrid, ein Boronsäureester, ein Boronsäureamid oder ein Boronsäureamidoester ist, dadurch gekennzeichnet, dass das Boronsäure-Derivat eine Struktur gemäß Formel (2), wie in Anspruch 1 definiert, aufweist.

Unter einem aromatischen Boronsäure-Derivat wird eine Verbindung verstanden, bei der das Boratom direkt an eine aromatische bzw. heteroaromatische Einheit gebunden ist. Bevorzugt erfolgt die Bindung des Boratoms an ein Kohlenstoffatom der aromatischen bzw. heteroaromatischen Einheit und nicht an ein gegebenenfalls vorhandenes Heteroatom. Unter einem aromatischen Boronsäure-Derivat im Sinne dieser Erfindung werden keine Polymere oder Oligomere verstanden, die das Boronsäure-Derivat nur an den Kettenenden gebunden enthalten.

In einem Boronsäure-Derivat im Sinne dieser Erfindung ist das Boratom dreifach substituiert. Verbindungen mit vierfach substituiertem Bor fallen nicht unter die Bezeichnung Boronsäure-Derivat. Das Boronsäure-Derivat ist ein cyclisches Boronsäureanhydrid, ein cyclisches Boronsäureimid, ein Boronsäureester, ein Boronsäureamid oder ein Boronsäureamidoester. Die Verwendung freier Boronsäuren in organischen elektronischen Vorrichtungen ist ungeeignet, da sie thermisch zur Dehydratation unter Bildung von Boronsäureanhydriden unter Freisetzung von Wasser neigen. Der Begriff Boronsäure-Derivat umfasst also nicht die freie Boronsäure. Jedoch können freie Boronsäuren als Edukte verwendet werden, aus denen in einem Aufdampfprozess die entsprechenden Boronsäureanhydride aufgedampft werden. Ebenso können freie Boronsäuren zur Herstellung der Vorrichtung verwendet werden und erst in der Vorrichtung, beispielsweise durch Reaktion mit einer anderen Verbindung in der Schicht, zum entsprechenden Boronsäure-Derivat umgesetzt werden. Die allgemeinen Strukturen einiger Boronsäure-Derivate sind im folgenden Schema 1 abgebildet, wobei Ar hier allgemein für ein aromatisches Ringsystem und R für einen organischen Rest steht:

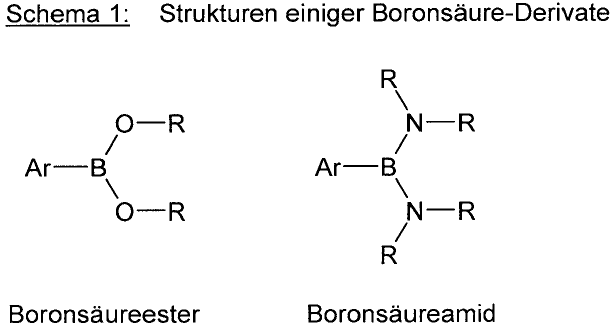

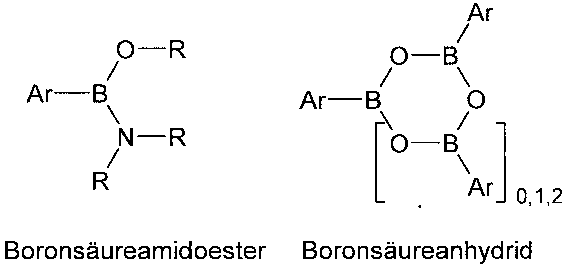

Bevorzugt bildet das Boronsäure-Derivat glasartige Filme mit einer Glasübergangstemperatur T_{g} von größer 70 °C, besonders bevorzugt größer 100 °C, ganz besonders bevorzugt größer 130 °C.

Weiterhin bevorzugt weist das Boronsäure-Derivat ein Molekulargewicht von mindestens 250 g/mol auf, besonders bevorzugt mindestens 300 g/mol, ganz besonders bevorzugt mindestens 400 g/mol. Weiterhin ist das Molekulargewicht des Boronsäure-Derivats, wenn dieses durch einen Aufdampfprozess aufgebracht werden soll, bevorzugt kleiner als 5000 g/mol, besonders bevorzugt kleiner als 2000 g/mol, ganz besonders bevorzugt kleiner als 1500 g/mol. Dabei handelt es sich bevorzugt um eine definierte Verbindung.

Die organische elektronische Vorrichtung ist bevorzugt ausgewählt aus der Gruppe bestehend aus organischen oder polymeren Leuchtdioden (OLEDs, PLEDs), organischen Feld-Effekt-Transistoren (O-FETs), organischen Dünnfilmtransistoren (O-TFTs), organischen lichtemittierenden Transistoren (O-LETs), organischen integrierten Schaltungen (O-ICs), organischen Solarzellen (O-SCs), organischen Feld-Quench-Devices (O-FQDs), lichtemittierenden elektrochemischen Zellen (LECs), organischen Photorezeptoren oder organischen Laserdioden (O-Laser). Besonders bevorzugt sind organische oder polymere Leuchtdioden.

Die organische elektronische Vorrichtung enthält üblicherweise Anode, Kathode und mindestens eine organische Schicht, die mindestens ein aromatisches Boronsäure-Derivat enthält. In organischen Elektrolumineszenzvorrichtungen ist mindestens eine der organischen Schichten eine Emissionsschicht. Dabei kann die Emission Fluoreszenz oder Phosphoreszenz sein, oder es können auch in einer Schicht oder in mehreren Schichten mehrere verschiedene Emitter vorhanden sein, wobei ein Teil der Emitter Fluoreszenz und ein anderer Teil der Emitter Phosphoreszenz zeigt. Es kann auch bevorzugt sein, wenn die organische elektronische Vorrichtung außer Anode, Kathode und der Emissionsschicht noch weitere Schichten enthält. Diese können beispielsweise sein: Lochinjektionsschicht, Lochtransportschicht, Lochblockierschicht, Elektronentransportschicht und/oder Elektroneninjektionsschicht. Es sei aber an dieser Stelle darauf hingewiesen, dass nicht notwendigerweise jede dieser Schichten vorhanden sein muss.

So werden insbesondere bei Verwendung von Boronsäure-Derivaten in der Emissionsschicht weiterhin sehr gute Ergebnisse erzielt, wenn die organische Elektrolumineszenzvorrichtung keine separate Elektronentransportschicht und/oder keine separate Lochblockierschicht enthält und die emittierende Schicht direkt an die Elektroneninjektionsschicht oder an die Kathode grenzt. Ebenfalls kann es bevorzugt sein, wenn die organische Elektrolumineszenzvorrichtung keine separate Lochtransportschicht enthält und die emittierende Schicht direkt an die Lochinjektionsschicht oder an die Anode grenzt.

In einer bevorzugten Ausführungsform der Erfindung wird das Boronsäure-Derivat in einer Emissionsschicht eingesetzt. Es kann dabei als Reinsubstanz eingesetzt werden, wird aber bevorzugt als Host-Material in Kombination mit einem fluoreszierenden oder phosphoreszierenden Dotanden eingesetzt. Hierfür kommen prinzipiell alle fluoreszierenden oder phosphoreszierenden Dotanden in Frage, wie sie in der Literatur beschrieben und unten näher ausgeführt sind.

In fluoreszierenden Vorrichtungen ist der Dotand bevorzugt ausgewählt aus der Klasse der Monostyrylamine, der Distyrylamine, der Tristyrylamine, der Tetrastyrylamine und der Arylamine. Unter einem Monostyrylamin wird eine Verbindung verstanden, die eine Styrylgruppe und mindestens ein Amin enthält, welches bevorzugt aromatisch ist. Unter einem Distyrylamin wird eine Verbindung verstanden, die zwei Styrylgruppen und mindestens ein Amin enthält, welches bevorzugt aromatisch ist. Unter einem Tristyrylamin wird eine Verbindung verstanden, die drei Styrylgruppen und mindestens ein Amin enthält, welches bevorzugt aromatisch ist. Unter einem Tetrastyrylamin wird eine Verbindung verstanden, die vier Styrylgruppen und mindestens ein Amin enthält, welches bevorzugt aromatisch ist. Unter einem Arylamin bzw. einem aromatischen Amin im Sinne dieser Erfindung wird eine Verbindung verstanden, die drei aromatische oder heteroaromatische Ringsysteme direkt an den Stickstoff gebunden enthält. Unter einer Styrylgruppe im Sinne dieser Erfindung wird eine substituierte oder unsubstituierte Vinylgruppe, die direkt an eine Aryl- oder Heteroarylgruppe gebunden ist, verstanden. Die Styrylgruppen sind besonders bevorzugt Stilbene, die auch an der Doppelbindung oder an den Aromaten weiter substituiert sein können. Dabei kommen als Substituenten insbesondere die unten ausgeführten Gruppen R¹ in Frage. Beispiele für derartige Dotanden sind substituierte oder unsubstituierte Tristilbenamine oder weitere Dotanden, die beispielsweise in WO 06/000388 und in den nicht offen gelegten Patentanmeldungen EP 04028407.7 und EP 05001891.0 beschrieben sind.

Dabei beträgt der Anteil des Boronsäure-Derivats als Host in der fluoreszierenden Mischung der Emissionsschicht üblicherweise zwischen 1 und 99.9 Gew.%, bevorzugt zwischen 50 und 99.5 Gew.%, besonders bevorzugt zwischen 80 und 99 Gew.%, insbesondere zwischen 90 und 99 Gew.%. Entsprechend beträgt der Anteil des fluoreszierenden Dotanden zwischen 0.1 und 99 Gew.%, bevorzugt zwischen 0.5 und 50 Gew.%, besonders bevorzugt zwischen 1 und 20 Gew.%, insbesondere zwischen 1 und 10 Gew.%.

In phosphoreszierenden Vorrichtungen ist der Dotand bevorzugt ausgewählt aus der Klasse der Metallkomplexe, enthaltend mindestens ein Element der Ordnungszahl größer 20, bevorzugt größer 38 und kleiner 84, besonders bevorzugt größer 56 und kleiner 80. Bevorzugt werden als Phosphoreszenzemitter Metallkomplexe verwendet, die Molybdän, Wolfram, Rhenium, Ruthenium, Osmium, Rhodium, Iridium, Palladium, Platin, Silber, Gold oder Europium enthalten, insbesondere Iridium oder Platin.

Die Liganden am Metall sind bevorzugt monoanionische, zweizähnig chelatisierende Liganden. Hierfür eignen sich insbesondere Liganden, die eine Metall-Kohlenstoff-Bindung ausbilden und weiterhin eine koordinative Bindung von einem Donoratom, insbesondere Stickstoff, Sauerstoff oder Phosphor, zum Metall. Bevorzugt enthält der Metallkomplex mindestens einen derartigen Liganden, besonders bevorzugt mindestens zwei derartige Liganden. Dabei ist die Bildung einer Metall-Kohlenstoff- und einer Metall-Stickstoff-Bindung bevorzugt. Dabei können beide koordinierenden Gruppen cyclisch sein, beispielsweise Phenylpyridin, Phenylisochinolin oder Derivate davon, oder sie können auch acyclisch sein, beispielsweise Liganden, die über Pyridin und ein Vinyl-C-Atom binden. Es können auch noch weitere Liganden vorhanden sein, beispielsweise β-Diketonate, etc. In einer besonders bevorzugten Ausführungsform der Erfindung enthält der Komplex nur zweizähnig chelatisierende Liganden, die eine Metall-Kohlenstoff-Bindung ausbilden.

Bevorzugte Mischungen enthalten als phosphoreszierende Emitter mindestens eine Verbindung der Formel (A) bis (D), 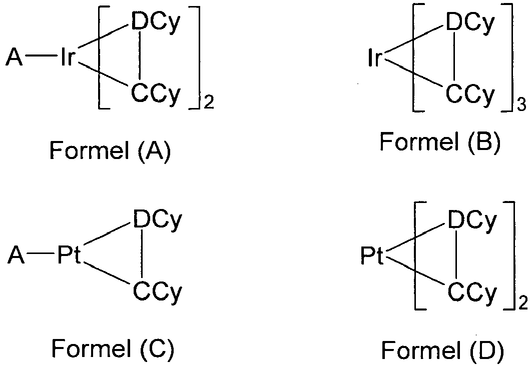 wobei für die verwendeten Symbole und Indizes Folgendes gilt:
- DCy: ist bei jedem Auftreten gleich oder verschieden eine cyclische Gruppe, die mindestens ein Donoratom, bevorzugt Stickstoff oder Phosphor, enthält, über welches die cyclische Gruppe an das Metall gebunden ist, und die wiederum einen oder mehrere Substituenten R¹ tragen kann; die Gruppen DCy und CCy sind über mindestens eine kovalente Bindung miteinander verbunden;
- CCy: ist bei jedem Auftreten gleich oder verschieden eine cyclische Gruppe, die ein Kohlenstoffatom enthält, über welches die cyclische Gruppe an das Metall gebunden ist, und die wiederum einen oder mehrere Substituenten R¹ tragen kann;
- A: ist bei jedem Auftreten gleich oder verschieden ein monoanionischer, zweizähnig chelatisierender Ligand, bevorzugt ein Diketonat-Ligand;
- R¹: hat dieselbe Bedeutung wie unten ausgeführt.

Die cyclischen Gruppen CCy und DCy können monocyclisch oder polycyclisch sein und sind bevorzugt aromatisch bzw. heteroaromatisch. Bevorzugt sind die Gruppen CCy und DCy monocyclisch oder bicyclisch, wobei die einzelnen Cyclen bevorzugt 5 oder 6 Ringatome aufweisen, beispielsweise Benzol, Pyridin, Naphthalin, Chinolin oder Isochinolin. Weiterhin können auch mehrere der Liganden über einen oder mehrere Substituenten R¹ als verbrückende Einheit zu einem größeren polypodalen Liganden verknüpft sein und/oder es kann außer der direkten kovalenten Bindung eine Brücke, insbesondere mit 1, 2 oder 3 Brückenatomen zwischen CCy und DCy vorliegen.

Besonders bevorzugt sind Strukturen der Formel (B) und (D), in denen kein weiterer Ligand A enthalten ist.

Beispiele für phosphoreszierende Emitter können den Anmeldungen WO 00/70655, WO 01/41512, WO 02/02714, WO 02/15645, EP 1191613, EP 1191612, EP 1191614, WO 04/081017, WO 05/033244 und den nicht offen gelegten Anmeldungen EP 04029182.5 und EP 05002237.5 entnommen werden.

Der Anteil des Boronsäure-Derivats als Host in der phosphoreszierenden Mischung beträgt üblicherweise zwischen 1 und 99.9 Gew.%, bevorzugt zwischen 50 und 99.5 Gew.%, besonders bevorzugt zwischen 70 und 99 Gew.%, insbesondere zwischen 80 und 95 Gew.%. Entsprechend beträgt der Anteil des phosphoreszierenden Dotanden zwischen 0.1 und 99 Gew.%, bevorzugt zwischen 0.5 und 50 Gew.%, besonders bevorzugt zwischen 1 und 30 Gew.%, insbesondere zwischen 5 und 20 Gew.%.

Weiterhin bevorzugt sind organische Elektrolumineszenzvorrichtungen, dadurch gekennzeichnet, dass mehrere emittierende Verbindungen in derselben Schicht verwendet werden oder mehrere emittierende Schichten vorhanden sind, wobei mindestens eine der emittierenden Schichten mindestens ein Boronsäurederivat enthält. Besonders bevorzugt weist diese Vorrichtung mehrere Emissionsmaxima zwischen 380 nm und 750 nm auf, so dass insgesamt weiße Emission resultiert. Dabei können als emittierende Verbindungen sowohl solche, die Fluoreszenz zeigen, wie auch solche, die Phosphoreszenz zeigen, eingesetzt werden. Eine Alternative zur Erzeugung weißer Emission ist die Verwendung von Breitbandemittern.

In nochmals einer bevorzugten Ausführungsform der Erfindung wird das Boronsäure-Derivat als Elektronentransportmaterial als Reinsubstanz oder in einer Mischung, bevorzugt als Reinsubstanz, in einer Elektronentransportschicht in einer organischen elektronischen Vorrichtung, insbesondere in einer fluoreszierenden oder phosphoreszierenden organischen Elektrolumineszenzvorrichtung, eingesetzt. Dabei kann das Boronsäure-Derivat auch dotiert sein, beispielsweise mit Alkalimetallen.

In nochmals einer bevorzugten Ausführungsform der Erfindung wird das Boronsäure-Derivat als Lochblockiermaterial als Reinsubstanz oder in einer Mischung, bevorzugt als Reinsubstanz, in einer Lochblockierschicht, insbesondere in einer phosphoreszierenden organischen Elektrolumineszenzvorrichtung, eingesetzt.

In nochmals einer bevorzugten Ausführungsform der Erfindung wird das Boronsäure-Derivat als Lochtransportmaterial als Reinsubstanz oder in einer Mischung, bevorzugt als Reinsubstanz, in einer Lochtransportschicht oder in einer Lochinjektionsschicht in einer organischen elektronischen Vorrichtung, insbesondere in einer fluoreszierenden oder phosphoreszierenden organischen Elektrolumineszenzvorrichtung, eingesetzt. Dies ist insbesondere dann der Fall, wenn das Boronsäure-Derivat eine oder mehrere Triarylamingruppen enthält. Dabei kann das Boronsäure-Derivat auch dotiert sein, wie beispielsweise in WO 03/070822 beschrieben.

In nochmals einer bevorzugten Ausführungsform der Erfindung wird das Boronsäure-Derivat als fluoreszierender Dotand, bevorzugt in Kombination mit einem Host-Material, in einer Emissionsschicht in einer fluoreszierenden organischen Elektrolumineszenzvorrichtung eingesetzt. Dies ist insbesondere dann der Fall, wenn das Boronsäure-Derivat eine oder mehrere Stilbengruppen, insbesondere in Kombination mit einer oder mehreren Triarylamingruppen, enthält. Als Host-Materialien kommen hier ebenso Boronsäure-Derivate in Frage, wie oben bereits beschrieben. Weiterhin kommen andere üblicherweise als Host-Materialien verwendete Verbindungen in Frage, bevorzugt ausgewählt aus den Klassen der Oligoarylene (z. B. 2,2',7,7'-Tetraphenyl-spirobifluoren gemäß EP 676461 oder Dinaphthylanthracen), insbesondere der Oligo-arylene enthaltend kondensierte aromatische Gruppen, der Oligo-arylenvinylene (z. B. DPVBi oder Spiro-DPVBi gemäß EP 676461), der polypodalen Metallkomplexe (z. B. gemäß WO 04/081017), der lochleitenden Verbindungen (z. B. gemäß WO 04/058911), der elektronenleitenden Verbindungen, insbesondere Ketone, Phosphinoxide, Sulfoxide, etc. (z. B. gemäß WO 05/084081 oder WO 05/084082) oder der Atropisomere (z. B. gemäß der nicht offen gelegten Anmeldung EP 04026402.0). Besonders bevorzugte Host-materialien sind ausgewählt aus den Klassen der Oligoarylene, enthaltend Naphthalin, Anthracen und/oder Pyren oder Atropisomeren dieser Verbindungen, der Oligo-arylenvinylene, der Ketone, der Phosphinoxide und der Sulfoxide. Ganz besonders bevorzugte Hostmaterialien sind ausgewählt aus den Klassen der Oligoarylene, enthaltend Anthracen und/oder Pyren oder Atropisomeren dieser Verbindungen, der Phosphinoxide und der Sulfoxide. Der Anteil des Boronsäure-Derivats als Dotand in der Mischung ist dabei bevorzugt so, wie oben bereits für Dotanden in fluoreszierenden organischen Elektrolumineszenzvorrichtungen beschrieben.

In nochmals einer bevorzugten Ausführungsform der Erfindung wird das Boronsäure-Derivat als phosphoreszierender Dotand, bevorzugt in Kombination mit einem Host-Material, in einer Emissionsschicht in einer phosphoreszierenden organischen Elektrolumineszenzvorrichtung eingesetzt. Als Host-Materialien kommen hier ebenso Boronsäure-Derivate in Frage, wie oben bereits beschrieben. Weiterhin kommen andere üblicherweise als Host-Materialien verwendete Verbindungen in Frage, bevorzugt ausgewählt aus den Klassen der Carbazol-Derivate, z. B. 4,4'-Bis-(N-carbazolyl)biphenyl (CBP), der Ketone und Imine (z. B. gemäß WO 04/093207), der Phosphinoxide, Sulfoxide und Sulfone (z. B. gemäß WO 05/003253), der Phosphine und Sulfide (z. B. gemäß WO 05/053051), der Tetraarylsilane (z. B. gemäß WO 04/095598) oder der Oligoarylen-Derivate. Dabei weist der erfindungsgemäße phosphoreszierende Dotand, enthaltend Boronsäure-Derivate, bevorzugt die Elemente und eine Struktur auf, wie oben bereits für phosphoreszierende Emitter beschrieben, wobei an mindestens einen Liganden mindestens ein Boronsäure-Derivat gebunden ist. Wenn es sich bei dem Liganden um ein Derivat von Phenylpyridin, Phenylchinolin oder Phenylisochinolin handelt und bei dem Boronsäure-Derivat um einen Boronsäureester handelt, weist dieser bevorzugt eine cyclische Struktur auf. Wenn es sich bei dem Boronsäure-Derivat um einen Boronsäureester handelt, weist dieser generell bevorzugt eine cyclische Struktur auf. Weitere bevorzugte phosphoreszierende Dotanden, die Boronsäure-Derivatgruppen tragen, sind Metall-Carben-Komplexe. Einfache Metall-Carben-Komplexe, wie sie für die Anwendung in OLEDs bekannt sind, sind beispielsweise in WO 05/019373 beschrieben.

Weiterhin kann es bevorzugt sein, wenn ein Boronsäure-Derivat in mehreren Schichten und/oder Funktionen gleichzeitig verwendet wird. So kann es beispielsweise gleichzeitig sowohl in einer oder mehreren Emissionsschichten als auch in einer oder mehreren Elektronentransportschichten und/oder Lochblockierschichten und/oder Lochtransportschichten eingesetzt werden. Dabei kann es sich in den unterschiedlichen Schichten um das gleiche oder um unterschiedliche Boronsäure-Derivate handeln.

Weiterhin bevorzugt ist eine organische elektronische Vorrichtung, dadurch gekennzeichnet, dass eine oder mehrere Schichten mit einem Sublimationsverfahren beschichtet werden. Dabei werden die Materialien in Vakuum-Sublimationsanlagen bei einem Druck kleiner 10⁻⁵ mbar, bevorzugt kleiner 10⁻⁶ mbar, besonders bevorzugt kleiner 10⁻⁷ mbar aufgedampft.

Bevorzugt ist ebenfalls eine organische elektronische Vorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien in der Regel bei einem Druck zwischen 10⁻⁵ mbar und 1 bar aufgebracht.

Weiterhin bevorzugt ist eine organische elektronische Vorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder InkJet Druck (Tintenstrahl-Druck), hergestellt werden.

Erfindungsgemäß weist das Boronsäure-Derivat eine Struktur gemäß Formel (2) auf, 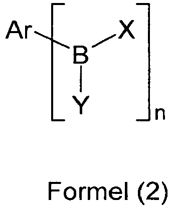 wobei für die Symbole und Indizes gilt:
- B: steht bei jedem Auftreten für ein Boratom;
- Ar: ist bei jedem Auftreten gleich oder verschieden ein aromatisches oder heteroaromatisches Ringsystem mit 5 bis 40 aromatischen Ringatomen, welches mit einem oder mehreren Resten R¹ substituiert sein kann;
- X: ist bei jedem Auftreten gleich oder verschieden eine Gruppe OR², SR², N(R²)₂, NHR² oder OBAr2;
- Y: ist bei jedem Auftreten gleich oder verschieden eine Gruppe Ar oder X;
- R¹: ist bei jedem Auftreten gleich oder verschieden F, Cl, Br, I, CN, eine geradkettige Alkyl-, Alkoxy- oder Thioalkoxykette mit 1 bis 40 C-Atomen oder eine verzweigte oder cyclische Alkyl-, Alkoxy- oder Thioalkoxykette mit 3 bis 40 C-Atomen, die jeweils durch R³ substituiert sein kann, in der auch ein oder mehrere nicht benachbarte C-Atome durch N-R³, O, S, CO, O-CO-O, CO-O, -CR³=CR³- oder -C≡C- ersetzt sein können und in der auch ein oder mehrere H-Atome durch F, Cl, Br, I oder CN ersetzt sein können, oder ein aromatisches oder heteroaromatisches Ringsystem mit 5 bis 40 C-Atomen, welches auch durch einen oder mehrere Reste R³ substituiert sein kann, oder eine Kombination aus zwei, drei oder vier dieser Systeme; dabei können zwei oder mehrere Reste R¹ miteinander auch ein monooder polycyclisches, aliphatisches oder aromatisches Ringsystem bilden;
- R²: ist bei jedem Auftreten gleich oder verschieden eine geradkettige Alkylkette mit 1 bis 40 C-Atomen oder eine verzweigte oder cyclische Alkylkette mit 3 bis 40 C-Atomen, die jeweils durch R³ substituiert sein kann, in der auch ein oder mehrere nicht benachbarte C-Atome durch N-R³, O, S, CO O-CO-O, CO-O, -CR³=CR³- oder -C≡C- ersetzt sein können, mit der Maßgabe, dass kein Heteroatom direkt an den Sauerstoff bzw. Schwefel bzw. Stickstoff der Gruppe X oder Y gebunden ist, und in der auch ein oder mehrere H-Atome durch F, Cl, Br, I oder CN ersetzt sein können, oder ein aromatisches oder heteroaromatisches Ringsystem mit 5 bis 40 C-Atomen, welches auch durch einen oder mehrere Reste R³ substituiert sein kann, oder eine Kombination aus zwei, drei oder vier dieser Systeme; dabei können zwei oder mehrere Reste R² miteinander auch ein mono- oder polycyclisches, aliphatisches oder aromatisches Ringsystem bilden;
- R³: ist bei jedem Auftreten gleich oder verschieden H oder ein aliphatischer oder aromatischer Kohlenwasserstoffrest mit 1 bis 20 C-Atomen;
- n: ist bei jedem Auftreten gleich oder verschieden 1, 2, 3, 4, 5 oder 6.

Dabei stellt die Formel mit X = OR² und Y = OR² einen Boronsäureester dar. Die Formel (2) mit X = SR² und Y = SR² stellt einen Thioboronsäureester dar. Die Formel (2) mit X = N(R²)₂ bzw. NHR² und Y = N(R²)₂ oder NHR² stellt ein Boronsäureamid dar. Die Formel (2) mit X = OR² und Y = N(R²)₂ bzw. NHR² stellt einen Boronsäureamidoester dar. Die Formel (2) mit X = SR² und Y = N(R²)₂ bzw. NHR² stellt einen Boronsäureamidothioester dar.

Auch wenn dies aus der Beschreibung hervorgeht, sei hier nochmals betont, dass mehrere Reste R¹ miteinander ein Ringsystem bilden können und/oder dass mehrere Reste R² miteinander ein Ringsystem bilden können. Dabei soll in diesem Zusammenhang der Begriff "aromatisches Ringsystem" auch heteroaromatische Ringsysteme mit umfassen. Es ist bevorzugt, wenn mehrere Reste R² miteinander ein aliphatisches oder aromatisches Ringsystem bilden.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe der C-Atome und Heteroatome mindestens 5 ergibt. Die Heteroatome sind bevorzugt ausgewählt aus N, O und/oder S. Diese Ringsysteme können mit R¹ substituiert sein. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine kurze, nichtaromatische Einheit (bevorzugt weniger als 10 % der von H verschiedenen Atome, besonders bevorzugt weniger als 5 % der von H verschiedenen Atome), wie z. B. ein sp³-hybridisiertes C-, N- oder O-Atom, unterbrochen sein können. Ebenso können mehrere Aryl- oder Heteroarylgruppen durch Vinylgruppen oder Acetylengruppen unterbrochen sein. Weiterhin können mehrere Aryl- oder Heteroarylgruppen durch Carbonylgruppen, Phosphinoxidgruppen, etc. unterbrochen sein. So sollen beispielsweise auch Systeme wie 9,9'-Spirobifluoren, 9,9-Diarylfluoren, Triarylamin, Diarylether, Stilben, Tolan, etc. als aromatische Ringsysteme im Sinne dieser Erfindung verstanden werden. Dabei kann das aromatische oder heteroaromatische Ringsystem oder ein Teil davon auch eine kondensierte Gruppe im Sinne der folgenden Definition sein.

Unter einer kondensierten Aryl- oder Heteroarylgruppe im Sinne dieser Erfindung wird ein Ringsystem mit 9 bis 40 aromatischen Ringatomen verstanden, in dem mindestens zwei aromatische oder heteroaromatische Ringe miteinander "verschmolzen", d. h. durch Anellierung einander ankondensiert sind, also mindestens eine gemeinsame Kante und ein gemeinsames aromatisches π-Etektronensystem aufweisen. Diese Ringsysteme können durch R¹ substituiert oder unsubstituiert sein. Beispiele für kondensierte aromatische oder heteroaromatische Ringsysteme sind Naphthalin, Chinolin, Isochinolin, Chinoxalin, Anthracen, Acridin, Phenanthren, Phenanthrolin, Pyren, Naphthacen, Perylen, Chrysen, etc., während beispielsweise Biphenyl keine kondensierte Arylgruppe darstellt, da dort keine gemeinsame Kante zwischen den beiden Ringsystemen vorliegt. Auch Fluoren oder Spirobifluoren stellt kein kondensiertes aromatisches Ringsystem dar, da die Phenyl-Einheiten dort kein gemeinsames aromatisches Elektronensystem ausbilden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einem aromatischen Ringsystem mit 6 bis 60 C-Atomen oder heteroaromatischen Ringsystem mit 2 bis 60 C-Atomen, welches noch jeweils mit den oben genannten Resten R¹ substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Naphthacen, Pentacen, Benzpyren, Biphenyl, Biphenylen, Terphenyl, Terphenylen, Fluoren, Spirobifluoren, Diphenylether, Triphenylamin, Dihydrophenanthren, Dihydropyren, Tetrahydropyren, cis- oder trans-Indenofluoren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

In einer bevorzugten Ausführungsform der Erfindung steht das Symbol X für OR². Die Verbindungen gemäß Formel (2) stehen also für einen Boronsäureester. In einer besonders bevorzugten Ausführungsform der Erfindung steht das Symbol X für OR². In einer ganz besonders bevorzugten Ausführungsform der Erfindung steht das Symbol X für OR² und das Symbol Y gleichzeitig für OR². Die Verbindungen gemäß Formel (2) stehen also ganz besonders bevorzugt für einen Boronsäureester. Hierbei ist es ganz besonders bevorzugt, wenn die beiden Reste R² der Gruppen OR² miteinander ein aliphatisches oder aromatisches Ringsystem bilden. Dies bedeutet, dass der Boronsäureester von einem aliphatischen oder aromatischen Diol gebildet wird. Das sich dabei bildende cyclische System ist bevorzugt ein Fünfring ([1,3,2]-Dioxaborolan) oder ein Sechsring ([1,3,2]-Dioxaborinan), d. h. der cyclische Boronsäureester wird bevorzugt von einem 1,2-Diol oder von einem 1,3-Diol gebildet.

In einer weiteren bevorzugten Ausführungsform der Erfindung stehen die Symbole X und Y gleich oder verschieden bei jedem Auftreten für NHR² oder N(R²)₂, besonders bevorzugt für N(R²)₂. Die Verbindungen gemäß Formel (2) stehen also bevorzugt für ein Boronsäureamid. Hierbei ist es ganz besonders bevorzugt, wenn zwei Reste R² der Gruppen N(R²)₂ an unterschiedlichen N-Atomen miteinander ein aliphatisches oder aromatisches Ringsystem bilden. Dies bedeutet, dass der Boronsäureester von einem aliphatischen oder aromatischen Diamin gebildet wird. Das sich dabei bildende cyclische System ist bevorzugt ein Fünfring ([1,3,2]-Diazaborolan) oder ein Sechsring ([1,3,2]-Diazaborinan), d. h. das cyclische Boronsäureamid wird bevorzugt von einem 1,2-Diamin oder von einem 1,3-Diamin gebildet.

Bevorzugte Reste R¹ sind, wenn vorhanden, bei jedem Auftreten gleich oder verschieden F, eine geradkettige Alkyl- oder Alkoxykette mit 1 bis 10 C-Atomen oder eine verzweigte Alkyl- oder Alkoxykette mit 3 bis 10 C-Atomen, die jeweils durch R³ substituiert sein kann, in der auch ein oder mehrere nicht benachbarte C-Atome durch N-R³, O, S, -CR³=CR³- oder -C≡C- ersetzt sein können und in der auch ein oder mehrere H-Atome durch F oder CN ersetzt sein können, oder ein aromatisches oder heteroaromatisches Ringsystem mit 5 bis 16 aromatischen Ringatomen, welches auch durch einen oder mehrere Reste R³ substituiert sein kann, oder eine Kombination aus zwei oder drei dieser Systeme; dabei können zwei oder mehrere Reste R¹ miteinander auch ein mono- oder polycyclisches, aliphatisches oder aromatisches Ringsystem bilden. Besonders bevorzugte Reste R¹ sind, wenn vorhanden, bei jedem Auftreten gleich oder verschieden F, eine geradkettige Alkylkette mit 1 bis 5 C-Atomen oder eine verzweigte Alkylkette mit 3 bis 5 C-Atomen, in der auch ein oder mehrere nicht benachbarte C-Atome durch -CR³=CR³- oder -C≡C- ersetzt sein können und in der auch ein oder mehrere H-Atome durch F ersetzt sein können, oder eine Aryl- oder Heteroarylgruppe mit 5 bis 10 aromatischen Ringatomen, welche auch durch einen oder mehrere Reste R³ substituiert sein kann, oder eine Kombination aus zwei dieser Systeme; dabei können zwei oder mehrere Reste R¹ miteinander auch ein mono- oder polycyclisches, aliphatisches oder aromatisches Ringsystem bilden.

Bevorzugte Reste R² sind bei jedem Auftreten gleich oder verschieden eine geradkettige Alkylkette mit 1 bis 10 C-Atomen oder eine verzweigte oder cyclische Alkylkette mit 3 bis 10 C-Atomen, die jeweils durch R³ substituiert sein kann, in der auch ein oder mehrere nicht benachbarte C-Atome durch N-R³, O, S, -CR³=CR³- oder -C≡C- ersetzt sein können, mit der Maßgabe, dass kein Heteroatom direkt an den Sauerstoff bzw. Schwefel bzw. Stickstoff der Gruppe X oder Y gebunden ist, und in der auch ein oder mehrere H-Atome durch F ersetzt sein können, oder ein aromatisches oder heteroaromatisches Ringsystem mit 5 bis 16 aromatischen Ringatomen, welches auch durch einen oder mehrere Reste R³ substituiert sein kann, oder eine Kombination aus zwei oder drei dieser Systeme; dabei können zwei oder mehrere Reste R² miteinander auch ein mono- oder polycyclisches, aliphatisches oder aromatisches Ringsystem bilden. In einer besonders bevorzugten Ausführungsform der Erfindung bilden zwei Reste R² zusammen mit B, X und Y ein Ringsystem, wobei die Bildung eines Fünf-, Sechs- oder Siebenrings, insbesondere eines Fünf-oder Sechsrings, besonders bevorzugt ist. Ganz besonders bevorzugte Gruppen R² sind bei der Bildung von Ringsystemen 1,2-Ethylen, 1,3-Propylen, 1,2-Phenylen und 1,8-Naphthylen, die jeweils auch durch einen oder mehrere Reste R³ substituiert sein können. Es ist weiterhin bevorzugt, wenn die Reste R² mit R¹ ein Ringsystem bilden.

Die bevorzugten Gruppen Ar der Formel (2) hängen von der jeweils beabsichtigten Verwendung der Boronsäure-Derivate in der organischen elektronischen Vorrichtung ab. Insbesondere unterscheiden sie sich in Abhängigkeit davon, ob die Verbindung als Host für fluoreszierende oder für phosphoreszierende Emitter verwendet werden. Als Elektronentransportmaterialien eignen sich die bevorzugten Hostmaterialien gleichermaßen. Ebenso sind unterschiedliche Gruppen Ar bevorzugt, wenn das Boronsäure-Derivat als Lochtransportverbindung oder als fluoreszierender oder phosphoreszierender Dotand eingesetzt werden soll.

Für die Verwendung als Hostmaterial für fluoreszierende Emitter und als Elektronentransportmaterial enthält das aromatische Ringsystem Ar in einer bevorzugten Ausführungsform mindestens eine kondensierte Aryl-oder Heteroarylgruppe. Bevorzugt ist das Boratom direkt an diese kondensierte Aryl- oder Heteroarylgruppe gebunden. Dabei kann es bevorzugt sein, wenn weitere aromatische Reste an die kondensierte Aryl- oder Heteroarylgruppe gebunden sind. Ebenso kann es bevorzugt sein, wenn mehr als ein Boratom an die kondensierte Aryl- oder Heteroarylgruppe gebunden ist oder wenn mehrere kondensierte Aryl- oder Heteroarylgruppen aneinander gebunden sind, an die jeweils ein oder mehrere Boronsäure-Derivate gebunden sind. Weiterhin ist es, insbesondere für blau emittierende Vorrichtungen, bevorzugt, wenn das Hostmaterial keine Doppelbindungen, also keine Stilbenstrukturen etc., enthält.

Besonders bevorzugt enthält die kondensierte Aryl- oder Heteroarylgruppe zwei, drei, vier oder fünf aromatische oder heteroaromatische Einheiten, die jeweils über eine oder mehrere gemeinsame Kanten einander ankondensiert sind und dadurch ein gemeinsames aromatisches System ausbilden und die durch R¹ substituiert oder unsubstituiert sein können. Die Substitution mit R¹ kann sinnvoll sein, um die elektronischen Eigenschaften einzustellen oder auch um besser lösliche Verbindungen zu erhalten. Ganz besonders bevorzugt enthält die kondensierte Aryl- oder Heteroarylgruppe drei oder vier aromatische oder heteroaromatische Einheiten, die jeweils über eine oder mehrere gemeinsame Kanten einander ankondensiert sind und dadurch ein gemeinsames aromatisches System ausbilden und die durch R¹ substituiert oder unsubstituiert sein können. Ganz besonders bevorzugt sind die einander ankondensierten aromatischen und heteroaromatischen Einheiten ausgewählt aus Benzol, Pyridin, Pyrimidin, Pyrazin und Pyridazin, die durch R¹ substituiert oder unsubstituiert sein können, insbesondere Benzol und Pyridin, die jeweils durch R¹ substituiert oder unsubstituiert sein können.

Die kondensierten Aryl- oder Heteroarylgruppen sind besonders bevorzugt ausgewählt aus der Gruppe bestehend aus Anthracen, Acridin, Phenanthren, Phenanthrolin, Pyren, Naphthacen, Chrysen, Pentacen und Perylen, die gegebenenfalls durch R¹ substituiert sein können. Besonders bevorzugt sind die kondensierten aromatischen Ringsysteme ausgewählt aus der Gruppe bestehend aus Anthracen, Phenanthren, Pyren oder Naphthacen, insbesondere Anthracen, Phenanthren oder Pyren, die gegebenenfalls durch R¹ substituiert sein können. Ganz besonders bevorzugt ist R² eine verbrückende Gruppe zwischen X und Y, ausgewählt aus 1,2-Phenylen, 1,8-Naphthylen, 1,2-Ethylen und 1,3-Propylen. Weiterhin bevorzugt können mehrere Gruppen R² an unterschiedlichen Boronsäurederivaten in derselben Verbindung auch ein Ringsystem bilden und so beispielsweise eine ansa-Verbindung erzeugen.

Der Übersichtlichkeit halber ist die Nummerierung von Anthracen, Phenanthren, Pyren und Perylen im Folgenden aufgeführt:

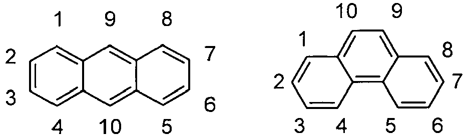

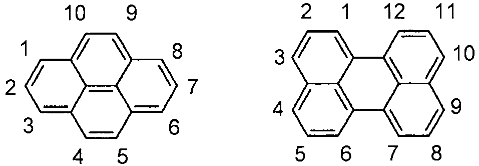

Dabei erfolgt die Verknüpfung des Boronsäure-Derivats am Anthracen bevorzugt über die 2- oder die 9-Position, wenn nur eine derartige Gruppe vorhanden ist, insbesondere über die 9-Position. Besonders bevorzugt ist dann die die 10-Position mit einem aromatischen Substituenten weiter substituiert. Die Verknüpfung der Boronsäure-Derivate am Anthracen erfolgt bevorzugt über die die 2,9-Position, die 2,10-Position, die 9,10-Position oder die 2,6-Position, wenn zwei derartige Gruppen vorhanden sind, besonders bevorzugt über die 9,10-Position.

Die Verknüpfung des Boronsäure-Derivats am Pyren erfolgt bevorzugt über die 1- oder die 2-Position, wenn nur eine derartige Gruppe vorhanden ist. Die Verknüpfung der Boronsäure-Derivate am Pyren erfolgt bevorzugt über die 1,6-, die 1,8-, die 1,3- oder die 2,7-Position, wenn zwei derartige Gruppen vorhanden sind, besonders bevorzugt über die 1,6- oder über die 2,7-Position. Die Verknüpfung der Boronsäure-Derivate am Pyren erfolgt bevorzugt über die 1,3,6,8-Position, wenn vier derartige Gruppen vorhanden sind.

Die Verknüpfung des Boronsäure-Derivats am Phenanthren erfolgt bevorzugt über die 2-, die 3- oder die 9-Position, wenn nur eine derartige Gruppe vorhanden ist. Die Verknüpfung der Boronsäure-Derivate am Phenanthren erfolgt bevorzugt über die 2,7-, die 3,6-, die 2,9-, die 2,10-oder die 9,10-Position, wenn zwei derartige Gruppen vorhanden sind, besonders bevorzugt über die 2,7- oder über die 3,6-Position.

Die Verknüpfung des Boronsäure-Derivats am Perylen erfolgt bevorzugt über die 3-Position, wenn nur eine derartige Gruppe vorhanden ist. Die Verknüpfung der Boronsäure-Derivate am Perylen erfolgt bevorzugt über die 3,4-, die 3,9- oder die 3,10-Position, wenn zwei derartige Gruppen vorhanden sind, besonders bevorzugt über die 3,9- oder über die 3,10-Position. Die Verknüpfung der Boronsäure-Derivate am Perylen erfolgt bevorzugt über die 3,4,9,10-Position, wenn vier derartige Gruppen vorhanden sind.

Für die Verwendung als Hostmaterial für phosphoreszierende Emitter und als Elektronentransportmaterial enthält das aromatische Ringsystem Ar in einer bevorzugten Ausführungsform nur Aryl- oder Heteroarylgruppen mit 5 bis 14 aromatischen Ringatomen, jedoch keine mit mehr als 14 aromatischen Ringatomen. Dies schließt nicht aus, dass mehrere derartige Gruppen im aromatischen Ringsystem Ar vorhanden sein können, schließt aber kondensierte Aryl- oder Heteroarylgruppen mit mehr als 14 aromatischen Ringatomen aus. Dabei kann es bevorzugt sein, wenn mehr als ein Boratom an das aromatische oder heteroaromatische Ringsystem gebunden ist. Weiterhin ist es bevorzugt, wenn das Hostmaterial keine Doppelbindungen, also keine Stilbenstrukturen, etc., enthält. In einer besonders bevorzugten Ausführungsform enthält das aromatische Ringsystem Ar nur Aryl- oder Heteroarylgruppen, die nicht mehr als 10 aromatische Ringatome enthalten, insbesondere ausgewählt aus Benzol, Naphthalin, Pyridin, Pyrimidin, Pyrazin, Pyridazin, Chinolin, Isochinolin, Chinoxalin, Triazin, Thiophen, Benzothiophen, Pyrrol, Indol, Furan, Pyrazol, Imidazol, Triazol oder Oxadiazol, die durch R¹ substituiert sein können. Insbesondere für die Verwendung als Hostmaterial für phosphoreszierende Emitter und als Elektronentransportmaterial ist es auch bevorzugt, wenn mehrere Arylgruppen durch eine nicht-konjugierte Einheit unterbrochen sind, besonders bevorzugt durch eine Carbonylgruppe, eine aromatische Phosphingruppe, eine aromatische Phosphinoxidgruppe, eine Thiogruppe, ein Sulfoxid, ein Sulfon oder eine C(R¹)₂-Gruppe, insbesondere eine Carbonyl-oder eine aromatische Phosphinoxidgruppe.

Besonders bevorzugte Gruppen Ar enthalten Benzol, 2-Biphenyl, 3-Biphenyl, 4-Biphenyl, Fluoren, Dihydrophenanthren, Spirobifluoren, Terphenyl, Naphthyl oder Binaphthyl. Diese können jeweils durch R¹ substituiert oder unsubstituiert sein und können ein oder mehrere Boronsäure-Derivate gebunden haben.

Für die Verwendung als Lochtransportmaterial für fluoreszierende oder phosphoreszierende organische Elektrolumineszenzvorrichtungen oder für andere organische elektronische Vorrichtungen ist es bevorzugt, wenn die Gruppe Ar mindestens eine Triarylamin-Einheit und/oder mindestens ein Thiophen-Derivat enthält. Besonders bevorzugt enthält die Gruppe mindestens eine Triarylamin-Einheit. Dies können Strukturen sein mit genau einer oder mit mehreren Stickstoffatomen, beispielsweise Triphenylamin, Naphthyldiphenylamin, TAD, NPB, NaphDATA, etc.

Für die Verwendung als fluoreszierender Dotand für organische Elektrolumineszenzvorrichtungen ist es bevorzugt, wenn die Gruppe Ar mindestens eine Stilben-Einheit und/oder mindestens eine Tolan-Einheit enthält, besonders bevorzugt mindestens eine Stilbeneinheit. Ganz besonders bevorzugt enthält die Gruppe Ar außer der Stilben-Einheit mindestens eine Triarylamin-Einheit.

Beispiele für Boronsäure-Derivate, die als Hostmaterialien für fluoreszierende bzw. phosphoreszierende Vorrichtungen, als Elektronentransportmaterialien, als Lochtransportmaterialien oder als Emitter geeignet sind, sind die nachfolgend abgebildeten Strukturen (1) bis (191). Welche der abgebildeten Verbindungen sich insbesondere für fluoreszierende Vorrichtungen eignet und welche für phosphoreszierende Vorrichtungen, bzw. welche auch für andere Verwendungen geeignet ist, kann der obigen Beschreibung entnommen werden.

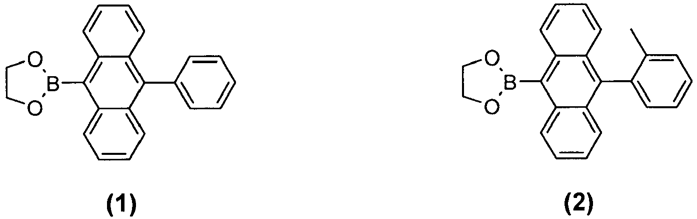

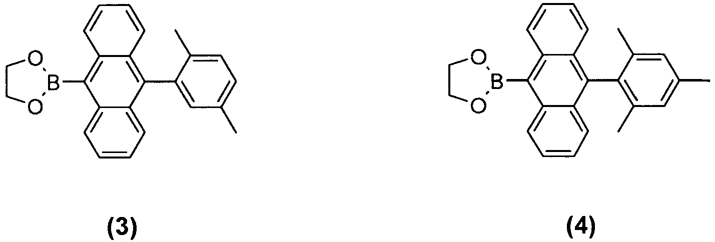

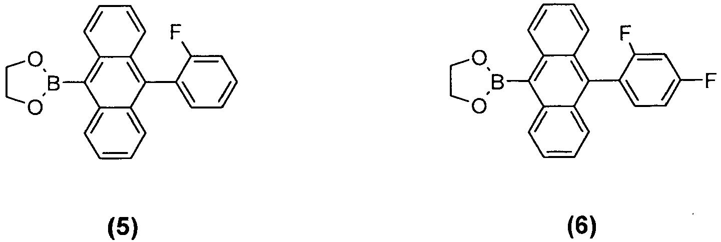

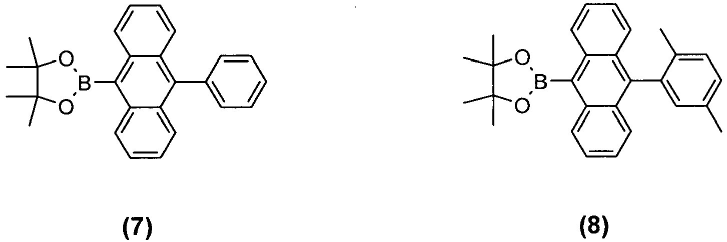

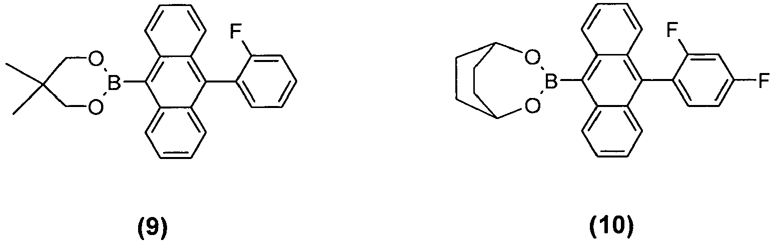

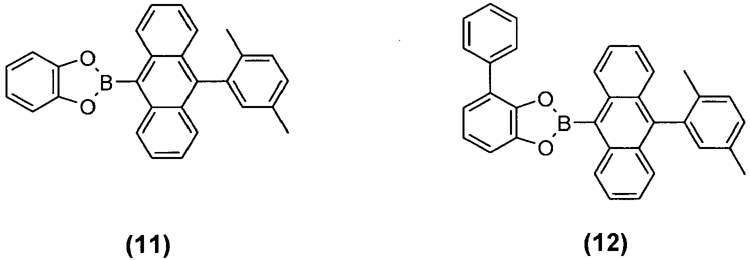

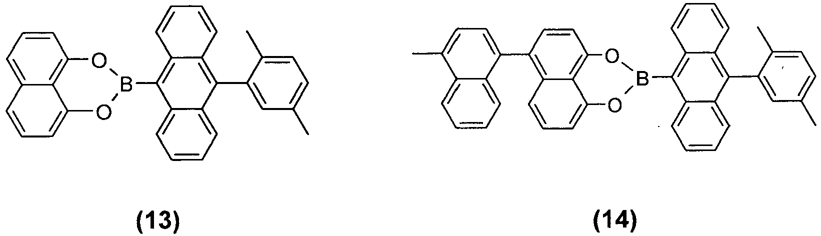

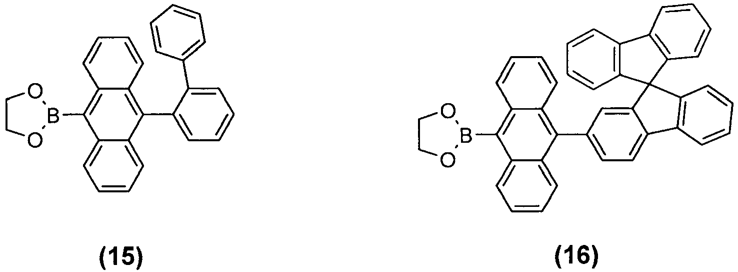

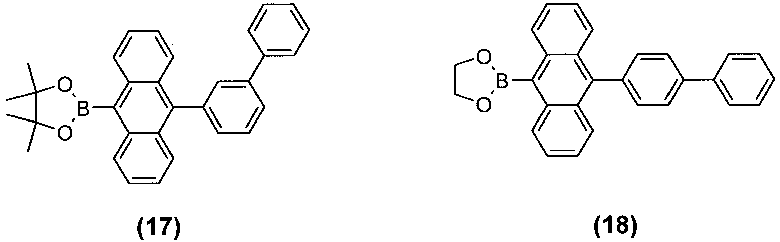

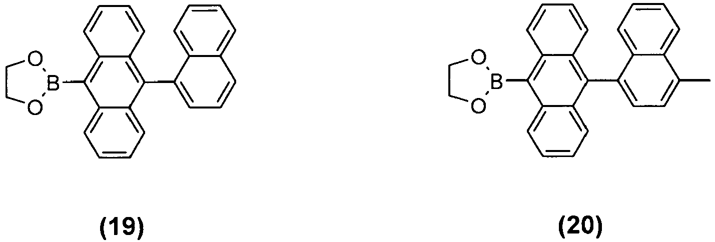

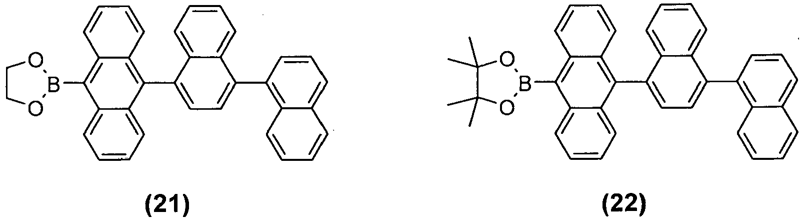

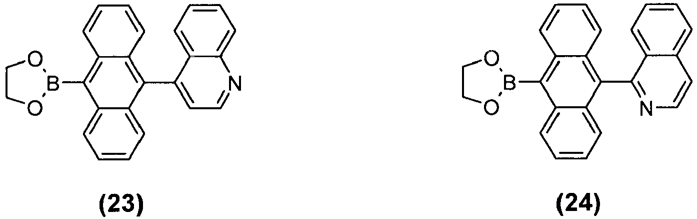

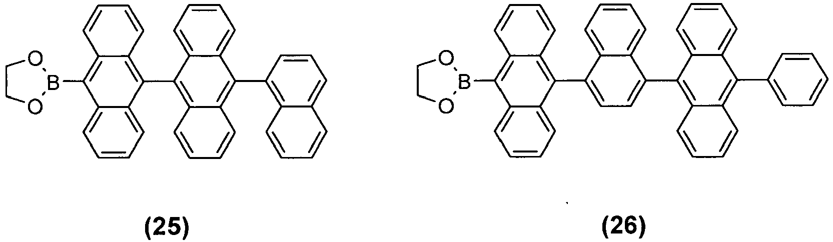

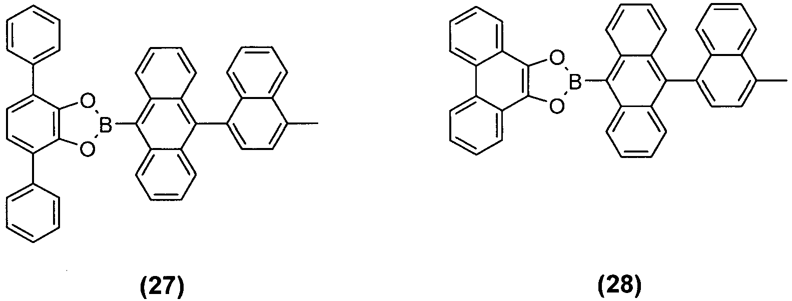

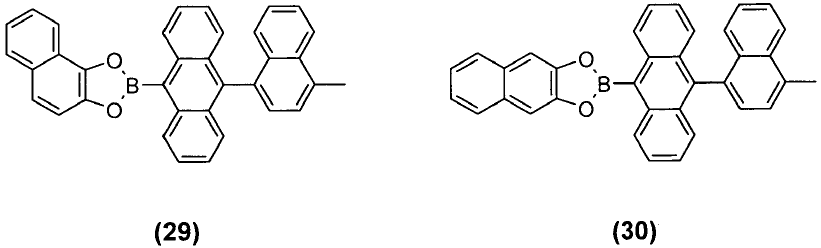

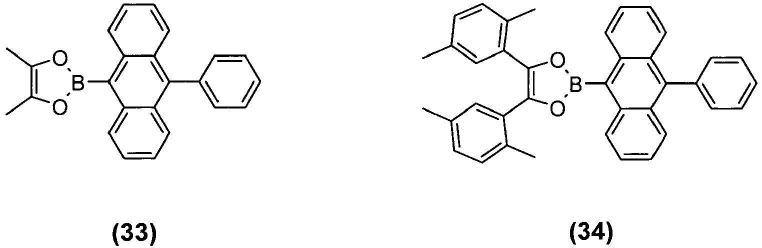

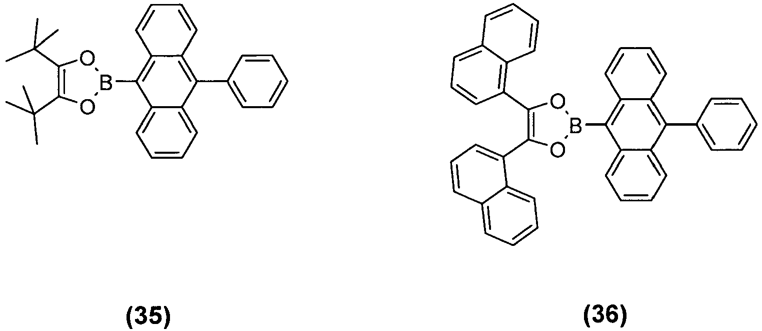

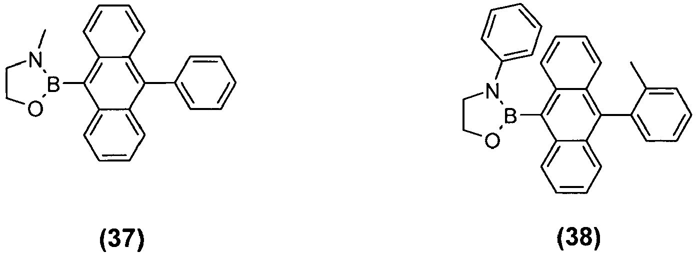

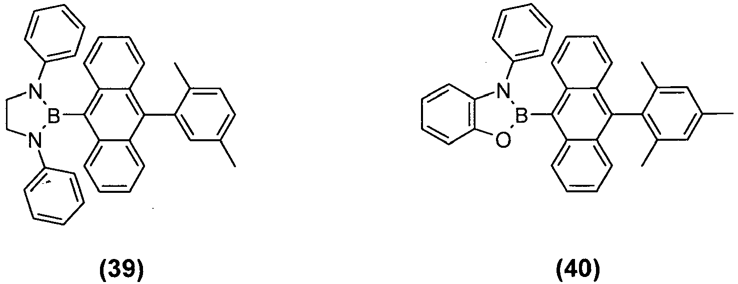

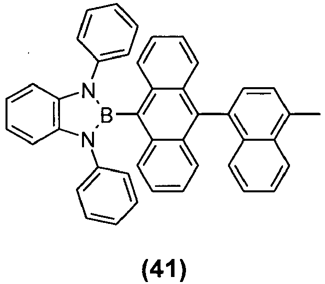

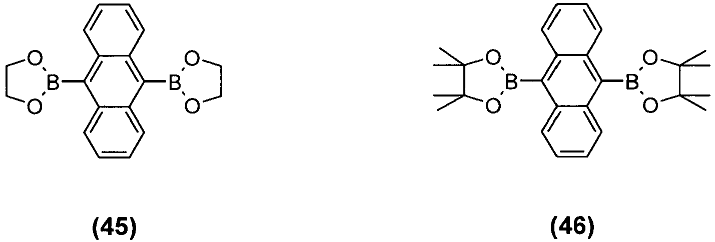

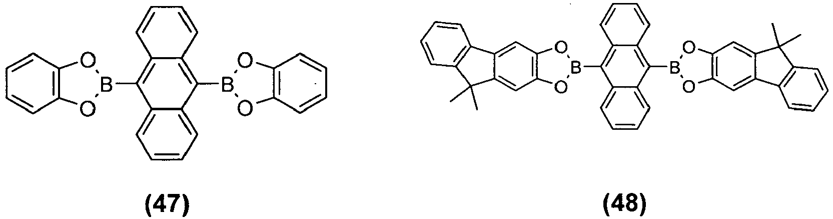

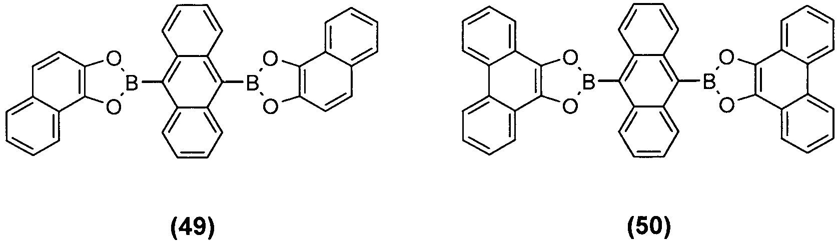

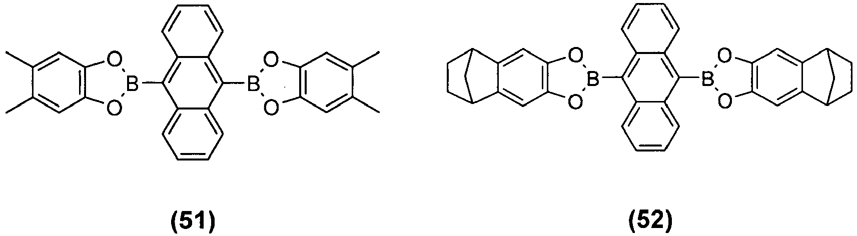

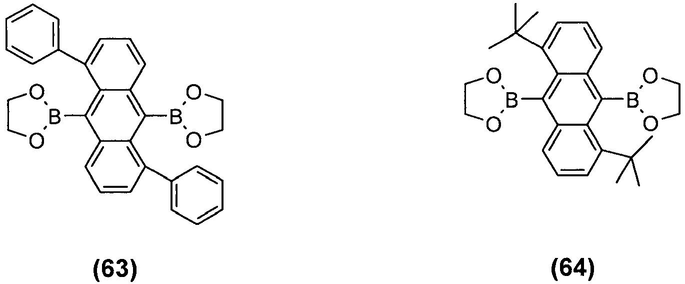

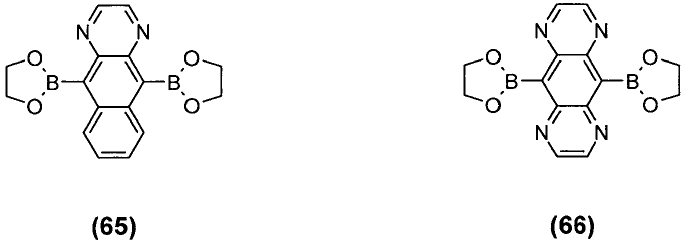

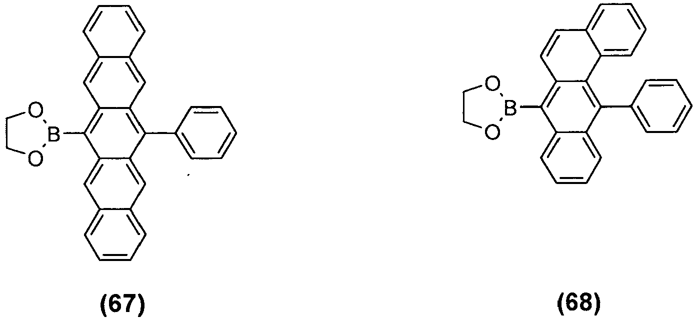

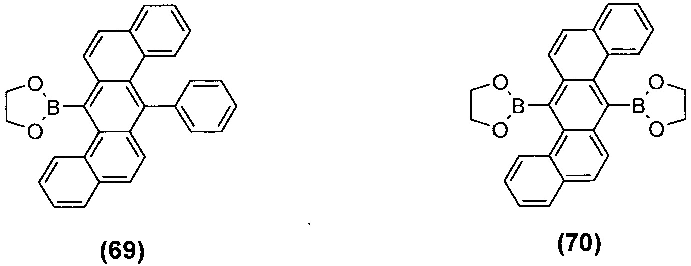

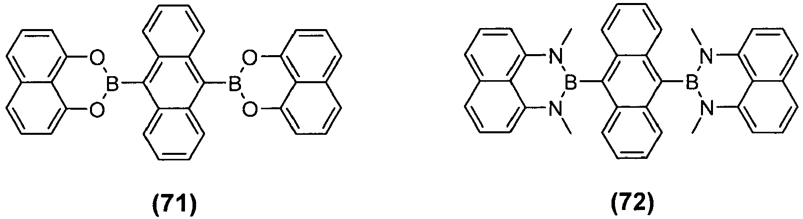

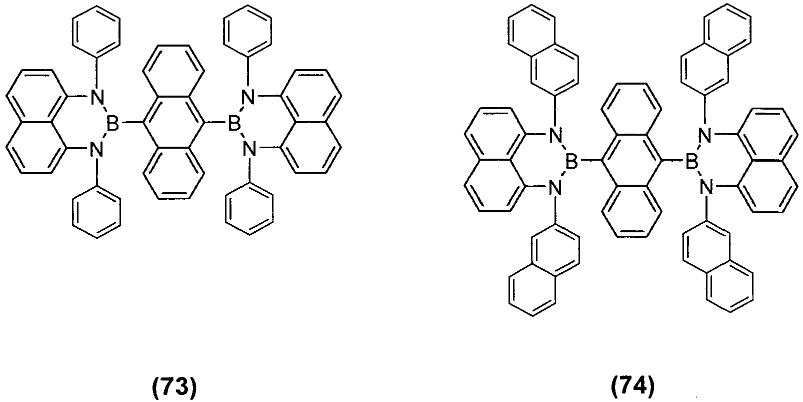

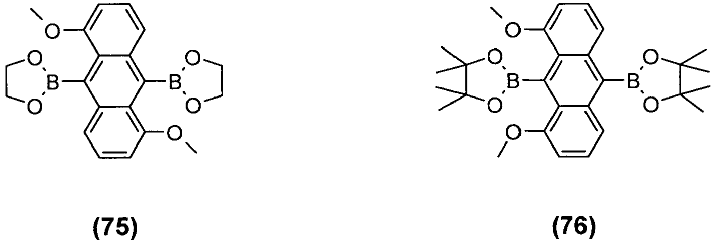

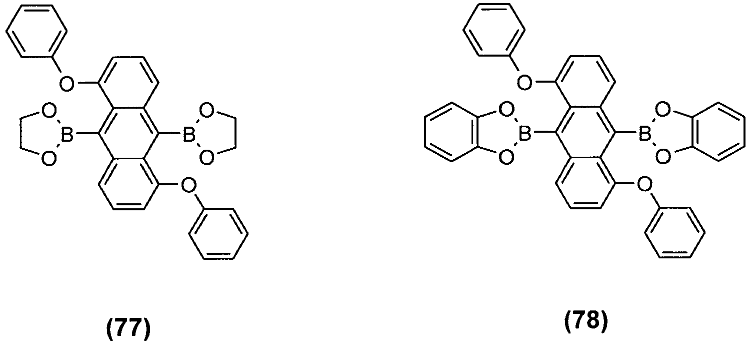

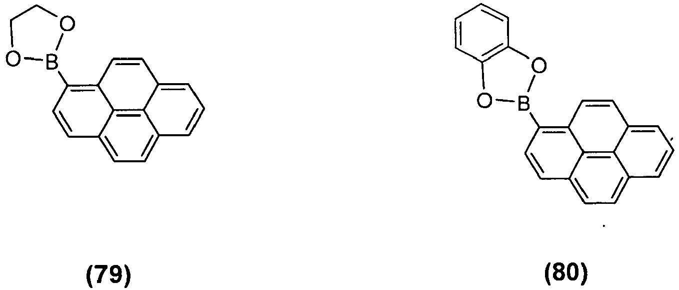

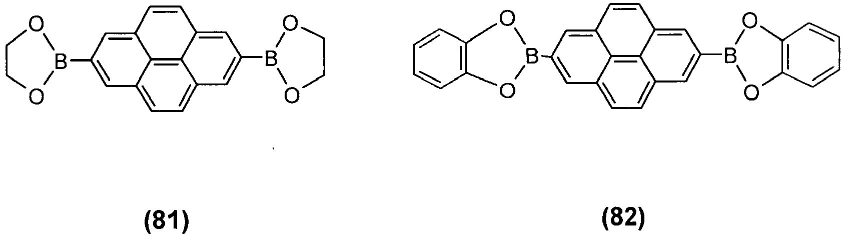

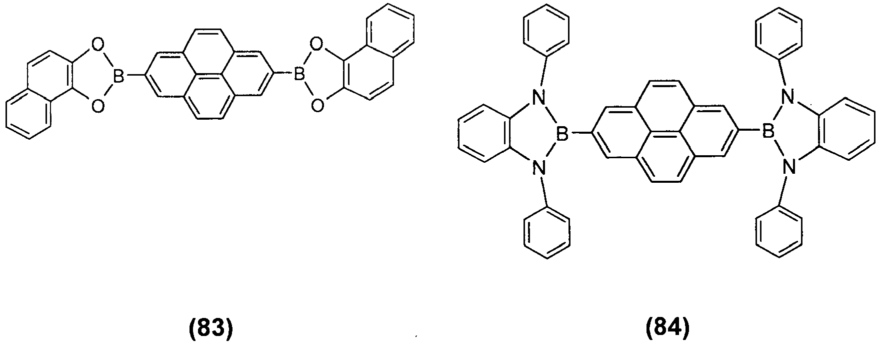

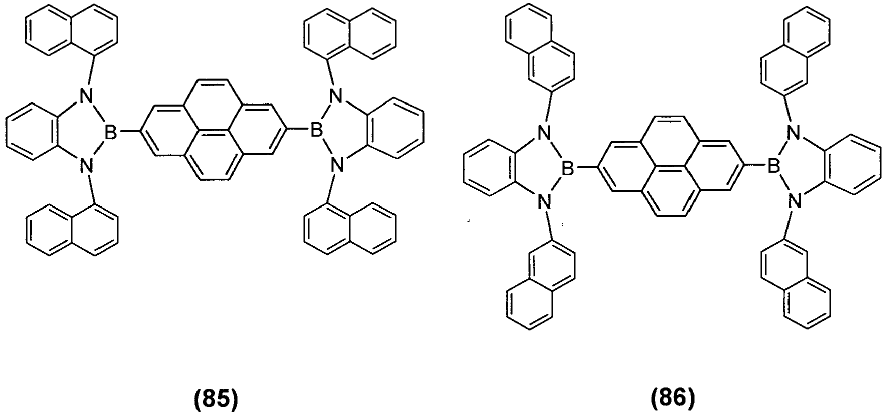

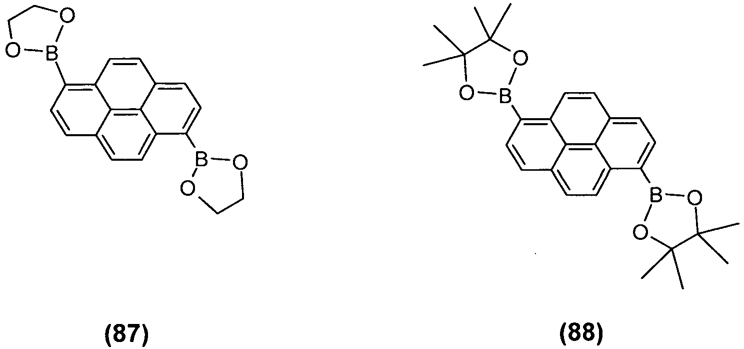

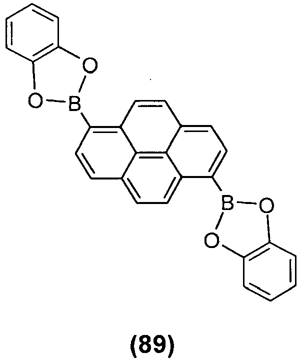

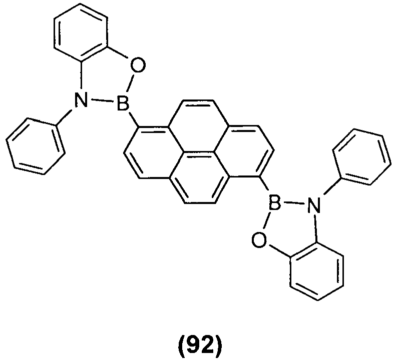

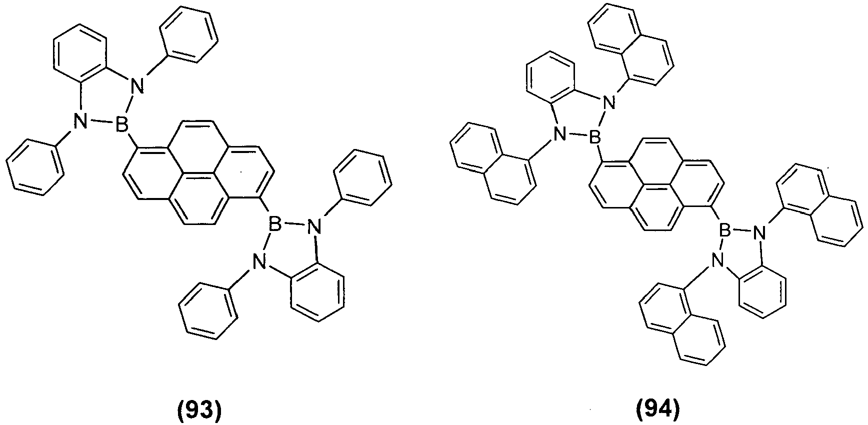

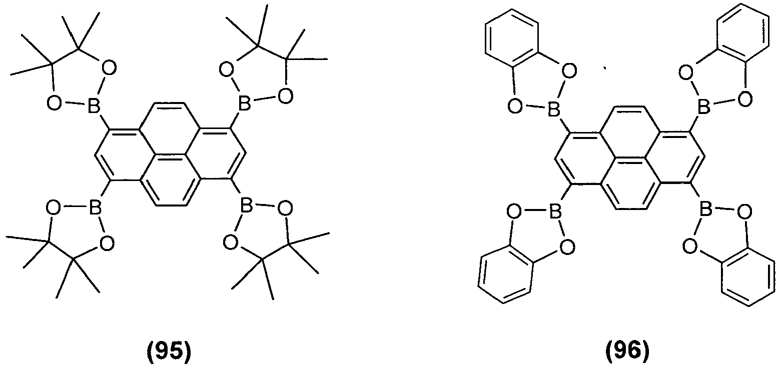

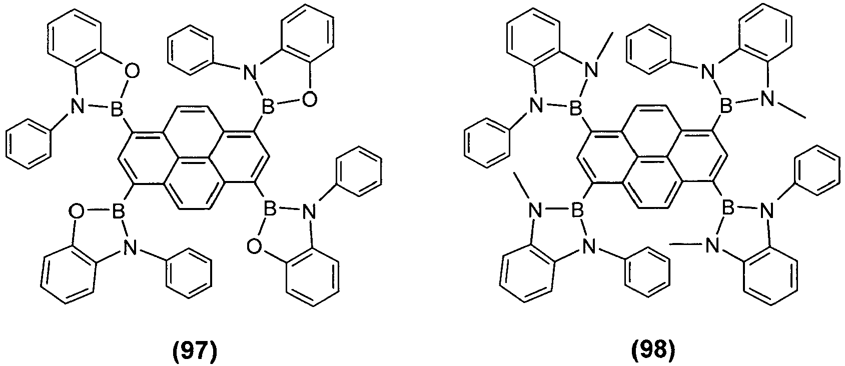

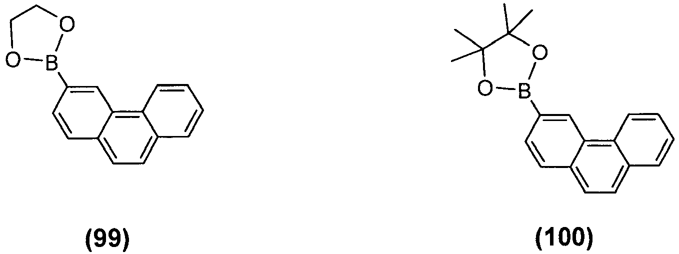

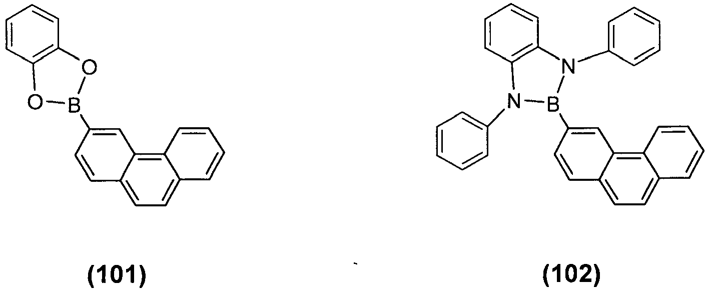

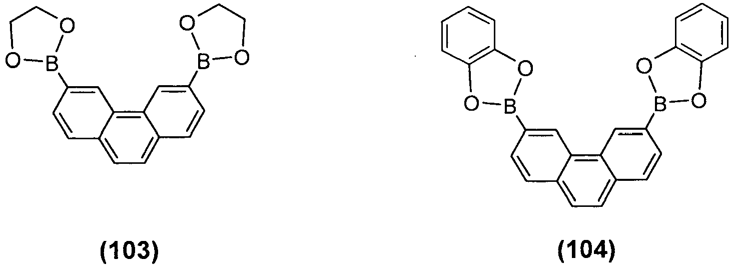

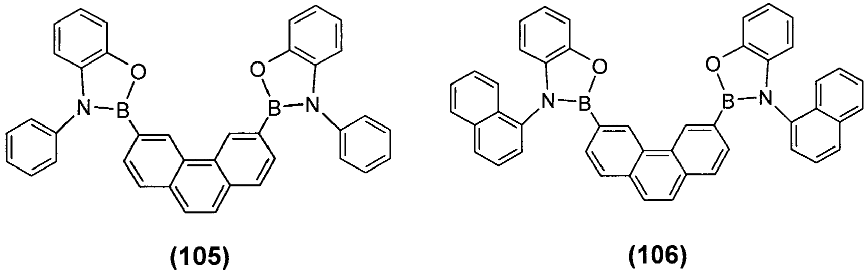

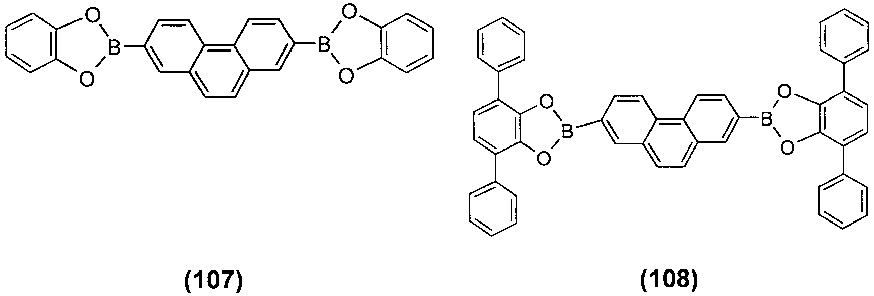

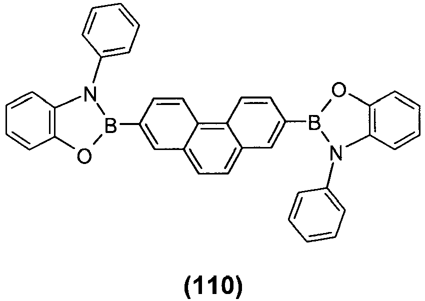

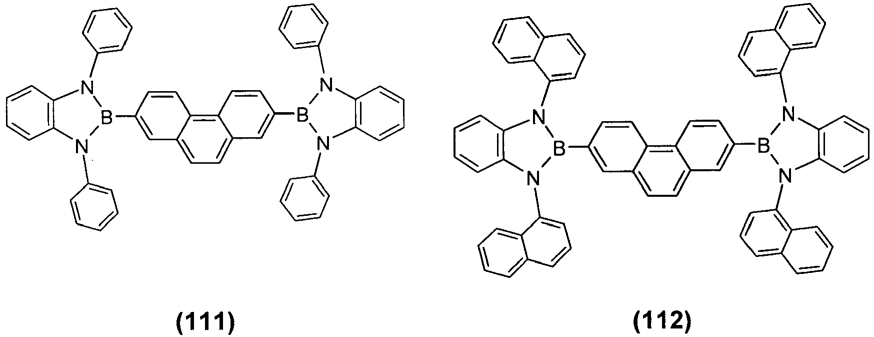

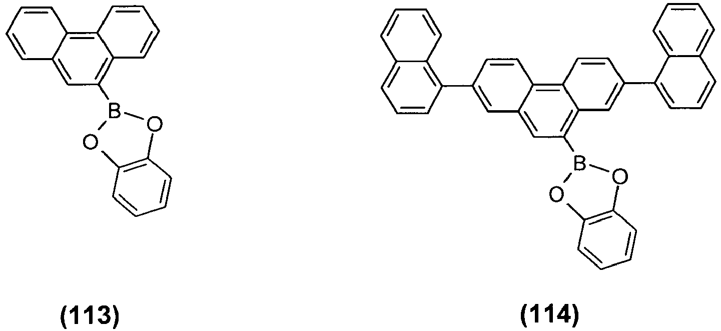

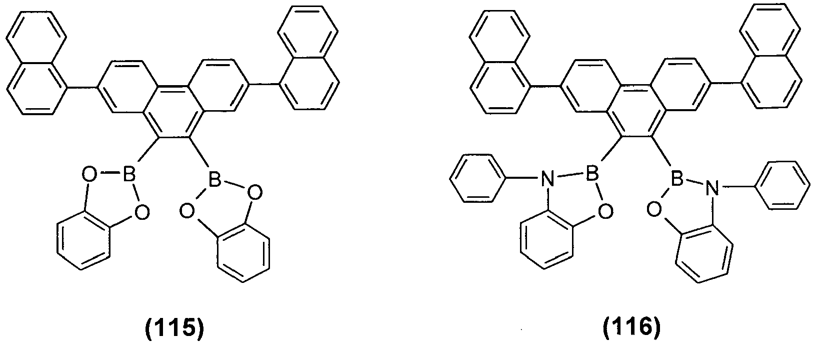

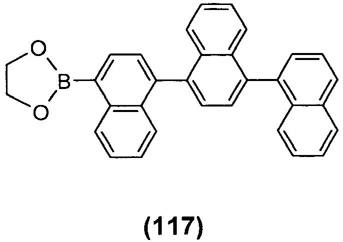

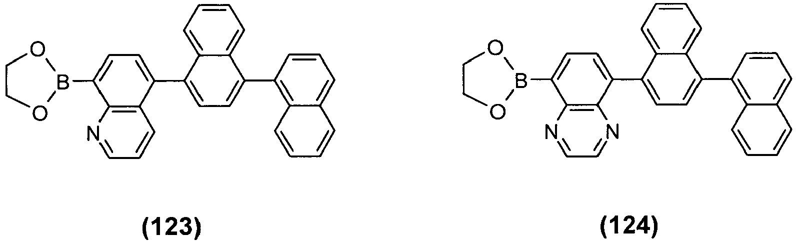

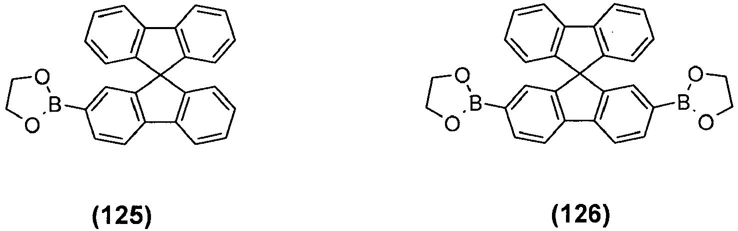

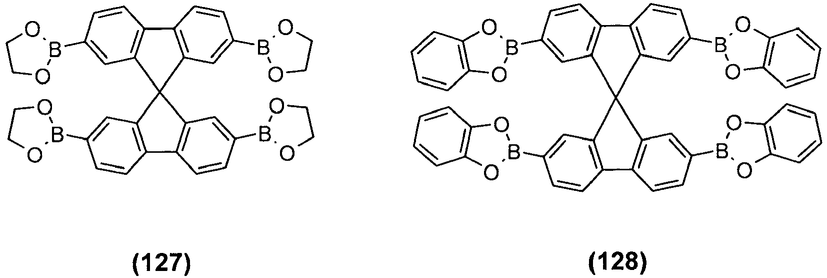

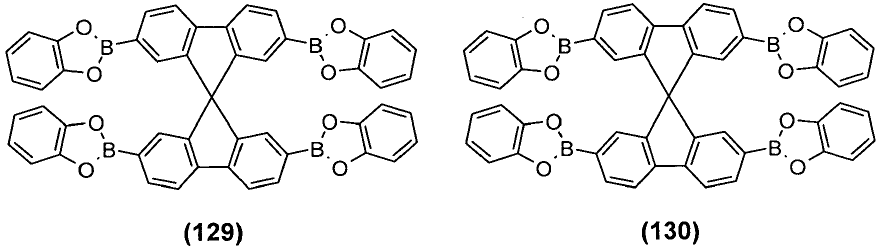

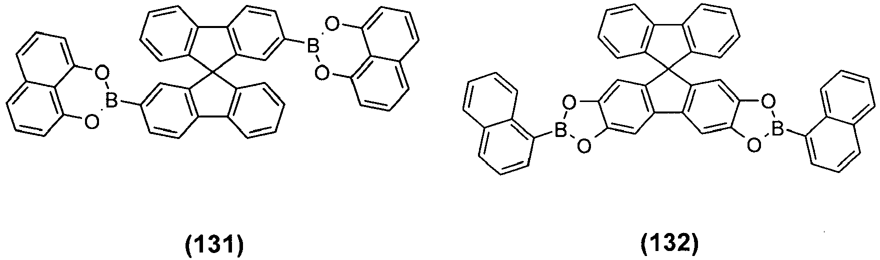

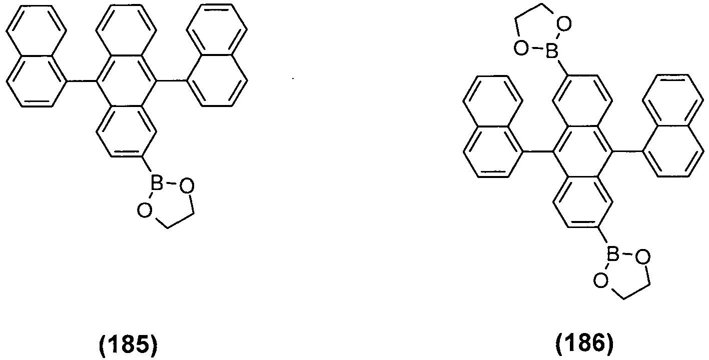

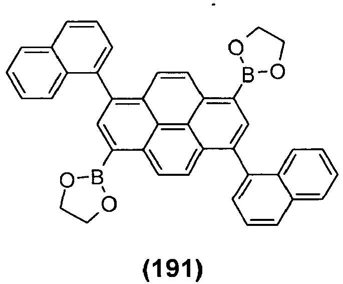

Aromatische Boronsäure-Derivate und deren Synthese sind vor allem als Zwischenprodukte für Kupplungsreaktionen gemäß Suzuki bekannt. Sie lassen sich nach Standardmethoden der organischen Chemie einfach synthetisieren: Üblicherweise erfolgt die Synthese aus einem aromatischen Halogenid, welches zu einer Organolithium-Verbindung oder einer Grignard-Verbindung umgesetzt wird, gefolgt von Reaktion mit einem Trialkylborat, üblicherweise Trimethylborat. Die Darstellung kann auch nach einem Eintopfverfahren erfolgen, bei welchem das aromatische Halogenid in Anwesenheit des Alkylborats mit einem reaktiven Metall (Li, Mg, etc.) oder einer Organolithiumverbindung umgesetzt wird (K.-T. Wong et al., J. Org. Chem. 2002, 67, 1041-1044). Die durch Hydrolyse erhaltene Boronsäure kann entweder durch Entwässern zum Boronsäureanhydrid umgesetzt werden, durch Umsetzung mit einem Alkohol unter Wasserabscheidung zum entsprechenden Boronsäureester oder durch Umsetzung mit einem Amin zum entsprechenden Boronsäureamid. Die Reaktion mit einem Diol ergibt einen cyclischen Boronsäureester, während die Umsetzung mit einem Diamin zu cyclischen Boronsäureamiden führt (G. Kaupp et al., Chem. Eur. J. 2003, 9, 4156-4160). Entsprechend führt die Reaktion mit Thiolen zu Thioboronsäureestern und mit Dithiolen zu cyclischen Thioboronsäureestern. Dabei können die Alkohole, Thiole und Amine aromatisch oder aliphatisch sein. Auch die Reaktion mit aromatischen oder aliphatischen Aminoalkoholen ist möglich und führt zu cyclischen Boronsäureamidoestern, ebenso mit Aminothiolen. Weiterhin lassen sich aromatische Boronsäure-Derivate auch durch Reaktion eines aromatischen Halogenids mit einer Verbindung, die eine Bor-Bor-Bindung enthält (beispielsweise Bis-pinacolato-diboran) unter Palladium-Katalyse erhalten (JP 2004/189705; T. Ishiyama et al., Special Publication - Royal Society of Chemistry 1997, 201 (Advances in Boron Chemistry), 92-95). Nochmals eine weitere Synthesemöglichkeit ist die Reaktion des lithiierten Aromaten mit Chlorcatecholboran-Derivaten, die direkt zum Boronsäureester führt (M. Yamashita et al., Angew. Chem. Int. Ed. 2000, 39, 4055-4058). Auch die Cyclooligomerisierung von Boryl-acetylenen ist in der Literatur beschrieben (A. Goswami et al., Eur. J. Inorg. Chem. 2004, 2635-2645). Die Verbindungen fallen bereits bei der Synthese in hoher Reinheit an und lassen sich durch Standardmethoden der organischen Chemie weiter reinigen, insbesondere durch Umkristallisation. Durch ihre hohe thermische Stabilität können sie auch problemlos durch Sublimation gereinigt werden. Dies ist für die Anwendung in OLEDs von großer Bedeutung, da hierfür üblicherweise sublimierte Verbindungen eingesetzt werden und die Verbindungen häufig durch Aufdampfen aufgebracht werden.

Das aromatische Halogenid, das als Ausgangsverbindung eingesetzt wird, kann entweder ein kommerziell erhältliches Halogenid sein, beispielsweise ein Arylbromid oder Aryldibromid. Es ist weiterhin möglich, erst komplexere aromatische Systeme aufzubauen, welche beispielsweise mehrere Arylgruppen enthalten. Eine Standardreaktion hierfür ist die Aryl-Aryl-Kupplung gemäß Suzuki unter Palladium-Katalyse, die Aryl-N-Kupplung gemäß Hartwig-Buchwald unter Palladium-Katalyse oder andere übergangsmetallkatalysierte Kupplungsreaktionen. In einem nächsten Schritt kann einer der Aromaten halogeniert werden, beispielsweise durch Bromierung mit Brom oder NBS.

Es hat sich gezeigt, dass die Verbindungen gemäß den Formeln (27) bis (29) wertvolle Intermediate für die Ausführung der erfindungsgemäßen Verwendung sind. Diese Boronsäure-Derivate sind neu und daher auch ein Gegenstand der vorliegenden Erfindung.

Weiterer Gegenstand der Erfindung sind Verbindungen gemäß Formel (27) und (27a), 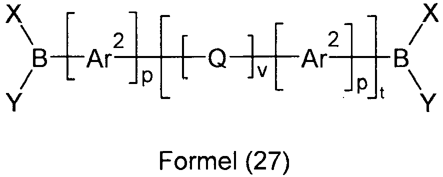 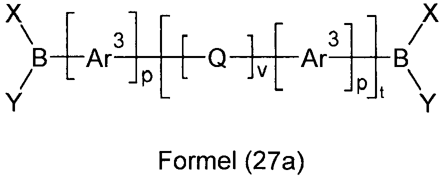 wobei B, X, Y, Ar und R¹ dieselbe Bedeutung haben, wie oben beschrieben und weiterhin gilt:
- Ar²: ist bei jedem Auftreten gleich oder verschieden eine kondensierte Aryl- oder Heteroarylgruppe mit 9 bis 20 aromatischen Ringatomen, welche mit R¹ substituiert sein kann;
- Ar³: ist bei jedem Auftreten gleich oder verschieden eine Fluoren- oder Spirobifluorengruppe, welche mit R¹ substituiert sein kann;
- Q: ist bei jedem Auftreten gleich oder verschieden eine bivalente Einheit, ausgewählt aus Ar, O, S, SO, SO₂, Se, SeO, SeO₂, Te, TeO, TeO₂, NAr, PAr, P(=O)Ar, AsAr, As(=O)Ar, SbAr, Sb(=O)Ar, C(R¹)₂, C=O, Si(R¹)₂ oder O-BAr-O;
- p: ist bei jedem Auftreten gleich oder verschieden 1, 2, 3, 4, 5 oder 6;
- v: ist bei jedem Auftreten gleich oder verschieden 0 oder 1;
- t: ist 1, 2, 3, 4 oder 5;
mit der Maßgabe, dass in Formel (27) Ar² nicht bei jedem Auftreten Naphthyl ist, wenn alle p = 1 und gleichzeitig v = 0 ist und t = 1 ist.

Bevorzugt ist Ar² bei jedem Auftreten gleich oder verschieden eine kondensierte Aryl- oder Heteroarylgruppe mit 9 bis 20 C-Atomen, besonders bevorzugt eine kondensierte Arylgruppe mit 10 bis 16 C-Atomen.

Weiterhin bevorzugt ist p 2, 3, 4 oder 5, besonders bevorzugt 2, 3 oder 4, ganz besonders bevorzugt 2 oder 3.

Weiterer Gegenstand der Erfindung sind Verbindungen gemäß Formel (28), 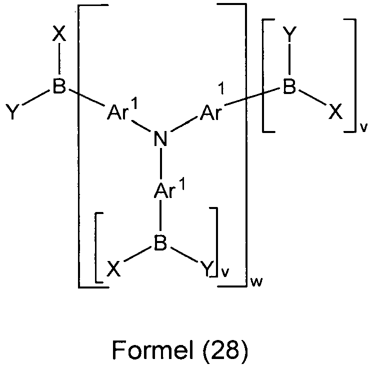 wobei B, X, Y, Ar¹ und R¹ dieselbe Bedeutung haben, wie oben beschrieben, und weiterhin gilt:
- v: ist bei jedem Auftreten gleich oder verschieden 0 oder 1;
- w: ist bei jedem Auftreten gleich oder verschieden 1, 2, 3, 4, 5 oder 6;
mit der Maßgabe, dass Boronsäureester, gebildet mit Pinacol, 1,2-Ethandiol, 2,2-Dimethyl-1,3-Propandiol, 2,3-Butandiol und iso-Propanol von der Erfindung ausgenommen sind.

Weiterer Gegenstand der Erfindung sind Verbindungen gemäß Formel (29), 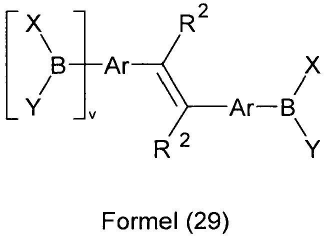 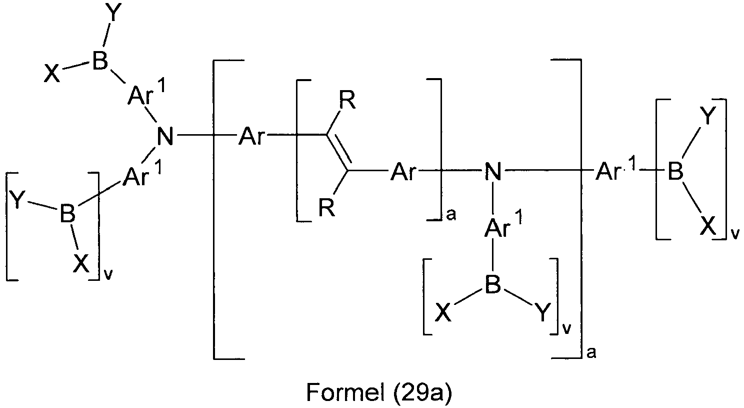 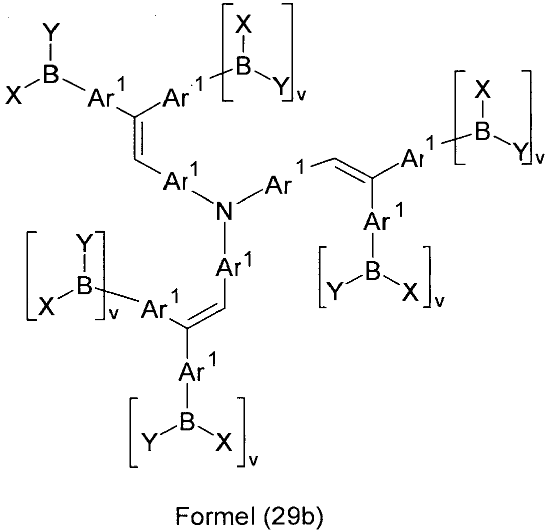 wobei B, X, Y, Ar, R¹, R² und v dieselbe Bedeutung haben, wie oben beschrieben, und wobei a bei jedem Auftreten gleich oder verschieden für 1, 2 oder 3 steht, mit der Maßgabe, dass es sich für Strukturen der Formel (29) nicht um Boronsäureester von Pinacol, Glycol und/oder 1,3-Propandiol handelt.

Dabei steht das Symbol Ar bzw. Ar¹ bevorzugt für eine Gruppe, die sich von Benzol, Biphenyl oder Naphthalin ableitet, die jeweils mit R¹ substituiert oder unsubstituiert sein kann.

Für die Gruppen X und Y gelten dieselben Bevorzugungen, wie oben bereits beschrieben. Ebenso können Verbindungen gemäß Formel (27) bis (29) mit Oligoalkoholen, Oligoaminen oder Oligoaminoalkoholen umgesetzt werden, um dadurch Dimere, Trimere, Tetramere, etc. zu erhalten.

Die oben beschriebenen Vorrichtungen weisen folgende überraschende Vorteile gegenüber dem Stand der Technik auf:
1. Die Stabilität entsprechender Vorrichtungen ist größer im Vergleich zu Systemen gemäß dem Stand der Technik, was sich vor allem in einer längeren Lebensdauer der OLED zeigt.
2. Die Boronsäure-Derivate zeigen nur einen sehr geringen Stokes-Shift. Dadurch weist das Emissionsspektrum des Boronsäure-Derivats, welches als Host verwendet wird, mit dem Absorptionsspektrum des Dotanden eine große Überlappung auf. Die Überlappung von Emissions- und Absorptionsspektrum ist die Voraussetzung für einen guten Energieübertrag auf den Dotanden und damit für eine hohe Effizienz.
3. Im Gegensatz zu bisher verwendeten Verbindungen, die teilweise durch ihre schlechte Löslichkeit schwierig zu reinigen waren, sind die Boronsäure-Derivate gut löslich und daher einfacher zu reinigen bzw. auch leichter aus Lösung zu verarbeiten.
4. Die eingesetzten Boronsäure-Derivate lassen sich einfach nach Standardmethoden der organischen Chemie synthetisieren und sind leicht zu reinigen. Dadurch stellen sie einen Vorteil gegenüber Verbindungen dar, die gemäß dem Stand der Technik eingesetzt werden.
5. Die Boronsäure-Derivate weisen eine geringere Verdampfungstemperatur auf als vergleichbare Verbindungen, die diese Substituenten nicht tragen. Dies ist für die Herstellung von OLEDs durch Vakuumaufdampfung von großem Vorteil, da dadurch thermisch empfindliche Teile der Apparatur, wie beispielsweise die Schattenmasken, weniger belastet werden.
6. Die Boronsäure-Derivate, insbesondere von Triplett-Emittern, weisen eine höhere thermische Stabilität auf als entsprechende Verbindungen, insbesondere Triplett-Emitter, gemäß dem Stand der Technik, die unsubstituiert oder gemäß dem Stand der Technik nur mit Alkyl- oder Arylgruppen, Halogenen, etc. substituiert sind. Durch die höhere Sublimationsstabilität sind sie leichter zu verarbeiten, insbesondere durch Sublimation bei der Device-Herstellung, was einen deutlichen Vorteil gegenüber den Materialien gemäß dem Stand der Technik bedeutet.
7. Die Boronsäure-Derivate sind deutlich stabiler gegenüber Oxidation als Borane, wie sie gemäß dem Stand der Technik eingesetzt werden. Dadurch lassen sie sich leichter handhaben und sind daher für den technischen Einsatz besser geeignet als aromatische Borane gemäß dem Stand der Technik.

Im vorliegenden Anmeldetext und auch in den im Weiteren folgenden Beispielen wird auf die Verwendung von Boronsäure-Derivaten in Bezug auf OLEDs und die entsprechenden Displays abgezielt. Trotz dieser Beschränkung der Beschreibung ist es für den Fachmann ohne weiteres erfinderisches Zutun möglich, Boronsäure-Derivate auch für weitere Verwendungen in anderen elektronischen Vorrichtungen zu benutzen.

Die Erfindung wird durch die folgenden Beispiele erläutert, ohne sie dadurch einschränken zu wollen.

### Beispiele:

Die nachfolgenden Synthesen werden, sofern nicht anders angegeben, unter einer Schutzgasatmosphäre durchgeführt. Die Edukte (9-Brom-anthracen, 4-Methylnaphth-1-ylboronsäure, 9,10-Dibromanthracen, Ethylenglykol, Pinacol, Hexafluor-2,3-bis(trifluormethyl)butan-2,3-diol, Pinakolboran, 1,4-Dibromnaphthalin, *p*-Xylol-diethylphosphonat, N,N,N',N'-Tetraphenylbenzidin, 4-Brombenzoylchlorid, DPEPhos, Anorganika, Lösemittel) können von den Firmen ALDRICH, Lancaster, Sensient, Strem bzw. ABCR bezogen werden. Dibrompyren (Isomerengemisch) kann nach Minabe et al., Bull. Chem. Soc. Jpn. 1994, 67(1), 172, 2,6-Dibromanthrachinon nach Lee et al., Org. Lett. 2005, 7(2), 323, Bis(4-bromphenyl)methyl-diethylphosphonat nach JP 09003079, Bis(4-brom-phenyl)(4-formylphenyl)amin nach Holmberg et al., Poly. Mat. Sci. Engen. 2001, 84, 717, 4-Bromphenylphosphordibromid nach Hinke et al., Phos. Sulf. Rel. El. 1983, 15(1), 93; *fac*-Tris[2-(2-pyridinyl-κN)(5-brom-phenyl)-κC]-iridium(III), *fac*-Tris[2-(2-pyridinyl-κN)(4-fluor-5-brom-phenyl)- κC]-iridium(III) und *fac*-Tris[2-(1-isochinolinyl-κN)(5-brom-phenyl)- κC]-iridium(III) werden nach / analog zu WO 02/068435 (Beispiel 4) dargestellt werden.

### Beispiel 1: Synthese von Anthracen-9,10-bis(boronsäureglycol-ester)

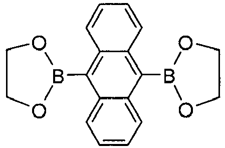

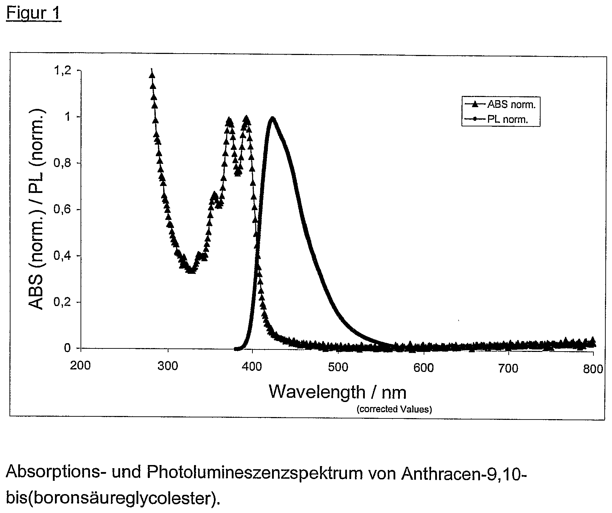

Eine auf -78 °C gekühlte, gut gerührte Suspension von 150.0 g (446 mmol) 9,10-Dibromanthracen in 2000 ml Diethylether wird während 20 min. mit 428.0 ml (1.07 mol) n-Buthyllithium (2.5 M in n-Hexan) versetzt und anschließend 30 min. bei -78 °C gerührt. Man lässt die Suspension während 2 h auf 20 °C erwärmen, rührt 2 h bei 20 °C nach und kühlt die Suspension erneut auf -78 °C. Unter gutem Rühren gibt man 199.0 ml (1.78 mol) Trimethylborat während 5 min. zu und lässt die Suspension erneut auf 20 °C erwärmen. Nach 15 h bei 20 °C wird mit einem Gemisch aus 67.0 ml (1.12 mol) Essigsäure in 300 ml Wasser versetzt und 5 h bei Raumtemperatur nachgerührt. Nach Abtrennen der Wasserphase wird die organische Phase im Vakuum zur Trockene eingeengt. Der verbliebene Brei wird mit 500 ml n-Hexan versetzt und 1 h intensiv gerührt. Anschließend wird der gebildete Feststoff abgesaugt, zweimal mit 200 ml n-Hexan gewaschen und trocken gesaugt. Der Feststoff wird in 500 ml Toluol suspendiert, mit 60 ml Ethylenglycol versetzt und 5 h am Wasserabscheider gekocht. Die nach Erkalten der Toluollösung ausgefallenen Kristalle werden abgesaugt, erneut zweimal aus Toluol umkristallisiert und anschließend sublimiert (T = 240 °C, p = 5 x 10⁻⁵ mbar). Ausbeute: 71.3 g (50.3 % d.Th.), 99.9 %ig nach ¹H-NMR. Das Absorptions- und Photolumineszenzspektrum von Anthracen-9,10-bis(boronsäureglycolester) ist in Figur 1 gezeigt. Wie man deutlich erkennt, zeigt die Verbindung einen sehr geringen Stokes-Shift.

### Beispiel 2: Synthese von 10-(4-Methylnaphth-1-yl)anthracen-9-boronsäurepinacolester

### a) 9-(4-Methylnaphth-1-yl)anthracen

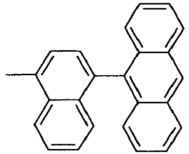

Eine Suspension von 93.0 g (500 mmol) 4-Methylnaphthalin-1-boronsäure, 100.0 g (389 mmol) 9-Bromanthracen, 212.3 g (1 mol)Trikaliumphosphat in einem Gemisch aus 400 ml Dioxan, 600 ml Toluol und 1000 ml Wasser wird unter gutem Rühren mit 3.6 g (11.7 mmol) Tri-o-tolylphosphin und dann mit 437 mg (1.9 mmol) Palladium(II)acetat versetzt und 16 h unter Rückfluss erhitzt. Nach Erkalten der Reaktionsmischung wird die organische Phase abgetrennt und dreimal mit 500 ml Wasser gewaschen. Anschließend wird die organische Phase über Kieselgel filtriert und zur Trockene eingeengt. Das verbleibende Öl wird in 1000 ml Ethanol aufgenommen und unter Rückfluss in Lösung gebracht. Nach Erkalten wird der farblose Feststoff abgesaugt, erneut mit 1000 ml Ethanol ausgerührt und abschließend im Vakuum getrocknet. Ausbeute: 103.0 g (83.1 % d.Th.), ca. 96 %ig nach ¹H-NMR.

### b) 9-Brom-10-(4-methylnaphth-1-yl)anthracen

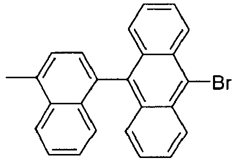

Eine Lösung von 102.0 g (320 mmol) 9-(4-Methylnaphth-1-yl)anthracen in 2000 ml Dichlormethan wird bei -5 °C unter gutem Rühren tropfenweise mit einem Gemisch von 18.0 ml (352 mmol) Brom in 100 ml Dichlormethan versetzt und 12 h bei Raumtemperatur gerührt. Anschließend wird die Suspension mit 1000 ml Ethanol verdünnt. Der ausgefallene Feststoff wird abgesaugt, mit 500 ml eines Gemischs aus Wasser und Ethanol (1:1, v:v) und dreimal mit 200 ml Ethanol gewaschen. Nach zweimaligem Auskochen mit je 1000 ml Ethanol wird der Feststoff im Vakuum getrocknet. Ausbeute: 108.0 g (84.9 % d.Th.), ca. 97 %ig nach ¹H-NMR.

### c) 10-(4-Methylnaphth-1-yl)anthracen-9-boronsäurepinacolester

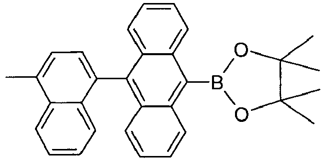

Eine auf -78 °C gekühlte, gut gerührte Suspension von 39.7 g (100 mmol) 9-Brom-10-(4-methylnaphth-1-yl)anthracen in 1000 ml Diethylether wird während 20 min. mit 44.0 ml (110 mmol) n-Buthyllithium (2.5 M in n-Hexan) versetzt und anschließend 30 min. bei -78 °C gerührt. Man lässt die Suspension während 2 h auf 20 °C erwärmen, rührt 2 h bei 20 °C nach und kühlt die Suspension erneut auf -78 °C. Unter gutem Rühren gibt man 28.0 ml (250 mol) Trimethylborat während 5 min. zu und lässt die Suspension erneut auf 20 °C erwärmen. Nach 15 h bei 20 °C wird mit einem Gemisch aus 15.0 ml (250 mol) Essigsäure in 200 ml Wasser versetzt und 5 h bei Raumtemperatur nachgerührt. Nach Abtrennen der Wasserphase wird die organische Phase im Vakuum zur Trockene eingeengt. Der verbliebene Brei wird mit 300 ml n-Hexan versetzt und 1 h intensiv gerührt. Anschließend wird der gebildete Feststoff abgesaugt, zweimal mit 100 ml n-Hexan gewaschen und trocken gesaugt. Der Feststoff wird in 150 ml Toluol suspendiert, mit 13.0 g (110 mmol) Pinacol versetzt und 5 h am Wasserabscheider gekocht. Die nach Erkalten der Toluollösung ausgefallenen Kristalle werden abgesaugt, zweimal aus DMSO umkristallisiert und anschließend sublimiert (T = 350°C, p = 5 x 10⁻⁵ mbar); Ausbeute: 30.4 g (68.4 % d.Th.), 99.9 %ig nach ¹H-NMR.

### Referenzbeispiel 3: Synthese von 9,10-Bis(phenyl-2-boronsäurepinacolester)anthracen

### a) 9,10-Bis(2-bromphenyl)anthracen

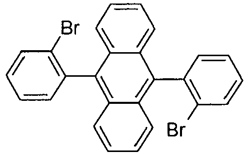

Eine Lösung von 149.0 ml (1.2 mol) 1,2-Dibrombenzol, 98.0 g (308 mmol) 9,10-Anthracendiboronsäureethylenglycolester und 179.0 g (3.1 mol) Kaliumfluorid (wasserfrei, sprühgetrocknet) in einem Gemisch aus 1300 ml Dioxan, 350 ml Ethanol und 950 ml Wasser wird mit 6.7 g (5.8 mmol) Tetrakis-(tri-phenylphosphino)-palladium(0) versetzt und 120 h unter Rückfluss erhitzt. Nach Erkalten wird der ausgefallene Feststoff abgesaugt, dreimal mit je 100 ml Wasser und dreimal mit je 100 ml Ethanol gewaschen und im Vakuum getrocknet. Ausbeute: 64.3 g (132 mmol), 42.8 % d. Th.; Reinheit 98 % n. ¹H-NMR, atropisomerenrein.

### b) Synthese von 9,10-Bis(phenyl-2-boronsäurepinacolester)-anthracen

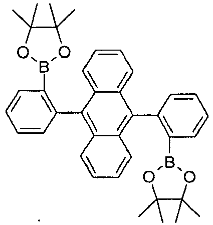

Eine Suspension von 19.5 g (40 mmol) 9,10-Bis(2-bromphenyl)anthracen in 1000 ml Diethylether wird mit 40.0 ml n-BuLi (2.5 M in Hexan) versetzt und 6 h bei Raumtemperatur gerührt. Anschließend wird die Reaktionsmischung auf-78 °C abgekühlt und unter gutem Rühren schnell mit 26.8 ml (240 mmol) Trimethylborat versetzt. Nach langsamen Erwärmen auf Raumtemperatur gibt man ein Gemisch aus 8 ml Essigsäure und 300 ml Wasser und dann 500 ml Essigsäureethylester zu, rührt 1 h bei Raumtemperatur nach, trennt die organische Phase ab, wäscht zweimal mit 500 ml Wasser, und engt die organische Phase im Vakuum ein. Der Rückstand wird mit 300 ml Toluol und 10.6 g (90 mmol) Pinacol versetzt und am Wasserabscheider erhitzt. Nach beendeter Wasserabscheidung destilliert man 250 ml Toluol ab und gibt 300 ml Ethanol zu. Nach Erkalten wird der farblose Feststoff abgesaugt, dreimal aus Toluol umkristallisiert und im Vakuum getrocknet. Sublimation, p = 1 x 10⁻⁵ mbar, T = 260 °C. Ausbeute: 10.6 g (18 mmol), 45.5 % d. Th.; Reinheit: 99.9 % n. ¹H-NMR.

### Referenzbeispiel 4: Synthese von 1,2-Bis(anthracen-9-yl-10-boronsäurepinacolester)benzol

### a) 1,2-Bis(anthracen-9-yl)benzol

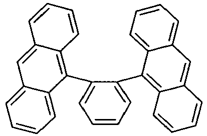

Durchführung analog Beispiel 3a. Anstelle von 149.0 ml (1.2 mol) 1,2-Dibrombenzol und 98.0 g (308 mmol) 9,10-Anthracendiboronsäureethylenglycolester werden 12.1 ml (100 mmol) Dibrombenzol und 68.0 g (306 mmol) 9-Anthracenboronsäure verwendet. Nach Erkalten wird vom Feststoff abgesaugt, dieser wird mit dreimal mit je 100 ml Ethanol gewaschen und dann zweimal mit je 1000 ml Essigsäure unter Rückfluss ausgerührt (1 h), und jeweils nach Erkalten auf 90 °C abgesaugt. Die Mutterlauge wird jeweils verworfen. Abschließend wird der Feststoff einmal mit Ethanol ausgekocht. Ausbeute: 33.0 g (76 mmol), 76.6 % d. Th.; Reinheit: 98 % n. ¹H-NMR.

### b) 1,2-Bis(10-brom-anthracen-9-yl)benzol

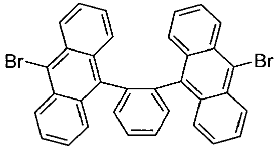

Eine Suspension von 86.1 g (200 mmol) 1,2-Bis(anthracen-9-yl)benzol und 500 g Glaskugeln (4 mm Durchmesser) in 2000 ml THF, gerührt von einem KPG-Rührer, wird unter Lichtausschluß mit 142.4 g (800 mmol) N-Bromsuccinimid versetzt. Die Mischung wird 24 h bei Raumtemperatur gerührt, dann werden die Glaskugeln über eine Sieb abfiltriert, mit THF gewaschen, der Feststoff wird vom THF abfiltriert, dreimal mit je 200 ml Ethanol gewaschen und dann im Vakuum getrocknet. Ausbeute: 114.1 g (194 mmol), 97.0 % d. Th.; Reinheit: 97 % n. ¹H-NMR.

### c) 1,2-Bis(anthracen-9-yl-10-boronsäurepinacolester)benzol

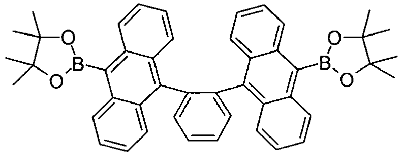

Darstellung analog Beispiel 3b. Anstelle von 19.5 g (40 mmol) 9,10-Bis(2-bromphenyl)anthracen werden 23.5 g (40 mmol) 1,2-Bis(10-bromanthracen-9-yl)benzol verwendet. Sublimation bei p = 1 x 10⁻⁵ mbar, T = 310 °C. Ausbeute: 17.1 g (25 mmol), 62.6 % d. Th.; Reinheit: 99.9 % n. ¹H-NMR.

### Referenzbeispiel 5: Synthese von 1,4-Bis(anthracen-9-yl-10-boronsäurepinacolester)naphthalin

### a) 1,4-Bis(anthracen-9-yl)naphthalin

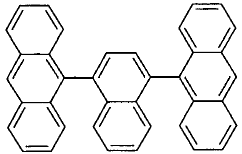

Durchführung analog Beispiel 3a. Anstelle von 149.0 ml (1.2 mol) 1,2-Dibrombenzol und 98.0 g (308 mmol) 9,10-Anthracendiboronsäureethylenglycolester werden 28.6 g (100 mmol) 1,4-Dibromnaphthalin und 68.0 g (306 mmol) 9-Anthracenboronsäure verwendet. Nach Erkalten wird vom Feststoff abgesaugt, dieser wird zweimal mit je 500 ml Ethanol ausgekocht. Ausbeute: 33.0 g (69 mmol), 68.7 % d. Th.; Reinheit: 98 % n. ¹H-NMR.

### b) 1,4-Bis(10-bromanthracen-9-yl)naphthalin

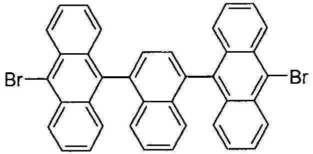

Durchführung analog Beispiel 4b. Anstelle von 86.0 g (200 mmol) 1,2-Bis-(anthracen-9-yl)benzol und 142.4 g (800 mmol) N-Bromsuccinimid werden 96.1 g (200 mmol) 1,4-Bis(anthracen-9-yl)naphthalin und 42.7 g (240 mmol) N-Bromsuccinimid verwendet. Ausbeute: 109.2 g (171 mmol), 85.5 % d. Th.; Reinheit: 97 % n. ¹H-NMR.

### c) 1,4-Bis(anthracen-9-yl-10-boronsäurepinacolester)naphthalin

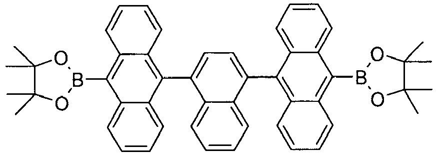

Darstellung analog Beispiel 3b. Anstelle von 19.5 g (40 mmol) 9,10-Bis(2-bromphenyl)anthracen werden 25.5 g (40 mmol) 1,4-Bis(10-bromanthracen-9-yl)naphthalin verwendet. Sublimation bei p = 1 x 10⁻⁵ mbar, T = 300 °C. Ausbeute: 12.1 g (16.5 mmol), 41.3 % d. Th.; Reinheit: 99.8 % n. ¹H-NMR.

### Beispiel 6: Synthese von 9,10-Bis(naphth-1-yl)anthracen-2,6-bis(boronsäurepinakolester)

### a) 2,6-Dibrom-9,10-bis(naphth-1-yl)anthracen

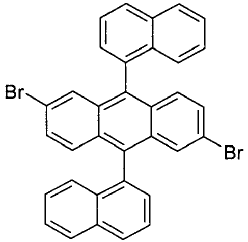

Aus 30.5 ml (220 mmol) 1-Bromnaphthalin und 5.5 g (225 mmol) Magnesium in 500 ml THF wird das entsprechende Grignardreagenz dargestellt. Zu diesem Grignardreagenz gibt man 36.6 g (100 mmol) 2,6-Dibrom-anthrachinon, erhitzt 6 h unter Rückfluss, lässt erkalten, gibt 15 ml Essigsäure zu, engt zur Trockene ein, nimmt den Rückstand in 500 ml DMF auf, gibt 56.9 g (300 mmol) Zinn(II)chlorid zu und erhitzt 5 h unter Rückfluss. Nach Erkalten gibt man 200 ml 2 N Salzsäure zu, rührt 1 h nach, saugt vom Feststoff ab, wäscht dreimal mit je 200 ml 2 N Salzsäure, dreimal mit je 300 ml Wasser, dreimal mit je 200 ml Ethanol, trocknet den Feststoff im Vakuum und kristallisiert einmal aus DMF um. Ausbeute: 48.9 g (83 mmol), 83.1 % d. Th.; Reinheit: 98 % n. ¹H-NMR.

### b) 9,10-Bis(naphth-1-yl)anthracen-2,6-bis(boronsäurepinakolester)

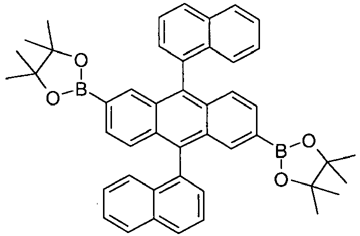

Darstellung analog Beispiel 3b. Anstelle von 19.5 g (40 mmol) 9,10-Bis(2-bromphenyl)anthracen werden 23.5 g (40 mmol) 2,6-Dibrom-9,10-bis-(naphth-1-yl)anthracen verwendet. Umkristallisation je zweimal aus Toluol und dann Dioxan. Sublimation bei p = 1 x 10⁻⁵ mbar, T = 270 °C. Ausbeute: 14.6 g (21 mmol), 53.5 % d. Th.; Reinheit: 99.9 % n. ¹H-NMR.

### Referenzbeispiel 7: Synthese von 9,10-Bis(naphth-1-yl-4-boronsäure-pinacolester)anthracen

### a) 9,10-Bis(4-bromnaphth-1-yl)anthracen

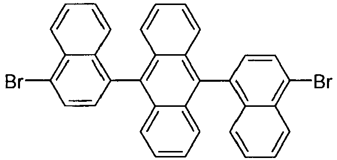

Eine Lösung von 31.9 g (120 mmol) 1,4-Dibromnaphthalin in 1000 ml THF wird unter gutem Rühren bei -78 °C mit 48.0 ml (120 mmol) n-Buthyllithium (2.5 M in Hexan) versetzt. Die Mischung wird 1 h bei -78 °C gerührt, dann lässt man auf 0 °C erwärmen, gibt 10.4 g (50 mmol) Anthrachinon zu und rührt 3 h bei 0 °C nach. Nach Zugabe von 15 ml Essigsäure engt man zur Trockene ein, nimmt den Rückstand in 500 ml DMF auf, gibt 28.4 g (150 mmol) Zinn(II)chlorid zu und erhitzt 5 h unter Rückfluss. Nach Erkalten gibt man 200 ml 2 N Salzsäure zu, rührt 1 h nach, saugt vom Feststoff ab, wäscht dreimal mit je 200 ml 2 N Salzsäure, dreimal mit je 300 ml Wasser, dreimal mit je 200 ml Ethanol, trocknet den Feststoff im Vakuum und kristallisiert einmal aus NMP um. Ausbeute: 25.9 g (44 mmol), 88.0 % d. Th.; Reinheit: 98 % n. ¹H-NMR.

### b) 9,10-Bis(4-bromnaphth-1-yl)anthracen

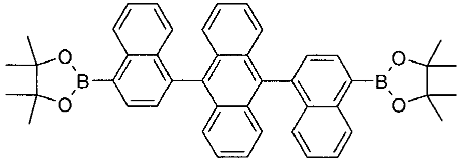

Darstellung analog Beispiel 3b. Anstelle von 19.5 g (40 mmol) 9,10-Bis(2-bromphenyl)anthracen werden 23.5 g (40 mmol) 9,10-Bis(4-bromnaphth-1-yl)anthracen verwendet. Aufgrund der schlechten Löslichkeit des 9,10-Bis(4-bromnaphth-1-yl)anthracen werden dem Ansatz 200 g Glasperlen (4 mm Durchmesser) zugesetzt, das Rühren erfolgt mit einem mechanischen Flügelrührer, und die Reaktionszeit der Lithiierung wird auf 24 h erhöht. Umkristallisation viermal aus Dioxan. Sublimation bei p = 1 x 10⁻⁵ mbar, T = 290 °C. Ausbeute: 17.6 g (26 mmol), 64.5 % d. Th.; Reinheit: 99.9 % n. ¹H-NMR.

### Beispiel 8: Synthese von 1,6-Bis(2,5-dimethylphenyl)pyren-3,8-bis(boronsäurepinacolester)

### a) 1,6-Bis(2,5-dimethylphenyl)pyren

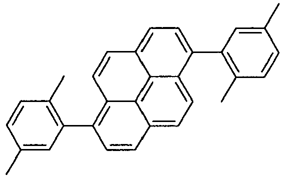

Eine gut gerührte Suspension von 76.0 g (211 mmol) Dibrompyren (Isomerengemisch), 72.9 g (486 mmol) 2,5-Dimethylphenylboronsäure und 222.4 g (966 mmol) Kaliumphosphat-1-hydrat in einem Gemisch aus 500 ml Toluol, 500 ml Dioxan und 1000 ml Wasser wird mit 7.2 g (20 mmol) Tri-o-tolylphosphin und 740 mg (3.3 mmol) Palladium(II)acetat versetzt und 12 h unter Rückfluss erhitzt. Nach Erkalten auf Raumtemperatur wird vom ausgefallenen Feststoff abgesaugt, dieser wird mit 200 ml Ethanol gewaschen, in 500 ml Dichlormethan unter Erwärmen gelöst, die Lösung über Kieselgel filtriert, das Filtrat im Vakuum auf 100 ml eingeengt und mit 300 ml Ethanol versetzt. Nach 2 h Stehen werden die farblosen Kristalle abgesaugt, mit 100 ml Ethanol gewaschen und im Vakuum getrocknet. Ausbeute: 32.5 g (79 mmol), 37.5 % d. Th.; Reinheit 98 % n. ¹H-NMR.

### b) 1,6-Bis(2,5-dimethylphenyl)-3,8-dibrompyren

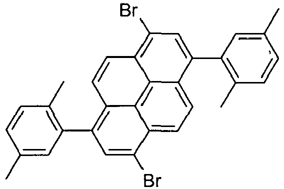

Eine Suspension von 25.8 g (63 mmol) 1,6-Bis(2,5-dimethylphenyl)pyren und 24.8 g (139 mmol) N-Bromsuccinimid in 800 ml THF wird 16 h unter Lichtausschluss bei Raumtemperatur gerührt. Die Reaktionsmischung wird im Vakuum auf 100 ml eingeengt und mit 200 ml Ethanol und 200 ml Wasser versetzt. Der Niederschlag wird abgesaugt, dreimal mit 100 ml Ethanol gewaschen, im Vakuum getrocknet und zweimal aus Chlorbenzol umkristallisiert. Ausbeute: 26.0 g (46 mmol), 72.6 % d. Th.; Reinheit 97 % n. ¹H-NMR.

### c) 1,6-Bis(2,5-dimethylphenyl)pyren-3,8-bis(boronsäurepinacol-ester)

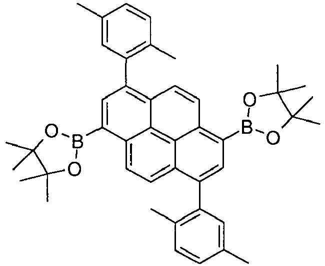

Durchführung analog Beispiel 3b. Anstelle von 19.5 g (40 mmol) 9,10-Bis(2-bromphenyl)anthracen werden 22.7 g (40 mmol) 1,6-Bis(2,5-dimethylphenyl)-3,8-dibrompyren eingesetzt. Die Umkristallisation erfolgt aus Dioxan. Sublimation, p = 1 x 10⁻⁵ mbar, T = 290 °C. Ausbeute: 11.5 g (17 mmol), 43.3 % d. Th.; Reinheit: 99.9 % n. ¹H-NMR.

### Referenzbeispiel 9: Synthese von 1,4-Bis(anthracen-9-yl-10-boron-säurebrenzcatechinester)naphthalin

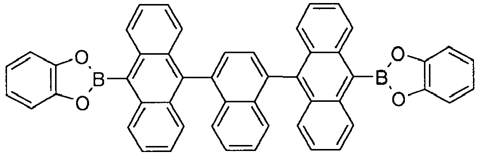

Darstellung analog Beispiel 3b. Anstelle von 19.5 g (40 mmol) 9,10-Bis(2-bromphenyl)anthracen werden 25.5 g (40 mmol) 1,4-Bis(10-brom-anthracen-9-yl)naphthalin, anstelle von 10.6 g (90 mmol) Pinacol werden 9.9 g (90 mmol) Brenzkatechin verwendet. Sublimation bei p = 1 x 10⁻⁵ mbar, T = 330 °C. Ausbeute: 17.7 g (25 mmol), 61.8 % d. Th.; Reinheit: 99.7 % n. ¹H-NMR.

### Beispiel 10: Synthese von 9,10-Bis(naphth-1-yl)anthracen-3,8-bis(boronsäurebrenzkatechinester)

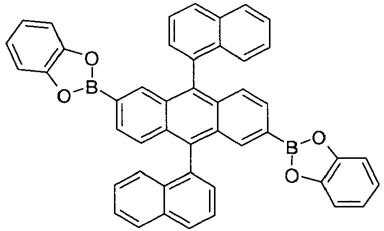

Darstellung analog Beispiel 3b. Anstelle von 19.5 g (40 mmol) 9,10-Bis(2-bromphenyl)anthracen werden 23.5 g (40 mmol) 2,6-Dibrom-9,10-bis-(naphth-1-yl)anthracen, anstelle von 10.6 g (90 mmol) Pinacol werden 9.9 g (90 mmol) Brenzkatechin verwendet. Sublimation bei p = 1 x 10⁻⁵ mbar, T = 305 °C. Ausbeute: 9.2 g (14 mmol), 34.5 % d. Th.; Reinheit: 99.9 % n. ¹H-NMR.

### Referenzbeispiel 11: 2,4,6-Tris-[10-(4-methylnaphth-1-yl)anthracen-9-yl]-cyclotriboroxan

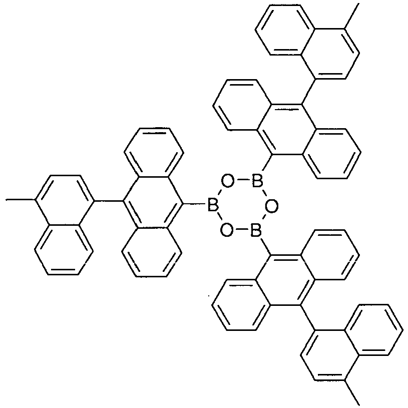

Darstellung analog Beispiel 2c. Nach Isolierung der Boronsäure wird diese in 300 ml Acetonitril suspendiert und 5 h am Wasserabscheider gekocht, wobei das Azeotrop kontinuierlich bis auf 50 ml abgenommen wird. Nach Zugabe von 300 ml Ethanol und Erkalten werden die ausgefallenen Kristalle abgesaugt, viermal aus Dioxan umkristallisiert und anschließend sublimiert (T = 370 °C, p = 5 x 10⁻⁵ mbar); Ausbeute: 15.8 g (18 mmol), 45.9 % d. Th.; Reinheit: 99.9 % n. ¹H-NMR.

### Beispiel 12: 9,10-Bis(naphth-1-yl)anthracen-3,8-bis(boronsäure-hexafluor-2,3-bis(trifluormethyl)but-2,3-ylester)

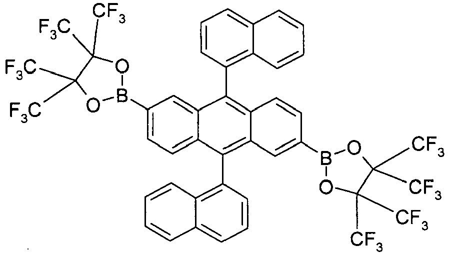

Darstellung analog Beispiel 3b. Anstelle von 19.5 g (40 mmol) 9,10-Bis(2-bromphenyl)anthracen werden 23.5 g (40 mmol) 2,6-Dibrom-9,10-bis-(naphth-1-yl)anthracen verwendet. Anstelle von 10.6 g (90 mmol) Pinacol werden 30.1 g (90 mmol) Hexafluor-2,3-bis(trifluormethyl)butan-2,3-diol verwendet. Umkristallisation fünfmal aus Toluol / Acetonitril. Sublimation bei p = 1 x 10⁻⁵ mbar, T = 280 °C. Ausbeute: 18.1 g (16 mmol), 40.6 % d. Th.; Reinheit: 99.8 % n. ¹H-NMR.

### Beispiel 13: Synthese von 9,10-Bis(naphth-1-yl)anthracen-3,8-bis(2-(3-methyl-2,3-dihydro-benzo[1,3,2]oxazaborol)

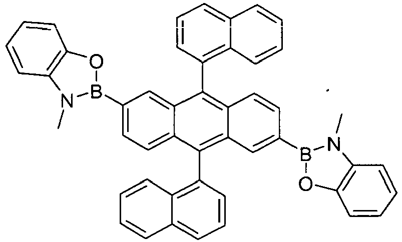

Darstellung analog Beispiel 3b. Anstelle von 19.5 g (40 mmol) 9,10-Bis(2-bromphenyl)anthracen werden 23.5 g (40 mmol) 2,6-Dibrom-9,10-bis-(naphth-1-yl)anthracen verwendet. Anstelle von 10.6 g (90 mmol) Pinacol werden 11.1 g (90 mmol) 2-Methylaminophenol verwendet. Umkristallisation viermal aus DMF. Sublimation bei p = 1 x 10⁻⁵ mbar, T = 280 °C. Ausbeute: 14.9 g (21.5 mmol), 53.8 % d. Th.; Reinheit: 99.9 % n. ¹H-NMR.

### Referenzbeispiel 14: Synthese von Tris-((4-(2,2-di(4-phenyl-boronsäurepinakolester)vinyl)phen-1-yl)amin

### a) Tris-((4-(2,2-di(4-bromphenyl)vinyl)phen-1-yl)amin

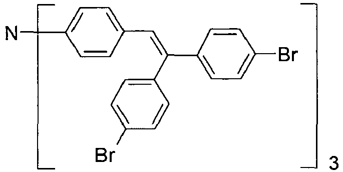

Eine auf 0 °C gekühlte Suspension von 76.9 g (800 mmol) Natrium-*tert-*butylat in 1000 ml wasserfreiem DMF wird mit einer Lösung von 184.8 g (400 mmol) Bis(4-bromphenyl)methyl-diethylphosphonat in 200 ml DMF versetzt. Nach 30 min. Nachrühren gibt man eine Lösung von 32.9 g (100 mmol) Tris(4-formyl)amin in 300 ml DMF während 30 min. zu, rührt 4 h bei 0 °C nach, versetzt dann mit 1000 ml 1 N Salzsäure und 500 ml Ethanol. Man saugt vom Feststoff ab, wäscht diesen dreimal mit 300 ml Wasser, dreimal mit 200 ml Ethanol und trocknet im Vakuum. Anschließend wird aus DMF umkristallisiert, abgesaugt, dreimal mit 200 ml Ethanol gewaschen und im Vakuum getrocknet. Ausbeute: 109.4 g (87 mmol), 87.3 % d. Th.; Reinheit: 99 % n. ¹H-NMR.

### b) Tris-((4-(2,2-di(4-phenyl-boronsäurepinacolester)vinyl)phen-1-yl)amin

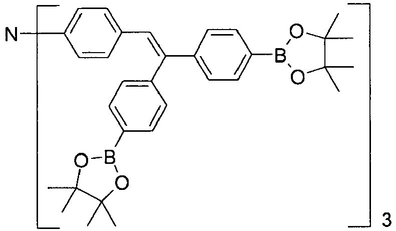

Eine Suspension von 31.3 g (25 mmol) Tris-((4-(2,2-di(4-bromphenyl)-vinyl)phen-1-yl)amin in 1000 ml Diethylether wird mit 65 ml n-BuLi (2.5 M in Hexan) versetzt und 6 h bei Raumtemperatur gerührt. Anschließend wird die Reaktionsmischung auf -78 °C abgekühlt und unter gutem Rühren schnell mit 44.5 ml (450 mmol) Trimethylborat versetzt. Nach langsamem Erwärmen auf Raumtemperatur gibt man ein Gemisch aus 15 ml Essigsäure und 500 ml Wasser und dann 500 ml Essigsäureethylester zu, rührt 1 h bei Raumtemperatur nach, trennt die organische Phase ab, wäscht zweimal mit 500 ml Wasser und engt die organische Phase im Vakuum ein. Der Rückstand wird mit 500 ml Toluol und 18.9 g (160 mmol) Pinacol versetzt und am Wasserabscheider erhitzt. Nach beendeter Wasserabscheidung destilliert man 400 ml Toluol ab und gibt 300 ml Ethanol zu. Nach Erkalten wird der gelbe Feststoff abgesaugt, fünfmal aus Dioxan / Ethanol (1:3, vv) umkristallisiert und im Vakuum (p = 1 x 10⁻⁵ mbar, T = 330 °C) sublimiert. Ausbeute: 14.5 g (9 mmol), 37.7 % d. Th.; Reinheit: 99.9 % n. ¹H-NMR.

### Referenzbeispiel 15: Synthese von 1,4-Bis(4-di(4-phenylboronsäure-pinakolester)aminostyryl)benzol

### a) 1,4-Bis(4-di(4-bromphenyl)aminostyryl)benzol

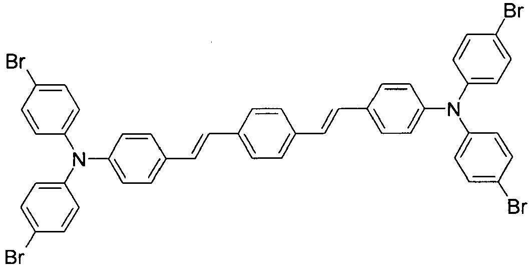

Eine auf 0 °C gekühlte Suspension von 38.5 g (400 mmol) Natrium-*tert-*butylat in 1000 ml wasserfreiem DMF wird mit einer Lösung von 37.8 g (100 mmol) p-Xylol-diethylphosphonat in 200 ml DMF versetzt. Nach 30 min. Nachrühren gibt man eine Lösung von 90.5 g (210 mmol) Bis(4-brom-phenyl)(4-formylphenyl)amin in 300 ml DMF während 30 min. zu, rührt 4 h bei 0 °C nach, versetzt dann mit 500 ml 1 N Salzsäure und 300 ml Ethanol. Man saugt vom Feststoff ab, wäscht diesen dreimal mit 300 ml Wasser, dreimal mit 200 ml Ethanol und trocknet im Vakuum. Anschließend wird aus DMF umkristallisiert, abgesaugt, dreimal mit 200 ml Ethanol gewaschen und im Vakuum getrocknet. Ausbeute: 86.1 g (92 mmol), 92.3 % d. Th.; Reinheit: 99 % n. ¹H-NMR.

### b) 1,4-Bis(4-di(4-phenylboronsäure-pinakolester)aminostyryl)-benzol

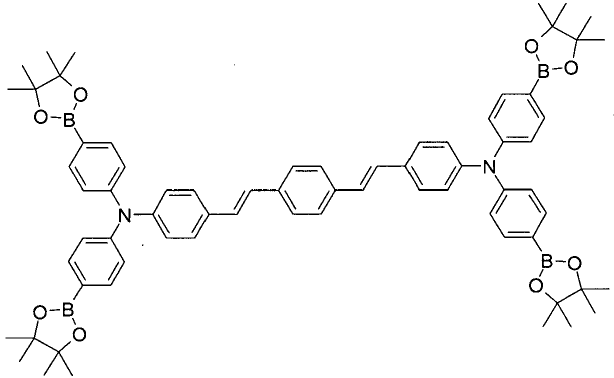

Darstellung analog Beispiel 14b. Anstelle von 31.3 g (25 mmol) Tris-((4-(2,2-di(4-bromphenyl)vinyl)phen-1-yl)amin werden 34.5 g (37 mmol) 1,4-Bis(4-di(4-bromphenyl)aminostyryl)benzol verwendet. Sublimation, p = 1 x 10⁻⁵ mbar, T = 310°C. Ausbeute: 18.9 g (17 mmol), 45.6 % d. Th.; Reinheit: 99.7 % n. ¹H-NMR.

### Referenzbeispiel 16: Synthese von N,N,N',N'-Tetrakis-(4-[1,3,2]dioxaborolan-2-yl-phenyl)biphenyl-4,4'-diamin

### a) N,N,N',N'-Tetra(4-bromphenyl)benzidin

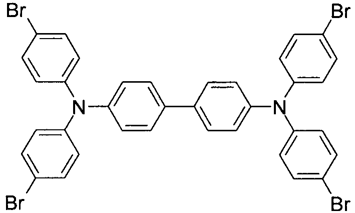

Eine Lösung von 48.9 g (100 mmol) N,N,N',N'-Tetraphenylbenzidin in 500 ml THF wird bei 40 °C unter gutem Rühren portionsweise mit 74.8 g (420 mmol) N-Bromsuccinimid versetzt und 16 h gerührt. Anschließend wird die Mischung auf 2000 g Eis gegeben, der ausgefallene Niederschlag wird abgesaugt, dreimal mit 300 ml Wasser und zweimal mit 200 ml Ethanol gewaschen und dann aus DMF umkristallisiert. Ausbeute: 73.5 g (91 mmol), 91.4 % d. Th.; Reinheit 98 % n. ¹H-NMR.

### b) N4,N4',N4",N4"'-Tetrakis-(4-[1,3,2]dioxaborolan-2-yl-phenyl)-biphenyl-4,4'-diamin

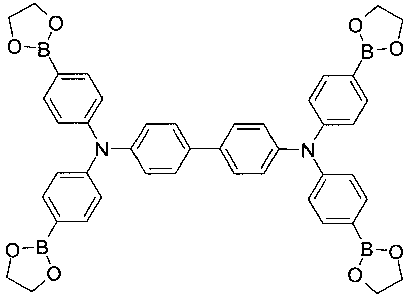

Darstellung analog Beispiel 15b. Anstelle von 34.5 g (37 mmol) 1,4-Bis(4-di(4-bromphenyl)aminostyryl)benzol werden 29.8 g (37 mmol) N,N,N',N'-Tetra(4-bromphenyl)-benzidin und anstelle von 18.9 g (160 mmol) Pinacol werden 9,0 ml (160 mmol) Ethylenglycol verwendet. Umkristallisation aus Toluol. Sublimation, p = 1 x 10⁻⁵ mbar, T = 250 °C. Ausbeute: 21.3 g (28 mmol), 75.0 % d. Th.; Reinheit: 99.9 % n. ¹H-NMR.

### Referenzbeispiel 17: Synthese von 2,2'-Bis(4-(4,4,5,5-tetra-methyl-[1,3,2]dioxaborolan-2-yl)-phenyl)spiro-9,9'-bifluoren

### a) 2,2'-Bis(4-brombenzoyl)spiro-9,9'-bifluoren

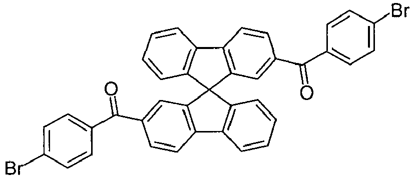

Eine Suspension von 16.0 g (120 mmol) Aluminiumchlorid in 300 ml 1,2-Dichlorethan wird tropfenweise mit einer Lösung von 24.1 g (110 mmol) 4-Brombenzolychlorid in 100 ml 1,2-Dichlorethan versetzt. Zu dieser Mischung gibt man tropfenweise eine Lösung von 15.8 g (50 mmol) Spiro-9,9'-bifluoren in 200 ml 1,2-Dichlorethan. Anschließend rührt man 4 h bei Raumtemperatur nach, gießt die Mischung unter gutem Rühren in ein Gemisch aus 1000 g Eis und 200 ml 2 N Salzsäure und saugt vom ausgefallenen Feststoff ab. Der Feststoff wird dreimal mit 500 ml Wasser und dreimal mit 200 ml Ethanol gewaschen und im Vakuum getrocknet. Ausbeute: 29.2 g (43 mmol), 85.6 % d. Th.; Reinheit: 98 % n. ¹H-NMR.

### b) 2,2'-Bis(4-(4,4,5,5-tetramethyl-[1,3,2]dioxaborolan-2-yl)-phenyl)-spiro-9,9'-bifluoren

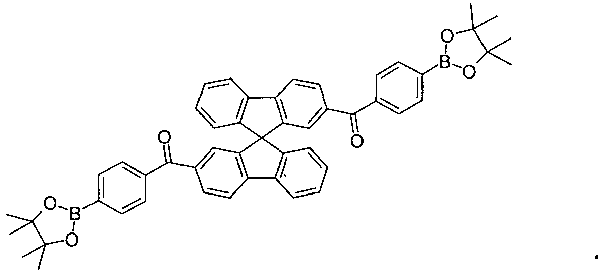

Die Darstellung erfolgt nach Melaimi et al., J. Organomet. Chem. 2004, 689(19), 2988, analog zur Darstellung von 2-(4-Acetylphenyl)-4,4,5,5-tetramethyl-1,3,2-dioxaborolan. Anstelle von 4-Acetylbrombenzol werden 17.1 g (25 mmol) 2,2'-Bis(4-brombenzoly)spiro-9,9'-bifluoren eingesetzt. Sublimation, p = 1 x 10⁻⁵ mbar, T = 265 °C. Ausbeute: 8.4 g (11 mmol), 43.2 % d. Th.; Reinheit: 99.9 % n. ¹H-NMR.

### Referenzbeispiel 18: Synthese von 2-Bis(spiro,9,9'-bifluoren)-(4-(4,4,5,5-tetramethyl-[1,3,2]dioxaborolan-2-yl)-phenyl)-phosphinoxid

### a) 2-Bis(spiro,9,9'-bifluoren)-(4-bromphenyl))phosphinoxid

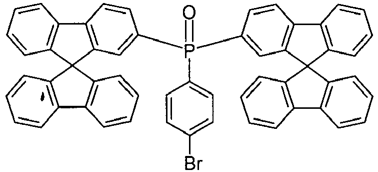

Darstellung analog WO 05/003253, Beispiel 1. Anstelle von Dichlorphenylphosphin werden 41.6 g (120 mmol) 4-Bromphenylphosphordibromid verwendet. Umkristallisation zweimal aus Chlorbenzol. Ausbeute: 71.0 g (71 mmol), 71.0 % d. Th.; Reinheit: 98 % n. ¹H-NMR.

### b) 2-Bis(spiro,9,9'-bifluoren)-(4-(4,4,5,5-tetramethyl-[1,3,2]dioxaborolan-2-yl)-phenyl)phosphinoxid

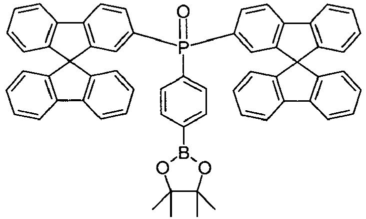

Darstellung analog Beispiel 17b. Anstelle von 17.1 g (25 mmol) 2,2'-Bis(4-brombenzoyl)spiro-9,9'-bifluoren werden 20.8 g (25 mmol) 2-Bis(spiro-9,9'-bifluoren)-(4-bromphenyl))phosphinoxid eingesetzt. Sublimation, p = 1 x 10⁻⁵ mbar, T = 310 °C. Ausbeute: 8.0 g (9 mmol), 36.3 % d. Th.; Reinheit: 99.9 % n. ¹H-NMR.

### Referenzbeispiel 19: Synthese von 4,4'-Bis(4,4'-bis([1,3,2]dioxaborolan-2-yl)carbazolyl)biphenyl

### a) 4,4'-Bis(4,4'-bisbromcarbazolyl)biphenyl

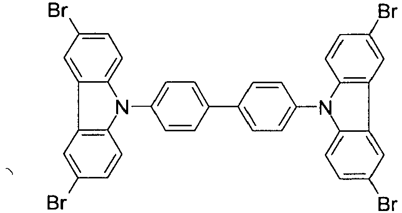

Eine Lösung von 48.5 g (100 mmol) Biscarbazolylbiphenyl in 1000 ml THF wird bei 40 °C unter gutem Rühren portionsweise mit 74.8 g (420 mmol) N-Bromsuccinimid versetzt und dann 16 h gerührt. Anschließend wird die Mischung auf 2000 g Eis gegeben, der ausgefallene Niederschlag wird abgesaugt, dreimal mit 300 ml Wasser und zweimal mit 200 ml Ethanol gewaschen und aus DMF umkristallisiert. Ausbeute: 74.3 g (93 mmol), 92.8 % d. Th.; Reinheit 98 % n. ¹H-NMR.

### b) 4,4'-Bis(4,4'-bis([1,3,2]dioxaborolan-2-yl)carbazolyl)biphenyl

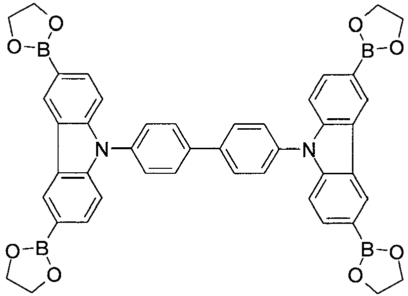

Darstellung analog Beispiel 16b. Anstelle von 29.8 g (37 mmol) N,N,N',N'-Tetra(4-bromphenyl)-benzidin werden 29.6 g (37 mmol) 4,4'-Bis(4,4'-bisbromcarbazolyl)biphenyl und anstelle von 18.9 g (160 mmol) Pinacol werden 9,0 ml (160 mmol) Ethylenglycol verwendet. Umkristallisation aus Dioxan. Sublimation, p = 1 x 10⁻⁵ mbar, T = 270 °C. Ausbeute: 21.3 g (28 mmol), 75.3 % d. Th.; Reinheit: 99.9 % n. ¹H-NMR.

### Referenzbeispiel 20: Synthese von 1,6-Bis((4-methylphenyl)amino)pyren-3,8-bis(boronsäurepinacolester)

### a) 1,6-Bis((4-methylphenyl)amino)pyren

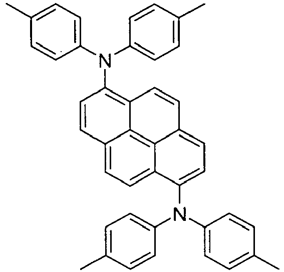

Eine gut gerührte Suspension von 76.0 g (211 mmol) Dibrompyren (Isomerengemisch), 94.7 g (480 mmol) Bis(4-methylphenyl)amin und 50.0 g (520 mmol) Natrium-*tert*-butylat in 1000 ml Toluol wird mit 1.05 ml (5.2 mmol) Chlor-di-*tert*-butylphosphin und dann mit 898 mg (4.0 mmol) Palladium(II)acetat versetzt und 5 h unter Rückfluss erhitzt. Nach Erkalten auf Raumtemperatur wird mit 1000 ml Wasser versetzt, vom ausgefallenen Feststoff abgesaugt, dieser wird mit 200 ml Ethanol gewaschen und im Vakuum getrocknet. Umkristallisation, dreimal aus DMF. Ausbeute: 41.4 g (70 mmol), 33.1 % d. Th.; Reinheit 99 % n. ¹H-NMR.

### b) 1,6-Bis((4-methylphenyl)amino)-3,8-dibrompyren

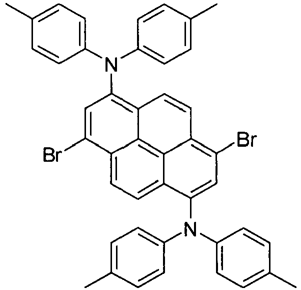

Darstellung analog 8b. Anstelle von 25.8 g (63 mmol) 1,6-Bis-(2,5-dimethylphenyl)-pyren werden 29.6 g (50 mmol) 1,6-Bis((4-methylphenyl)-amino)pyren, anstelle von 24,8 g (139 mmol) N-Bromsuccinimid werden 19.6 g (110 mmol) N-Bromsuccinimid verwendet. Ausbeute: 27.4 g (36.5 mmol), 73.0 % d. Th.; Reinheit 99 % n. ¹H-NMR.

### c) 1,6-Bis((4-methylphenyl)amino)pyren-3,8-bis(boronsäurepinacolester)

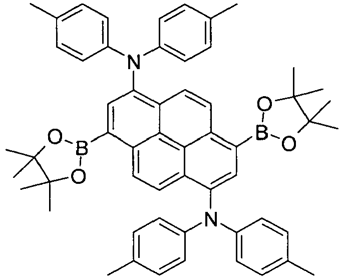

Durchführung analog Beispiel 3b. Anstelle von 19.5 g (40 mmol) 9,10-Bis-(2-bromphenyl)-anthracen werden 30.0 g (40 mmol) 1,6-Bis((4-methylphenyl)amino)-3,8-dibrompyren eingesetzt. Die Umkristallisation erfolgt aus Chlorbenzol. Sublimation, p = 1 x 10⁻⁵ mbar, T = 285 °C. Ausbeute: 13.8 g (16 mmol), 40.8 % d. Th.; Reinheit: 99.9 % n. ¹H-NMR.

### Referenzbeispiel 21: Synthese von 9,10-Bis((bis-4-(4,4,5,5-tetramethyl-[1,3,2]dioxaborolan-2-yl)phenyl)amino)anthracen

### a) 9,10-Bis(diphenylamino)anthracen

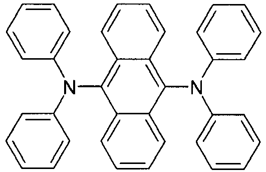

Darstellung analog Beispiel 20a. Anstelle von 76.0 g (211 mmol) Dibrompyren (Isomerengemisch) und 94.7 g (480 mmol) Bis(4-methylphenyl)amin werden 70.9 g (211 mmol) 9,10-Dibromanthracen und 81.2 g (480 mmol) Diphenylamin verwendet. Ausbeute: 86.2 g (168 mmol), 79.7 % d. Th.; Reinheit 99 % n. ¹H-NMR.

### b) 9,10-Bis-N,N-(di(4-bromphenyl)amino)anthracen

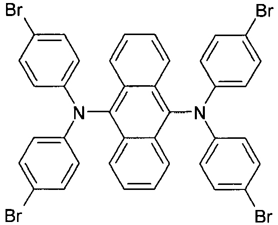

Darstellung analog Beispiel 16a. Anstelle von 48.9 g (100 mmol)

N,N,N',N'-Tetra-phenylbenzidin werden 51.3 g (100 mmol) 9,10-Bis-(diphenylamino)anthracen verwendet. Ausbeute: 70.8 g (85 mmol), 85.5 % d. Th.; Reinheit 98 % n. ¹H-NMR.

### c) 9,10-Bis((bis-4-(4,4,5,5-tetramethyl-[1,3,2]dioxaborolan-2-yl)-phenyl)amino)anthracen

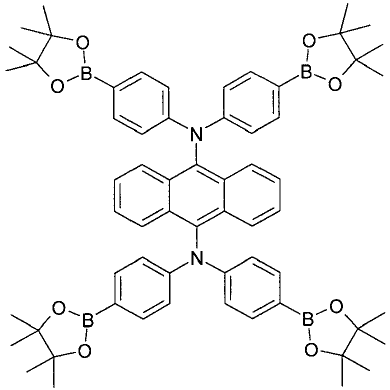

Darstellung analog Beispiel 3b. Anstelle von 19.5 g (40 mmol) 9,10-Bis(2-bromphenyl)anthracen werden 16.6 g (20 mmol) 9,10-Bis(di(4-bromphenyl)amino)anthracen verwendet. Die Umkristallisation erfolgt aus Chlorbenzol. Sublimation, p = 1 x 10⁻⁵ mbar, T = 285 °C. Ausbeute: 9.9 g (9.7 mmol), 48.7 % d. Th.; Reinheit 99.8 % n. ¹H-NMR.

### Referenzbeispiel 22: Synthese von fac-Tris[2-(2-pyridinyl-κN)(5-(4,4,5,5-tetramethyl-[1,3,2]dioxaborolan-2-yl)-phenyl)-κC]-iridium(III)

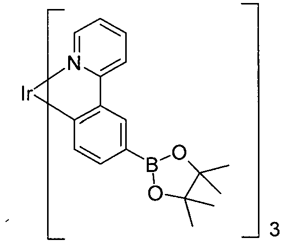

Die Darstellung erfolgt nach Broutin et al., Org. Lett. 2004, 6(24), 4419 analog der allgemeinen Darstellungsvorschrift für Phenylboronate. Es werden 892 mg (1 mmol) *fac*-Tris[2-(2-pyridinyl-κN)(5-brom-phenyl)-κC]-iridium(III) in 10 ml Dioxan und 1.3 g (10 mmol) Pinacolboran eingesetzt, die Reaktionszeit beträgt 16 h. Chromatographische Reinigung an desaktiviertem Kieselgel (5 % Triethylamin), Laufmittel Dichlormethan : n-Hexan (1:10, v:v). Sublimation, p = 1 x 10⁻⁵ mbar, T = 295 °C. Ausbeute: 325 mg (315 µmol), 31.5 % d. Th.; Reinheit: 99.9 % n. ¹H-NMR.

### Referenzbeispiel 23: Synthese von fac-Tris[2-(2-pyridinyl-κN)(4-fluor-5-(4,4,5,5-tetramethyl-[1,3,2]dioxaborolan-2-yl)-phenyl)-κC]-iridium(III)

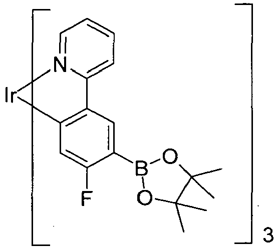

Die Darstellung erfolgt nach Broutin et al., Org. Lett. 2004, 6(24), 4419 analog der allgemeinen Darstellungsvorschrift für Phenylboronate. Es werden 946 mg (1 mmol) *fac*-Tris[2-(2-pyridinyl-κN)-(4-fluor-5-bromphenyl)-κC]-iridium(III) in 10 ml Dioxan und 1.3 g (10 mmol) Pinacolboran eingesetzt, die Reaktionszeit beträgt 16 h.Chromatographische Reinigung an desaktiviertem Kieselgel (5 % Triethylamin), Laufmittel Dichlormethan : n-Hexan (1:10, v:v). Sublimation, p = 1 x 10⁻⁵ mbar, T = 280 °C. Ausbeute: 324 mg (298 µmol), 29.8 % d. Th.; Reinheit: 99.8 % n. ¹H-NMR.

### Referenzbeispiel 24: Synthese von fac-Tris[2-(1-isochinolinyl-κN)(5-(4,4,5,5-tetramethyl-[1,3,2]dioxaborolan-2-yl)-phenyl)-κC]-iridium(III)

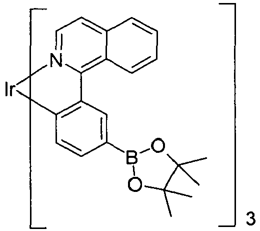

Die Darstellung erfolgt nach Broutin et al., Org. Lett. 2004, 6(24), 4419 analog der allgemeinen Darstellungsvorschrift für Phenylboronate. Es 1042 mg (1 mmol) *fac*-Tris[2-(1-isochinolinyl-κN)(5-brom-phenyl)-κC]-iridium(III) in 10 ml Dioxan und 1.3 g (10 mmol) Pinakolboran eingesetzt, die Reaktionszeit beträgt 16 h.Chromatographische Reinigung an desaktiviertem Kieselgel (5 % Triethylamin), Laufmittel Dichlormethan : n-Hexan (1:10, v:v). Sublimation, p = 1 x 10⁻⁵ mbar, T = 340 °C. Ausbeute: 485 mg (410 µmol), 41.0 % d. Th.; Reinheit: 99.9 % n. ¹H-NMR.

### Beispiel 25: Herstellung von OLEDs mit den Materialien nach Beispiel 1 bis 13

Die Herstellung von OLEDs erfolgt nach einem allgemeinen Verfahren gemäß WO 04/058911, das im Einzelfall auf die jeweiligen Gegebenheiten (z. B. Schichtdickenvariation, um optimale Effizienz bzw. Farbe zu erreichen) angepasst wird.

In den folgenden Beispielen 26 bis 39 werden die Ergebnisse verschiedener OLEDs vorgestellt. Der grundlegende Aufbau und die verwendeten Materialien (außer der emittierenden Schicht) sind in den Beispielen zur besseren Vergleichbarkeit identisch. Analog dem o. g. allgemeinen Verfahren werden OLEDs mit folgendem Aufbau erzeugt:

| | |
|---|---|
| Lochinjektionsschicht (HIL) | 20 nm PEDOT (aus Wasser aufgeschleudert; von H. C. Starck, Goslar, Deutschland; Poly(3,4-ethylendioxy-2,5-thiophen)) |
| Lochtransportschicht (HTM) | 30 nm 4,4',4"-Tris(N-1-naphthyl-N-phenylamino)-triphenylamin, (abgekürzt als NaphDATA bezogen von SynTec) |
| Lochtransportschicht (HTM) | 30 nm NPB (N-Naphthyl-N-phenyl-4,4'-diaminobiphenyl) |
| Emissionschicht (EML) | 30 nm, Schicht aus den Hostmaterialien nach Beispiel 1 bis 13 (s. Tabelle), dotiert mit 5 % Tris[4-(2,2-diphenyl-vinyl)-phenyl]amin als Dotand (abgekürzt D1, aufgedampft, synthetisiert nach WO 06/000388) |
| ODER: | als Vergleichsbeispiel 30 nm 9,10-Bis(1-naphthylanthracen) als Hostmaterial (abgekürzt H), dotiert mit 5 % Tris[4-(2,2-diphenyl-vinyl)-phenyl]amin als Dotand (abgekürzt D1) |
| Elektronenleiter (ETL) | 20 nm AlQ₃ (bezogen von SynTec, Tris(chinolinato)aluminium(III)) |
| Kathode | 1 nm LiF, darauf 150 nm Al |

Diese OLEDs werden standardmäßig charakterisiert; hierfür werden die Elektrolumineszenzspektren, die Effizienz (gemessen in cd/A), die Leistungseffizienz (gemessen in Im/W) in Abhängigkeit der Helligkeit, berechnet aus Strom-Spannungs-Helligkeit-Kennlinien (IUL-Kennlinien) bestimmt.

In Tabelle 1 sind die Ergebnisse einiger OLEDs (Beispiele 26 bis 39), zusammengefasst.

Das Hostmaterial für das Vergleichsbeispiel ist 9,10-Bis(1-naphthyl)-anthracen; als Dotand wird in allen Beispielen D1 eingesetzt. Beide sind im Folgenden dargestellt:

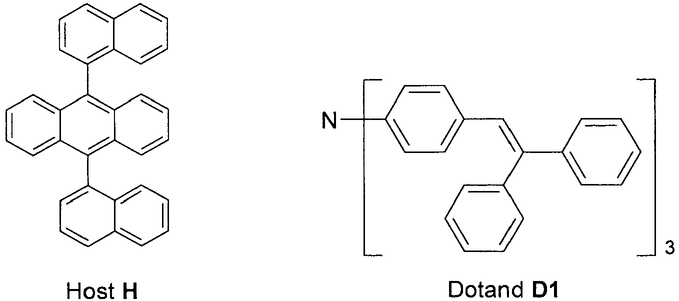

Wie man den Beispielen bis in der Tabelle 1 entnehmen kann, zeigen OLEDs enthaltend die Hostmaterialien nach Beispielen 1 bis 13 geringere Betriebsspannungen. Dies führt neben deutlich verbesserten Leistungseffizienzen, gleichbedeutend mit geringerem Stromverbrauch bei gleichen Betriebshelligkeiten, auch zu verbesserten Lebensdauern.

**Tabelle 1**

| **Beispiel** | **EML** | **Max Effizienz (cd/A)** | **Spannung(V) bei 1000 cd/m²** | **CIE** |
|---|---|---|---|---|
| Beispiel 26 (Vergleich) | Host H Dotand D1 | 7.9 | 6.6 | x=0.17; y=0.31 |
| Beispiel 27 | Host n. Bsp.1 Dotand D1 | 8.2 | 5.3 | x=0.16; y=0.28 |
| Beispiel 28 | Host n. Bsp.2 Dotand D1 | 8.3 | 5.2 | x=0.16; y=0.29 |
| Referenz-Beispiel 29 | Host n. Bsp.3 Dotand D1 | 8.2 | 5.3 | x=0.16; y=0.29 |
| Referenz-Beispiel 30 | Host n. Bsp.4 Dotand D1 | 8.0 | 5.4 | x=0.16; y=0.30 |
| Referenz-Beispiel 31 | Host n. Bsp.5 Dotand D1 | 8.5 | 5.0 | x=0.16; y=0.28 |
| Beispiel 32 | Host n. Bsp.6 Dotand D1 | 8.6 | 4.9 | x=0.16; y=0.29 |
| Referenz-Beispiel 33 | Host n. Bsp.7 Dotand **D1** | 8.7 | 4.7 | x=0.15; y=0.27 |
| Beispiel 34 | Host n. Bsp.8 Dotand **D1** | 8.5 | 4.9 | x=0.16; y=0.28 |
| Referenz-Beispiel 35 | Host n. Bsp.9 Dotand **D1** | 8.3 | 5.0 | x=0.17; y=0.29 |
| Beispiel 36 | Host n. Bsp.10 Dotand **D1** | 8.4 | 5.1 | x=0.16; y=0.29 |
| Referenz-Beispiel 37 | Host n. Bsp.11 Dotand **D1** | 8.7 | 5.4 | x=0.15; y=0.27 |
| Beispiel 38 | Host n. Bsp.12 Dotand **D1** | 8.6 | 5.5 | x=0.16; y=0.28 |
| Beispiel 39 | Host n. Bsp.13 Dotand **D1** | 7.9 | 5.3 | x=0.16; y=0.29 |

### Beispiel 40: Herstellung von OLEDs mit den Hostmaterialien nach Beispiel 5 bis 8 bzw. Host H und den Emittern nach Referenzbeispiel 14 und 15

In den folgenden Beispielen 41 bis 51 werden die Ergebnisse verschiedener OLEDs vorgestellt. Der grundlegende Aufbau und die verwendeten Materialien (außer der emittierenden Schicht) sind in den Beispielen zur besseren Vergleichbarkeit identisch. Analog dem o. g. allgemeinen Verfahren werden OLEDs mit folgendem Aufbau erzeugt:

| | |
|---|---|
| Lochinjektionsschicht (HIL) | 20 nm PEDOT (aus Wasser aufgeschleudert; von H. C. Starck, Goslar, Deutschland; Poly(3,4-ethylendioxy-2,5-thiophen)) |
| Lochtransportschicht (HTM) | 30 mn 4,4',4"-Tris(N-1-naphthyl-N-phenylamino)-triphenylamin, (abgekürzt als NaphDATA bezogen von SynTec) |
| Lochtransportschicht (HTM) | 30 nm NPB (N-Naphthyl-N-phenyl-4,4'-diaminobiphenyl) |
| Emissionschicht (EML) | 30 nm, Schicht aus den Hostmaterialien nach Beispiel 5, 6, 7, 8 (s. Tabelle), dotiert mit 5 % Dotand nach Beispiel 14 bzw. 15 |
| ODER: | als Vergleichsbeispiel 9,10-Bis(1-naphthylanthracen) als Hostmaterial (abgekürzt H), dotiert mit 5 % Tris[4-(2,2-diphenyl-vinyl)-phenyl]amin als Dotand (abgekürzt **D1,** aufgedampft, synthetisiert nach WO 06/000388) bzw. dotiert mit 5 % 1,4-Bis-(4-di(3-methylphenyl)aminostyryl)benzol als Dotand (abgekürzt **D2,** aufgedampft, synthetisiert nach JP 06001973) |
| Elektronenleiter (ETL) | 20 nm AlQ₃ (bezogen von SynTec, Tris(chinolinato)aluminium(III)) |
| Kathode | 1 nm LiF, darauf 150 nm Al |

Diese OLEDs werden standardmäßig charakterisiert; hierfür werden die Elektrolumineszenzspektren, die Effizienz (gemessen in cd/A), die Leistungseffizienz (gemessen in Im/W) in Abhängigkeit der Helligkeit, berechnet aus Strom-Spannungs-Helligkeit-Kennlinien (IUL-Kennlinien) bestimmt.

In Tabelle 2 sind die Ergebnisse einiger OLEDs (Beispiele 41 bis 51), zusammengefasst. Das Hostmaterial für die Vergleichsbeispiele ist 9,10-Bis(1-naphthyl)anthracen (s.o.), als Dotanden für die Vergleichsbeispiele werden **D1** (s.o.) und **D2** eingesetzt.

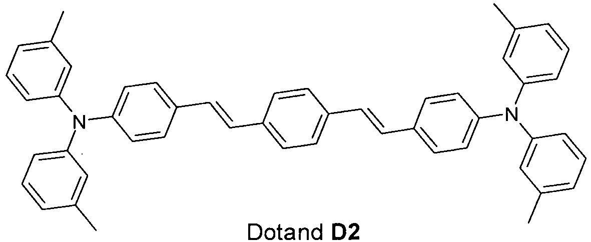

Wie man den Beispielen in der Tabelle 2 entnehmen kann, zeigen OLEDs enthaltend die Hostmaterialien deutlich verbesserte Effizienzen bei vergleichbaren Farbkoordinaten und verbesserte Lebensdauern.

Außerdem sei an dieser Stelle noch mal auf die erheblich verbesserte thermische Stabilität des Dotanden nach Referenzbeispiel 15 gegenüber dem strukturell analogen, aber nicht mit 4,4,5,5-Tetramethyl-[1,3,2]dioxaborolan-2-yl-Gruppen substituierten Dotanden **D2** hingewiesen. Diese verbesserte Stabilität ist insbesondere in der technischen Anwendung von maßgeblicher Bedeutung, da Dotanden im industriellen Einsatz Standzeiten von mehreren Tagen bis Wochen bei hohen Temperaturen aufweisen müssen.

**Tabelle 2**

| **Beispiel** | **EML** | **Max Effizienz (cd/A)** | **Spannung (V) bei 1000 cd/m²** | **CIE** |
|---|---|---|---|---|
| Beispiel 41 (Vergleich) | Host **H** Dotand **D** | 7.9 | 6.6 | x=0.17; y=0.31 |
| Referenz-Beispiel 42 | Host **H** Dotand n. Bsp. 14 | 9.8 | 5.1 | x=0.19; y=0.31 |
| Referenz-Beispiel 43 | Host **H** Dotand n. Bsp. 15 | 12.3 | 5.0 | x=0.21; y=0.33 |
| Referenz-Beispiel 44 | Host n. Bsp.5 Dotand n. Bsp. 14 | 10.2 | 5.0 | x=0.17; y=0.31 |
| Referenz-Beispiel 45 | Host n. Bsp.6 Dotand n. Bsp. 14 | 10.3 | 4.9 | x=0.18; y=0.32 |
| Referenz-Beispiel 46 | Host n. Bsp.7 Dotand n. Bsp. 14 | 9.9 | 5.2 | x=0.18; y=0.32 |
| Referenz-Beispiel 47 | Host n. Bsp.8 Dotand n. Bsp. 14 | 10.6 | 4.9 | x=0.18; y=0.32 |
| Referenz-Beispiel 48 | Host n. Bsp.5 Dotand n. Bsp. 15 | 13.2 | 5.0 | x=0.19; y=0.32 |
| Referenz-Beispiel 49 | Host n. Bsp.6 Dotand n. Bsp. 15 | 13.0 | 4.9 | x=0.19; y=0.32 |
| Referenz-Beispiel 50 | Host n. Bsp.7 Dotand n. Bsp. 15 | 12.9 | 5.2 | x=0.19; y=0.32 |
| Referenz-Beispiel 51 | Host n. Bsp.8 Dotand n. Bsp. 15 | 12.7 | 4.9 | x=0.19; y=0.32 |

### Beispiel 52: Herstellung von OLEDs mit dem Lochtransportmaterial nach Referenzbeispiel 16

In den folgenden Beispielen 53 und 54 werden die Ergebnisse verschiedener OLEDs vorgestellt. Der grundlegende Aufbau und die verwendeten Materialien (außer der emittierenden Schicht) sind in den Beispielen zur besseren Vergleichbarkeit identisch. Analog dem o. g. allgemeinen Verfahren werden OLEDs mit folgendem Aufbau erzeugt:

| | |
|---|---|
| Lochinjektionsschicht (HIL) | 20 nm PEDOT (aus Wasser aufgeschleudert; von H. C. Starck, Goslar, Deutschland; Poly(3,4-ethylendioxy-2,5-thiophen)) |
| Lochtransportschicht (HTM) | 30 nm Schicht aus dem Lochtransportmaterial nach Beispiel 16 |
| ODER: | als Vergleichsbeispiel 30 nm Schicht aus N,N,N',N'-Tetraphenyl[1,1'-biphenyl]-4,4'-diamin (abgekürzt TAD; bezogen von SynTec) |
| Lochtransportschicht (HTM) | 30 nm NPB (N-Naphthyl-N-phenyl-4,4'-diaminobiphenyl) |
| Emissionschicht (EML) | 30 nm, Schicht aus dem Hostmaterial nach Beispiel 8 (s. Tabelle), dotiert mit 5 % Dotand nach Beispiel 14 |
| Elektronenleiter (ETL) | 20 nm AlQ₃ (bezogen von SynTec, Tris(chinolinato)aluminium(III)) |
| Kathode | 1 nm LiF, darauf 150 nm Al |

Diese OLEDs werden standardmäßig charakterisiert; hierfür werden die Elektrolumineszenzspektren, die Effizienz (gemessen in cd/A), die

Leistungseffizienz (gemessen in Im/W) in Abhängigkeit der Helligkeit, berechnet aus Strom-Spannungs-Helligkeit-Kennlinien (IUL-Kennlinien) bestimmt.

In Tabelle 3 sind die Ergebnisse zweier OLEDs (Beispiele 53 und 54) wiedergegeben. Wie man den Beispielen in der Tabelle 3 entnehmen kann, zeigen OLEDs enthaltend das Lochtransportmaterial nach Referenzbeispiel 16 deutlich verbesserte Effizienzen bei vergleichbaren Farbkoordinaten und verbesserte Lebensdauern.

**Tabelle 3**

| **Beispiel** | **HTM** | **Max. Effizienz (cd/A)** | **Spannung(V) bei 1000 cd/m²** | **CIE** |
|---|---|---|---|---|
| Beispiel 53 (Vergleich) | TAD | 9.0 | 5.6 | x=0.19; y=0.33 |
| Referenz-Beispiel 54 | HTM n. Bsp. 16 | 10.8 | 4.7 | x=0.18; y=0.32 |

### Beispiel 55: Herstellung von OLEDs mit Matrixmaterialien nach Referenzbeispiel 17, 18 und 19 und Emittern nach Referenzbeispiel 22, 23 und 24

Die Herstellung von OLEDs erfolgt nach einem allgemeinen Verfahren gemäß WO 04/093207, das im Einzelfall auf die jeweiligen Gegebenheiten (z. B. Schichtdickenvariation, um optimale Effizienz bzw. Farbe zu erreichen) angepasst wird.

Hier werden die Ergebnisse verschiedener OLEDs gegenübergestellt. Der grundlegende Aufbau, wie die verwendeten Materialien, Dotierungsgrad und ihre Schichtdicken, sind für die Beispielexperimente zur besseren Vergleichbarkeit identisch. Es wird ausschließlich das Wirtsmaterial in der Emitterschicht getauscht, und die Beispiele werden mit unterschiedlichen Triplett-Emittern durchgeführt.

Das erste Beispiel beschreibt einen Vergleichsstandard nach dem Stand der Technik, bei dem die Emitterschicht aus dem Matrixmaterial CBP besteht. Des Weiteren werden OLEDs mit einer Emitterschicht bestehend aus den Matrixmaterialien nach den Referenzbeispielen 17, 18 und 19 beschrieben.

Analog dem o. g. allgemeinen Verfahren wurden grün und rot emittierende OLEDs mit folgendem Aufbau erzeugt:

| | |
|---|---|
| PEDOT | 60 nm (aus Wasser aufgeschleudert; bezogen von H. C. Starck; Poly-[3,4-ethylendioxy-2,5-thiophen]) |
| NaphDATA | 20 nm (aufgedampft; NaphDATA bezogen von SynTec; 4,4',4"-Tris(N-1-naphthyl-N-phenyl-amino)-triphenylamin |
| S-TAD | 20 nm (aufgedampft; S-TAD hergestellt nach WO99/12888; 2,2',7,7'-Tetrakis(diphenyl-amino)spirobifluoren) |
| Emitter-Schicht: | 20 nm des Matrixmaterials nach Referenzbeispiel 17, 18 bzw. 19 jeweils dotiert mit 10 % **E1** (synthetisiert nach WO 04/085449) oder **E2** (synthetisiert nach US 2003/0068526) |
| ODER: | 20 nm des Matrixmaterials nach Referenzbeispiel 17, 18 bzw. 19 jeweils dotiert mit 10 % des Emitters nach Referenzbeispiel 22, 23 bzw. 24 |
| ODER: | als Vergleichsbeispiel 20 nm CBP (aufgedampft; CBP bezogen von ALDRICH und weiter gereinigt, schließlich noch zweimal sublimiert; 4,4'-Bis-(N-carbazolyl)biphenyl) (Vergleichsstandard), dotiert mit 10 % **E1** (synthetisiert nach WO 04/085449) oder **E2** (synthetisiert nach US 2003/0068526 |
| Bathocuproin (BCP) | 10 nm (aufgedampft; BCP bezogen von ABCR, verwendet wie erhalten; 2,9-Dimethyl-4,7-diphenyl-1,10-phenanthrolin); nicht in allen Beispielen verwendet |
| AlQ₃ | 10 nm (aufgedampft; AlQ₃ bezogen von SynTec; Tris(chinolinolato)aluminium(III)), nicht in allen Beispielen verwendet |
| Ba-Al | 3 nm Ba, darauf 150 nm Al als Kathode |

Diese OLEDs werden standardmäßig charakterisiert; hierfür werden die Elektrolumineszenzspektren, die Effizienz (gemessen in cd/A), die Leistungseffizienz (gemessen in Im/W) in Abhängigkeit der Helligkeit, berechnet aus Strom-Spannungs-Helligkeit-Kennlinien (IUL-Kennlinien), und die Lebensdauer bestimmt. Als Lebensdauer wird die Zeit definiert, nach der die Anfangshelligkeit von 1000 cd/m² auf die Hälfte gesunken ist. Zur Übersicht sind im Folgenden die verwendeten Triplett-Emitter und die verwendeten Wirtsmaterialien abgebildet:

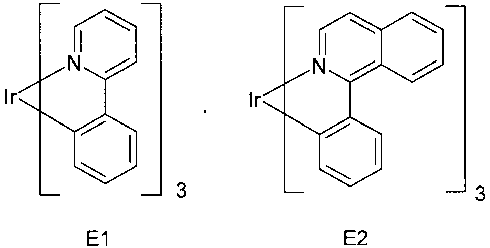

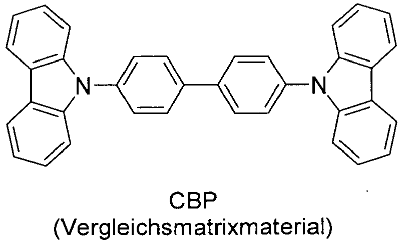

**Tabelle 4:**

| **Experiment** | **EML** | **HBL** | **ETL** | **Max. Effizienz (cd/A)** | **Max. Leistungseffizienz (lm/W)** | **x, y (CIE)** | **Lebensdauer (h) bei 1000 cd/cm²** |
|---|---|---|---|---|---|---|---|
| Beispiel 56 (Vergleich) | CBP **E1** | BCP (10 nm) | AlQ₃ (10 nm) | 25.0 | 12.2 | 0.33,0.61 | 400 |
| Referenz-Beispiel 57 | Matrix n. Bsp. 17 **E1** | BCP (10 nm) | AlQ₃ (10 nm) | 32.2 | 26.7 | 0.32, 0.60 | 1050 |
| Referenz-Beispiel 58 | Matrix n. Bsp. 18 **E1** | BCP (10 nm) | AlQ₃ (10 nm) | 43.0 | 36.5 | 0.32, 0.60 | 1200 |
| Referenz-Beispiel 59 | Matrix n. Bsp. 19 **E1** | BCP (10 nm) | AlQ₃ (10 nm) | 33.9 | 17.4 | 0.31, 0.61 | 650 |
| Beispiel 60 (Vergleich) | CBP Emitter n. Bsp. **22** | BCP (10 nm) | AlQ₃ (10 nm) | 20.9 | 17.2 | 0.31, 0.63 | 900 |
| Referenz-Beispiel 61 | Matrix n. Bsp. 17 Emitter n. Bsp. 22 | BCP (10 nm) | AlQ₃ (10 nm) | 34.8 | 28.8 | 0.30, 0.62 | 2200 |
| Referenz-Beispiel 62 | Matrix n. Bsp. 18 Emitter n. Bsp. 22 | BCP (10 nm) | AlQ₃ (10 nm) | 47.2 | 36.8 | 0.30, 0.62 | 2600 |
| Referenz-Beispiel 63 | Matrix n. Bsp. 19 Emitter n. Bsp. 22 | BCP (10 nm) | AlQ₃ (10 nm) | 35.0 | 19.1 | 0.30, 0.61 | 1750 |
| Referenz-Beispiel 64 | Matrix n. Bsp. 17 Emitter n. Bsp. 22 | | | 42.0 | 34.6 | 0.31, 0.62 | 2000 |
| Referenz-Beispiel 65 | Matrix n. Bsp. 18 Emitter n. Bsp. 22 | | | 56.4 | 46.8 | 0.31,0.62 | 2100 |
| Referenz-Beispiel 66 | Matrix n. Bsp. 18 Emitter n. Bsp. 22 | | | 59.2 | 51.9 | 0.30, 0.61 | 1550 |
| Referenz-Beispiel 67 | Matrix n. Bsp. 18 Emitter n. Bsp. 23 | | | 45.2 | 33.2 | 0.38, 0.52 | 1550 |
| Beispiel 68 (Vergleich) | CBP **E2** | | | 6.5 | 4.8 | 0.68, 0.32 | 5000 (extrapoliert) |
| Referenz-Beispiel 69 | Matrix n. Bsp. 17 **E2** | | | 7.7 | 6.7 | 0.69,0.31 | 25000 (extrapoliert) |
| Referenz-Beispiel 70 | Matrix n. Bsp. 18 **E2** | | | 8.1 | 7.6 | 0.68, 0.32 | 27000 (extrapoliert) |
| Referenz-Beispiel 71 | Matrix n. Bsp. 19 **E2** | | | 7.2 | 5.4 | 0.68, 0.32 | 8000 (extrapoliert) |
| Referenz-Beispiel 72 | CBP Emitter n. Bsp. 24 | | | 13.4 | 9.0 | 0.66, 0.34 | 11000 (extrapoliert) |
| Referenz-Beispiel 73 | Matrix n. Bsp. 17 Emitter n. Bsp. 24 | | | 14.3 | 11.5 | 0.67,0.33 | 32000 (extrapoliert) |
| Referenz-Beispiel 74 | Matrix n. Bsp. 18 Emitter n. Bsp. 24 | | | 14.7 | 12.2 | 0.66, 0.34 | 27000 (extrapoliert) |
| Referenz-Beispiel 75 | Matrix n. Bsp. 19 Emitter n. Bsp. 24 | | | 14.1 | 10.1 | 0.66, 0.34 | 15000 (extrapoliert) |

### Elektrolumineszenzspektren:

Die OLEDs, sowohl der Vergleichsbeispiele als auch die OLEDs enthaltend die Matrices und Emitter zeigen vergleichbare Farbkoordinaten, wobei die Emitter nach Referenz-Beispiel 22, 23 und 24, die 4,4,5,5-tetramethyl-[1,3,2]dioxaborolan-2-yl-Gruppen tragen, etwas hypsochrom verschobene Emission aufweisen.

### Effizienz:

OLEDs, hergestellt mit den Matrixmaterialien nach Referenz-Beispiel 17, 18 bzw. 19 und enthaltend die Emitter nach Referenz-Beispiel 22, 23 und 24, zeigen sowohl deutliche bessere photometrische Effizienz als auch bessere Leistungseffizienzen im Vergleich zum Matrixmaterial gemäß Stand der Technik. Diese gilt insbesondere für die in anwendungstechnischer Hinsicht maßgebliche Leistungseffizienz, bedingt durch die geringeren Betriebsspannungen bei Verwendung der erfindungsgemäßen Matrixmaterialien.

### Lebensdauer:

Die Lebensdauer, die bei Verwendung der Matrixmaterialen 17, 18 bzw. 19 bzw. der Emitter 22, 23 und 24 erreicht wird, übertrifft die der Vergleichsbeispiele mit dem Matrixmaterial CBP erheblich.

### Schichtvereinfachung:

Wie den Beispielen 64, 65 und 66 entnommen werden kann, ist es mit den Matrixmaterialien möglich, OLEDs, die weder eine Lochblockierschicht noch eine Elekronenleiterschicht enthalten herzustellen, ohne dass dadurch das elektrooptische Gesamteigenschaftsprofil verschlechtert wird. Dies ist produktionstechnisch ein erheblicher Vorteil.

### Thermische Stabilität:

Die Emitter gemäß den Referenz-Beispielen 22, 23 und 24 weisen eine deutlich höhere thermische Stabilität auf gegenüber den strukturell analogen, jedoch nicht durch Boronsäureestergruppen substituierten Verbindungen. Diese verbesserte Stabilität ist insbesondere in der technischen Anwendung von maßgeblicher Bedeutung, da Dotanden im industriellen Einsatz Standzeiten von mehreren Tagen bis Wochen bei hohen Temperaturen aufweisen müssen.

### Beispiel 76: Herstellung der OLEDs mit den Elektronentransportmaterialien nach Referenzbeispiel 17, 18 und 19

Die Herstellung von OLEDs erfolgt nach einem allgemeinen Verfahren gemäß WO 04/058911, das im Einzelfall auf die jeweiligen Gegebenheiten (z. B. Schichtdickenvariation, um optimale Effizienz bzw. Farbe zu erreichen) angepasst wird.

In den folgenden Beispielen 77 bis 79 werden die Ergebnisse verschiedener OLEDs vorgestellt. Der grundlegende Aufbau und die verwendeten Materialien (außer der Elektronentransportschicht) sind in den Beispielen zur besseren Vergleichbarkeit identisch. Analog dem o. g. allgemeinen Verfahren werden OLEDs mit folgendem Aufbau erzeugt:

| | |
|---|---|
| Lochinjektionsschicht (HIL) | 20 nm PEDOT (aus Wasser aufgeschleudert; von H. C. Starck, Goslar, Deutschland; Poly(3,4-ethylendioxy-2,5-thiophen)) |
| Lochtransportschicht (HTM) | 30 nm 4,4',4"-Tris(N-1-naphthyl-N-phenylamino)-triphenylamin, (abgekürzt als NaphDATA bezogen von SynTec) |
| Lochtransportschicht (HTM) | 30 nm NPB (N-Naphthyl-N-phenyl-4,4'-diaminobiphenyl) |
| Emissionschicht (EML) | 30 nm, dotierte Schicht aus 9,10-Bis(1-naphthylanthracen) als Hostmaterial (abgekürzt H), dotiert mit 5 % Tris[4-(2,2-diphenyl-vinyl)-phenyl]amin als Dotand (abgekürzt **D1,** aufgedampft) |
| Elektronenleiter (ETL) | 20 nm des Elektronenleiters nach Referenz-Beispiel 17 bzw. 18 |
| ODER: | als Vergleichsbeispiel 20 nm AlQ₃ (bezogen von SynTec, Tris(chinolinato)aluminium(III)) |
| Kathode | 1 nm LiF, darauf 150 nm Al |

Diese OLEDs werden standardmäßig charakterisiert; hierfür werden die Elektrolumineszenzspektren, die Effizienz (gemessen in cd/A), die Leistungseffizienz (gemessen in Im/W) in Abhängigkeit der Helligkeit, berechnet aus Strom-Spannungs-Helligkeit-Kennlinien (IUL-Kennlinien) bestimmt.

In Tabelle 5 sind die Ergebnisse einiger OLEDs (Beispiele 79, 80), bei denen die Elektronentransportschicht (ETM) aus den Verbindungen 17 bzw. 18 besteht, zusammengefasst. Als Vergleichsmaterial wird im Vergleichsbeispiel AlQ₃ gemäß den Stand der Technik verwendet.

Wie man den Beispielen 77 bis 79 in der Tabelle 5 entnehmen kann, zeigen OLED-Devices enthaltend die Elektronentransportmaterialien nach Referenzbeispiel 17 bzw. 18 eine deutlich geringere Betriebsspannung bei 1000 cd/m², was sich in besseren Leistungseffizien äußert.

**Tabelle 5**

| **Beispiel** | **ETL** | **Max Effizienz (cd/A)** | **Spannung (V) bei 1000 cd/m²** | **CIE** |
|---|---|---|---|---|
| Beispiel 77 (Vergleich) | AlQ₃ | 7.9 | 6.6 | x=0.17; y=0.31 |
| Referenz-Beispiel 78 | ETL n. Bsp. 17 | 8.0 | 5.1 | x=0.16; y=0.31 |
| Referenz-Beispiel 79 | ETL n. Bsp. 18 | 8.0 | 5.0 | x=0.16; y=0.31 |

### Beispiel 80: Herstellung der OLEDs mit den Emittermaterialien nach Referenzbeispiel 20 und 21

Die Herstellung von OLEDs erfolgt nach einem allgemeinen Verfahren gemäß WO 04/058911, das im Einzelfall auf die jeweiligen Gegebenheiten (z. B. Schichtdickenvariation, um optimale Effizienz bzw. Farbe zu erreichen) angepasst wird.

In den folgenden Beispielen 81 bzw. 82 werden die Ergebnisse verschiedener OLEDs vorgestellt. Der grundlegende Aufbau und die verwendeten Materialien (außer der Elektronentransportschicht) sind in den Beispielen zur besseren Vergleichbarkeit identisch. Analog dem o. g. allgemeinen Verfahren werden OLEDs mit folgendem Aufbau erzeugt:

| | |
|---|---|
| Lochinjektionsschicht (HIL) | 20 nm PEDOT (aus Wasser aufgeschleudert; von H. C. Starck, Goslar, Deutschland; Poly(3,4-ethylendioxy-2,5-thiophen)) |
| Lochtransportschicht (HTM) | 30 nm 4,4',4"-Tris(N-1-naphthyl-N-phenylamino)-triphenylamin, (abgekürzt als NaphDATA bezogen von SynTec) |
| Lochtransportschicht (HTM) | 30 nm NPB (N-Naphthyl-N-phenyl-4,4'-diaminobiphenyl) |
| Emissionschicht (EML) | 30 nm, dotierte Schicht aus 9,10-Bis(1-naphthylanthracen) als Hostmaterial (abgekürzt **H**), dotiert mit 5 % der Emittermaterialien n. Referenzbeispiel 20 bzw. 21 |
| Elektronenleiter (ETL) | 20 nm AlQ₃ (bezogen von SynTec, Tris(chinolinato)aluminium(III)) |
| Kathode | 1 nm LiF, darauf 150 nm Al |

Diese OLEDs werden standardmäßig charakterisiert; hierfür werden die Elektrolumineszenzspektren, die Effizienz (gemessen in cd/A), die Leistungseffizienz (gemessen in Im/W) in Abhängigkeit der Helligkeit, berechnet aus Strom-Spannungs-Helligkeit-Kennlinien (IUL-Kennlinien) bestimmt.

In Tabelle 6 sind die Ergebnisse einiger OLEDs (Beispiele 81 bzw. 82), bei denen die Emittermaterialien aus den Verbindungen 20 bzw. 21 besteht, zusammengefasst.

Wie man den Beispielen 81 bis 82 in der Tabelle 6 entnehmen kann, zeigen OLED-Devices enthaltend die Emittermaterialien nach Referenzbeispiel 20 bzw. 21 eine effiziente grüne Emission.

**Tabelle 6**

| **Beispiel** | **EML** | **Max Effizienz (cd/A)** | **Spannung (V) bei 1000cd/m²** | **CIE** |
|---|---|---|---|---|
| Referenz-Beispiel 81 | Emitter n. Bsp. 20 | 21.0 | 5.1 | x=0.27; y=0.62 |
| Referenz-Beispiel 82 | Emitter n. Bsp. 21 | 18.2 | 5.0 | x=0.24; y=0.58 |

### Beispiel 83: Sublimationstemperaturen

In der folgenden Tabelle 7 sind die Sublimationstemperaturen (bei einem Druck von 1x10⁻⁵ mbar) einiger Verbindungen, die in den vorangehenden Beispielen beschrieben sind, mit den Sublimationstemperaturen von Verbindungen verglichen, die die gleiche Grundstruktur aufweisen, jedoch nicht mit Boronsäureestern substituiert sind. An den aufgeführten Beispielen sieht man, dass die Sublimationstemperatur der entsprechenden Boronester durchweg niedriger liegt als die der unsubstituierten Verbindungen. Dies ist ein erheblicher technischer Vorteil, da dadurch temperaturempfindliche Teile der Aufdampfapparatur, wie beispielsweise Schattenmasken, nur einer geringeren thermischen Belastung ausgesetzt sind.

Weiterhin fällt auf, dass einige der Verbindungen, die als unsubstituierte Verbindung bei der Sublimation Zersetzung zeigen, sich unzersetzt sublimieren lassen, wenn sie mit Boronsäureester-Gruppen substituiert sind. Dies ist ein erheblicher technischer Vorteil.

**Tabelle 7**

| Verbindung | Tsublimation | Vergleich | T_{sublimation} |
|---|---|---|---|
| aus Beispiel 6 | 270 °C stabil | Standard-OLED-Material | 360 °C stabil |
| | | 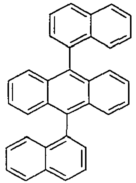 | |
| aus Referenz-Beispiel 7 | 290 °C stabil | Standard-OLED-Material | 360 °C stabil |
| | | 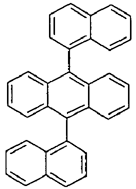 | |
| aus Referenz-Beispiel | 300 °C stabil | WO 06/000388 | 315 °C stabil |
| | | 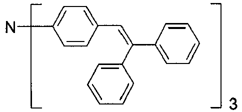 | |
| aus Referenz-Beispiel 17 | 265 °C stabil | WO 04/093207 | 290 °C stabil |
| | | 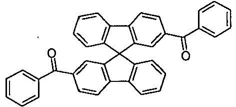 | |
| aus Referenz-Beispiel 18 | 310 °C stabil | WO 05/003253 | 385 °C stabil |
| | | 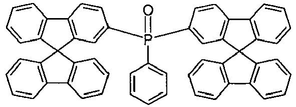 | |
| aus Referenz-Beispiel 22 | 295 °C stabil | Standard-OLED-Material | 340 °C geringe Zersetzung |
| | | 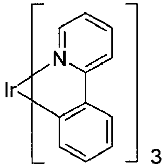 | |
| aus Referenz-Beispiel 24 | 340 °C stabil | WO 05/033244 | 385 °C starke Zersetzung |
| | | 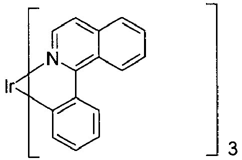 | |

## Patentansprüche

1. Organische Elektrolumineszenzvorrichtung, enthaltend mindestens eine organische Schicht, die mindestens ein aromatisches Boronsäure-Derivat enthält, wobei das Boratom dreifach substituiert ist und das Boronsäure-Derivat ein cyclisches Boronsäureanhydrid, ein Boronsäureester, ein Boronsäureamid oder ein Boronsäureamidoester ist,
**dadurch gekennzeichnet, dass** das Boronsäure-Derivat eine Struktur gemäß Formel (2) aufweist, 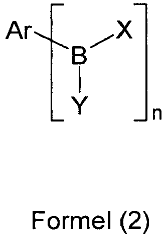 wobei für die verwendeten Symbole gilt:
Ar ist bei jedem Auftreten gleich oder verschieden ein aromatisches oder heteroaromatisches Ringsystem mit 5 bis 40 aromatischen Ringatomen, welches mit einem oder mehreren Resten R¹ substituiert sein kann;
B steht bei jedem Auftreten für ein Boratom;
X ist bei jedem Auftreten gleich oder verschieden eine Gruppe OR² oder N(R²)₂;
Y ist bei jedem Auftreten gleich oder verschieden X;
R¹ ist bei jedem Auftreten gleich oder verschieden F, Cl, Br, I, CN, eine geradkettige Alkyl-, Alkoxy- oder Thioalkoxykette mit 1 bis 40 C-Atomen oder eine verzweigte oder cyclische Alkyl-, Alkoxy- oder Thioalkoxykette mit 3 bis 40 C-Atomen, die jeweils durch R³ substituiert sein kann, in der auch ein oder mehrere nicht benachbarte C-Atome durch N-R³, O, S, CO, O-CO-O, CO-O, -CR³=CR³- oder -C≡C- ersetzt sein können und in der auch ein oder mehrere H-Atome durch F, Cl, Br, I oder CN ersetzt sein können, oder ein aromatisches oder heteroaromatisches Ringsystem mit 5 bis 40 aromatischen Ringatomen, welches auch durch einen oder mehrere Reste R³ substituiert sein kann, oder eine Kombination aus zwei, drei oder vier dieser Systeme; dabei können zwei oder mehrere Reste R¹ miteinander auch ein mono- oder polycyclisches, aliphatisches oder aromatisches Ringsystem bilden;
R² ist bei jedem Auftreten gleich oder verschieden eine geradkettige Alkylkette mit 1 bis 40 C-Atomen oder eine verzweigte oder cyclische Alkylkette mit 3 bis 40 C-Atomen, die jeweils durch R³ substituiert sein kann, in der auch ein oder mehrere nicht benachbarte C-Atome durch N-R³, O, S, CO, O-CO-O, CO-O, -CR³=CR³- oder -C=C- ersetzt sein können, mit der Maßgabe, dass kein Heteroatom direkt an den Sauerstoff bzw. Schwefel bzw. Stickstoff der Gruppe X oder Y gebunden ist, und in der auch ein oder mehrere H-Atome durch F, Cl, Br, I oder CN ersetzt sein können, oder ein aromatisches oder heteroaromatisches Ringsystem mit 5 bis 40 aromatischen Ringatomen, welches auch durch einen oder mehrere Reste R³ substituiert sein kann, oder eine Kombination aus zwei, drei oder vier dieser Systeme;
dabei bilden zwei Reste R² zusammen mit B, X und Y ein mono- oder polycyclisches, aliphatisches oder aromatisches Ringsystem;
R³ ist bei jedem Auftreten gleich oder verschieden H oder ein aliphatischer oder aromatischer Kohlenwasserstoffrest mit 1 bis 20 C-Atomen;
n ist bei jedem Auftreten gleich oder verschieden 1, 2, 3, 4, 5 oder 6.

2. Organische Elektrolumineszenzvorrichtung gemäß Anspruch 1,
**dadurch gekennzeichnet, dass** das Boronsäure-Derivat glasartige Filme mit einer Glasübergangstemperatur Tg von größer 70 °C bildet.

3. Organische Elektrolumineszenzvorrichtung gemäß Anspruch 1 oder 2,
**dadurch gekennzeichnet, dass** das Boronsäure-Derivat ein Molekulargewicht von mindestens 250 g/mol aufweist.

4. Organische Elektrolumineszenzvorrichtung gemäß einem oder mehreren der Ansprüche 1 bis 3, **dadurch gekennzeichnet, dass** die organische Elektrolumineszenzvorrichtung Anode, Kathode und mindestens eine Emissionsschicht enthält, die Fluoreszenz oder Phosphoreszenz zeigt.

5. Organische Elektrolumineszenzvorrichtung gemäß Anspruch 4, **dadurch gekennzeichnet, dass** weitere Schichten vorhanden sind, ausgewählt aus Lochinjektionsschicht, Lochtransportschicht, Lochblockierschicht, Elektronentransportschicht und/oder Elektroneninjektionsschicht.

6. Organische Elektrolumineszenzvorrichtung gemäß einem oder mehreren der Ansprüche 1 bis 5, **dadurch gekennzeichnet, dass** das Boronsäure-Derivat in einer Emissionsschicht in Kombination mit einem fluoreszierenden oder phosphoreszierenden Dotanden eingesetzt wird.

7. Organische Elektrolumineszenzvorrichtung gemäß Anspruch 6, **dadurch gekennzeichnet, dass** der fluoreszierende Dotand ausgewählt ist aus der Klasse der Monostyrylamine, der Distyrylamine, der Tristyrylamine, der Tetrastyrylamine und der Arylamine.

8. Organische Elektrolumineszenzvorrichtung gemäß Anspruch 6, **dadurch gekennzeichnet, dass** der phosphoreszierende Dotand ausgewählt ist aus der Klasse der Metallkomplexe, enthaltend mindestens ein Element der Ordnungszahl größer 20, bevorzugt größer 38 und kleiner 84.

9. Organische Elektrolumineszenzvorrichtung gemäß einem oder mehreren der Ansprüche 1 bis 8, **dadurch gekennzeichnet, dass** das Boronsäure-Derivat als Elektronentransportmaterial als Reinsubstanz oder in einer Mischung in einer Elektronentransportschicht eingesetzt wird und/oder dass das Boronsäure-Derivat als Lochblockiermaterial als Reinsubstanz oder in einer Mischung in einer Lochblockierschicht eingesetzt wird.

10. Organische Elektrolumineszenzvorrichtung gemäß einem oder mehreren der Ansprüche 1 bis 9, **dadurch gekennzeichnet, dass** das Boronsäure-Derivat als Lochtransportmaterial als Reinsubstanz oder in einer Mischung in einer Lochtransportschicht oder in einer Lochinjektionsschicht in einer organischen Elektrolumineszenzvorrichtung eingesetzt wird.

11. Organische Elektrolumineszenzvorrichtung gemäß einem oder mehreren der Ansprüche 1 bis 10, **dadurch gekennzeichnet, dass** das Boronsäure-Derivat als fluoreszierender oder phosphoreszierender Dotand, bevorzugt in Kombination mit einem Host-Material, in einer Emissionsschicht in einer fluoreszierenden bzw. phosphoreszierenden organischen Elektrolumineszenzvorrichtung eingesetzt wird.

12. Organische Elektrolumineszenzvorrichtung gemäß einem oder mehreren der Ansprüche 1 bis 11, **dadurch gekennzeichnet, dass** das Symbol X in Formel (2) für OR² steht.

13. Organische Elektrolumineszenzvorrichtung gemäß Anspruch 12, **dadurch gekennzeichnet, dass** in Formel (2) das Symbol X für OR² und das Symbol Y gleichzeitig für OR² steht.

14. Organische Elektrolumineszenzvorrichtung gemäß einem oder mehreren der Ansprüche 1 bis 13, **dadurch gekennzeichnet, dass** in Formel (2) die Symbole X und Y gleich oder verschieden bei jedem Auftreten für N(R²)₂ stehen.

15. Organische Elektrolumineszenzvorrichtung gemäß einem oder mehreren der Ansprüche 1 bis 14, **dadurch gekennzeichnet, dass** die Reste R¹ bei jedem Auftreten gleich oder verschieden für F, eine geradkettige Alkyl- oder Alkoxykette mit 1 bis 10 C-Atomen oder eine verzweigte Alkyl- oder Alkoxykette mit 3 bis 10 C-Atomen, die jeweils durch R³ substituiert sein kann, in der auch ein oder mehrere nicht benachbarte C-Atome durch N-R³, O, S, -CR³=CR³- oder -C≡C- ersetzt sein können und in der auch ein oder mehrere H-Atome durch F oder CN ersetzt sein können, oder ein aromatisches oder heteroaromatisches Ringsystem mit 5 bis 16 aromatischen Ringatomen, welches auch durch einen oder mehrere Reste R³ substituiert sein kann, oder eine Kombination aus zwei oder drei dieser Systeme stehen; dabei können zwei oder mehrere Reste R¹ miteinander auch ein mono- oder polycyclisches, aliphatisches oder aromatisches Ringsystem bilden.

16. Organische Elektrolumineszenzvorrichtung gemäß einem oder mehreren der Ansprüche 1 bis 15, **dadurch gekennzeichnet, dass** die Reste R² bei jedem Auftreten gleich oder verschieden für eine geradkettige Alkylkette mit 1 bis 10 C-Atomen oder eine verzweigte oder cyclische Alkylkette mit 3 bis 10 C-Atomen, die jeweils durch R³ substituiert sein kann, in der auch ein oder mehrere nicht benachbarte C-Atome durch N-R³, O, S, -CR³=CR³- oder -C≡C- ersetzt sein können, mit der Maßgabe, dass kein Heteroatom direkt an den Sauerstoff bzw. Schwefel bzw. Stickstoff der Gruppe X oder Y gebunden ist, und in der auch ein oder mehrere H-Atome durch F ersetzt sein können, oder ein aromatisches oder heteroaromatisches Ringsystem mit 5 bis 16 aromatischen Ringatomen, welches auch durch einen oder mehrere Reste R³ substituiert sein kann, oder eine Kombination aus zwei oder drei dieser Systeme stehen; dabei können zwei oder mehrere Reste R² miteinander auch ein weiteres mono- oder polycyclisches, aliphatisches oder aromatisches Ringsystem bilden.

17. Organische Elektrolumineszenzvorrichtung gemäß einem oder mehreren der Ansprüche 1 bis 16, **dadurch gekennzeichnet, dass** zwei Reste R² zusammen mit B, X und Y einen Fünf-, Sechs- oder Siebenring bilden.

18. Organische Elektrolumineszenzvorrichtung gemäß einem oder mehreren der Ansprüche 1 bis 17, **dadurch gekennzeichnet, dass** für die Verwendung als Hostmaterial für fluoreszierende Emitter das aromatische Ringsystem Ar mindestens eine kondensierte Aryl- oder Heteroarylgruppe enthält, die bevorzugt direkt an das Boratom gebunden ist.

19. Organische Elektrolumineszenzvorrichtung gemäß einem oder mehreren der Ansprüche 1 bis 17, **dadurch gekennzeichnet, dass** für die Verwendung als Hostmaterial für phosphoreszierende Emitter das aromatische Ringsystem Ar in einer bevorzugten Ausführungsform nur Aryl- oder Heteroarylgruppen mit 5 bis 14 aromatischen Ringatomen enthält.

20. Organische Elektrolumineszenzvorrichtung gemäß einem oder mehreren der Ansprüche 1 bis 17, **dadurch gekennzeichnet, dass** für die Verwendung als Lochtransportmaterial für fluoreszierende oder phosphoreszierende organische Elektrolumineszenzvorrichtungen oder für andere organische elektronische Vorrichtungen die Gruppe Ar mindestens eine Triarylamin-Einheit und/oder mindestens ein Thiophen-Derivat enthält.

21. Organische Elektrolumineszenzvorrichtung gemäß einem oder mehreren der Ansprüche 1 bis 17, **dadurch gekennzeichnet, dass** für die Verwendung als fluoreszierender Dotand für organische Elektrolumineszenzvorrichtungen die Gruppe Ar mindestens eine Stilben-Einheit und/oder mindestens eine Tolan-Einheit enthält und bevorzugt weiterhin eine oder mehrere Triarylamin-Einheiten enthält.

22. Verwendung von aromatischen Boronsäure-Derivaten gemäß der Formel (2), wie in Anspruch 1 definiert, in organischen Elektrolumineszenzvorrichtungen.

23. Verbindungen gemäß Formel (27), (27a) und (28), 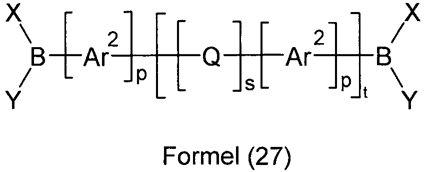 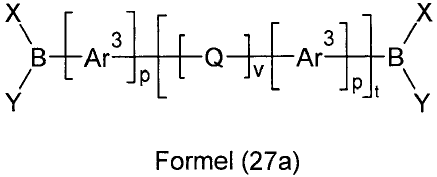 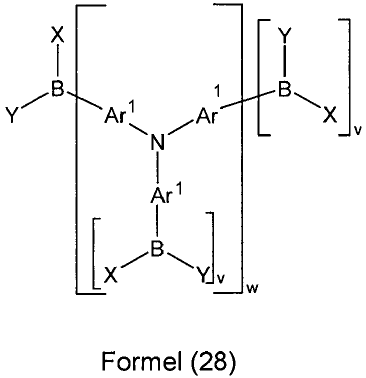 wobei B, X, Y, Ar und R¹ dieselbe Bedeutung haben, wie in Anspruch 1 beschrieben und weiterhin gilt:
Ar¹ ist gleich oder verschieden bei jedem Auftreten eine Aryl- oder Heteroarylgruppe mit 5 bis 40 aromatischen Ringatomen, welche durch R¹ substituiert sein kann;
Ar² ist bei jedem Auftreten gleich oder verschieden eine kondensierte Aryl- oder Heteroarylgruppe mit 9 bis 20 aromatischen Ringatomen, welche mit R¹ substituiert sein kann;
Ar³ ist bei jedem Auftreten gleich oder verschieden eine Fluoren- oder Spirobifluorengruppe, welche mit R¹ substituiert sein kann;
Q ist bei jedem Auftreten gleich oder verschieden eine bivalente Einheit, ausgewählt aus Ar, O, S, SO, SO₂, Se, SeO, SeO₂ Te, TeO, TeO₂, NAr, PAr, P(=O)Ar, AsAr, As(=O)Ar, SbAr, Sb(=O)Ar, C(R¹)₂, C=O, Si(R¹)₂ oder O-BAr-O;
p ist bei jedem Auftreten gleich oder verschieden 1, 2, 3, 4, 5 oder 6;
s ist 0 oder 1;
t ist 1, 2, 3, 4 oder 5;
v ist bei jedem Auftreten gleich oder verschieden 0 oder 1;
w ist bei jedem Auftreten gleich oder verschieden 1, 2, 3, 4, 5 oder 6; mit der Maßgabe, dass in Formel (27) Ar² nicht bei jedem Auftreten Naphthyl ist, wenn alle p = 1 und gleichzeitig s = 0 ist und t = 1 sind, und weiterhin mit der Maßgabe, dass Boronsäureester der Formel (28), gebildet mit Pinacol, 1,2-Ethandiol, 2,2-Dimethyl-1,3-Propandiol, 2,3-Butandiol und iso-Propanol von der Erfindung ausgenommen sind.

24. Verbindungen gemäß Formel (29), (29a) und (29b), 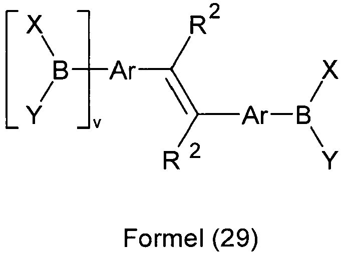 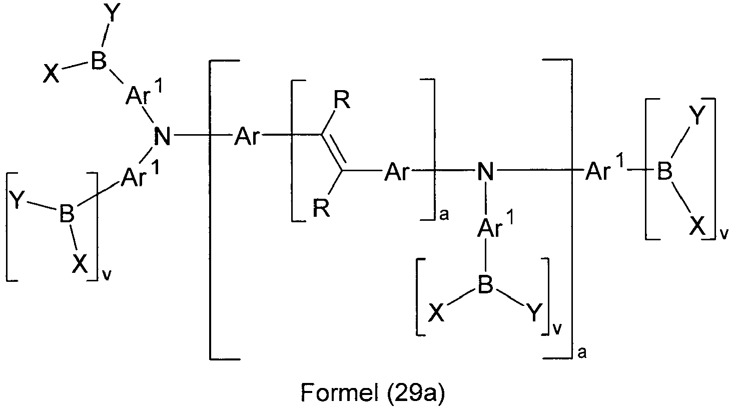 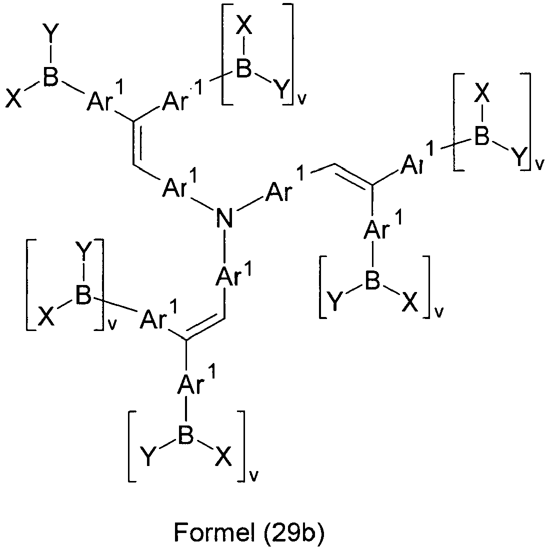 wobei B, X, Y, Ar, Ar¹, R¹, R² und v dieselbe Bedeutung haben, wie in Anspruch 1 und 23 beschrieben, und wobei a bei jedem Auftreten gleich oder verschieden für 1, 2 oder 3 steht, mit der Maßgabe, dass es sich für Strukturen der Formel (29) nicht um Boronsäureester von Pinacol, Glycol und/oder 1,3-Propandiol handelt.

## Claims

1. Organic electroluminescent device, comprising at least one organic layer which comprises at least one aromatic boronic acid derivative, where the boron atom is trisubstituted and the boronic acid derivative is a cyclic boronic acid anhydride, a boronic acid ester, a boronic acid amide or a boronic acid amidoester,
**characterised in that** the boronic acid derivative has a structure of the formula (2), 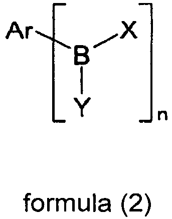 where the following applies to the symbols used:
Ar is on each occurrence, identically or differently, an aromatic or heteroaromatic ring system having 5 to 40 aromatic ring atoms, which may be substituted by one or more radicals R¹;
B stands on each occurrence for a boron atom;
X is on each occurrence, identically or differently, a group OR², or N(R²)₂;
Y is on each occurrence, identically or differently, X;
R¹ is on each occurrence, identically or differently, F, Cl, Br, I, CN, a straight-chain alkyl, alkoxy or thioalkoxy chain having 1 to 40 C atoms or a branched or cyclic alkyl, alkoxy or thioalkoxy chain having 3 to 40 C atoms, each of which may be substituted by R³ and in which one or more non-adjacent C atoms may be replaced by N-R³, O, S, CO, O-CO-O, CO-O, -CR³=CR³- or -C≡C- and in which, in addition, one or more H atoms may be replaced by F, Cl, Br, I or CN, or an aromatic or heteroaromatic ring system having 5 to 40 aromatic ring atoms, which may also be substituted by one or more radicals R³ or a combination of two, three or four of these systems; two or more radicals R¹ here may also form a mono- or polycyclic, aliphatic or aromatic ring system with one another;
R² is on each occurrence, identically or differently, a straight-chain alkyl chain having 1 to 40 C atoms or a branched or cyclic alkyl chain having 3 to 40 C atoms, each of which may be substituted by R³ and in which, in addition, one or more non-adjacent C atoms may be replaced by N-R³, O, S, CO, O-CO-O, CO-O, -CR³=CR³- or -C≡C-, with the proviso that a heteroatom is not bonded directly to the oxygen or sulfur or nitrogen of the group X or Y, and in which one or more H atoms may be replaced by F, Cl, Br, I or CN, or an aromatic or heteroaromatic ring system having 5 to 40 aromatic ring atoms, which may also be substituted by one or more radicals R³, or a combination of two, three or four of these systems;
two radicals R² here together with B, X and Y may form a mono- or polycyclic, aliphatic or aromatic ring system;
R³ is on each occurrence, identically or differently, H or an aliphatic or aromatic hydrocarbon radical having 1 to 20 C atoms;
n is on each occurrence, identically or differently, 1, 2, 3, 4, 5 or 6.

2. Organic electroluminescent device according to Claim 1, **characterised in that** the boronic acid derivative forms glass-like films having a glass transition temperature T_{g} of greater than 70°C.

3. Organic electroluminescent device according to Claim 1 or 2, **characterised in that** the boronic acid derivative has a molecular weight of at least 250 g/mol.

4. Organic electroluminescent device according to one or more of Claims 1 to 3, **characterised in that** the organic electroluminescent device comprises anode, cathode and at least one emission layer which exhibits fluorescence or phosphorescence.

5. Organic electroluminescent device according to Claim 4, **characterised in that** further layers are present, selected from hole-injection layer, hole-transport layer, hole-blocking layer, electron-transport layer and/or electron-injection layer.

6. Organic electroluminescent device according to one or more of Claims 1 to 5, **characterised in that** the boronic acid derivative is employed in an emission layer in combination with a fluorescent or phosphorescent dopant.

7. Organic electroluminescent device according to Claim 6, **characterised in that** the fluorescent dopant is selected from the class of the monostyrylamines, the distyrylamines, the tristyrylamines, the tetrastyrylamines and the arylamines.

8. Organic electroluminescent device according to Claim 6, **characterised in that** the phosphorescent dopant is selected from the class of the metal complexes containing at least one element having an atomic number of greater than 20, preferably greater than 38 and less than 84.

9. Organic electroluminescent device according to one or more of Claims 1 to 8, **characterised in that** the boronic acid derivative is employed as electron-transport material as the pure substance or in a mixture in an electron-transport layer and/or **in that** the boronic acid derivative is employed as hole-blocking material as the pure substance or in a mixture in a hole-blocking layer.

10. Organic electroluminescent device according to one or more of Claims 1 to 9, **characterised in that** the boronic acid derivative is employed as hole-transport material as the pure substance or in a mixture in a hole-transport layer or in a hole-injection layer in an organic electroluminescent device.

11. Organic electroluminescent device according to one or more of Claims 1 to 10, **characterised in that** the boronic acid derivative is employed as fluorescent or phosphorescent dopant, preferably in combination with a host material, in an emission layer in a fluorescent or phosphorescent organic electroluminescent device.

12. Organic electroluminescent device according to one or more of Claims 1 to 11, **characterised in that** the symbol X in formula (2) stands for OR².

13. Organic electroluminescent device according to Claim 12, **characterised in that**, in formula (2), the symbol X stands for OR² and the symbol Y simultaneously stands for OR².

14. Organic electroluminescent device according to one or more of Claims 1 to 13, **characterised in that**, in formula (2), the symbols X and Y stand, identically or differently on each occurrence, for N(R²)₂.

15. Organic electroluminescent device according to one or more of Claims 1 to 14, **characterised in that** the radicals R¹ on each occurrence, identically or differently, stand for F, a straight-chain alkyl or alkoxy chain having 1 to 10 C atoms or a branched alkyl or alkoxy chain having 3 to 10 C atoms, each of which may be substituted by R³ and in which one or more non-adjacent C atoms may be replaced by N-R³, O, S, -CR³≡CR³- or -C≡C- and in which, in addition, one or more H atoms may be replaced by F or CN, or an aromatic or heteroaromatic ring system having 5 to 16 aromatic ring atoms, which may also be substituted by one or more radicals R³, or a combination of two or three of these systems; two or more radicals R¹ here may also form a mono- or polycyclic, aliphatic or aromatic ring system with one another.

16. Organic electroluminescent device according to one or more of Claims 1 to 15, **characterised in that** the radicals R² on each occurrence, identically or differently, stand for a straight-chain alkyl chain having 1 to 10 C atoms or a branched or cyclic alkyl chain having 3 to 10 C atoms, each of which may be substituted by R³ and in which one or more non-adjacent C atoms may be replaced by N-R³, O, S, -CR³=CR³- or -C≡C-, with the proviso that a heteroatom is not bonded directly to the oxygen or sulfur or nitrogen of the group X or Y, and in which, in addition, one or more H atoms may be replaced by F, or an aromatic or heteroaromatic ring system having 5 to 16 aromatic ring atoms, which may also be substituted by one or more radicals R³, or a combination of two or three of these systems; two or more radicals R² here may also form a further mono- or polycyclic, aliphatic or aromatic ring system with one another.

17. Organic electroluminescent device according to one or more of Claims 1 to 16, **characterised in that** two radicals R² together with B, X and Y form a five-, six- or seven-membered ring.

18. Organic electroluminescent device according to one or more of Claims 1 to 17, **characterised in that**, for use as host material for fluorescent emitters, the aromatic ring system Ar contains at least one condensed aryl or heteroaryl group, which is preferably bonded directly to the boron atom.

19. Organic electroluminescent device according to one or more of Claims 1 to 17, **characterised in that**, for use as host material for phosphorescent emitters, the aromatic ring system Ar in a preferred embodiment contains only aryl or heteroaryl groups having 5 to 14 aromatic ring atoms.

20. Organic electroluminescent device according to one or more of Claims 1 to 17, **characterised in that**, for use as hole-transport material for fluorescent or phosphorescent organic electroluminescent devices or for other organic electronic devices, the group Ar contains at least one triarylamine unit and/or at least one thiophene derivative.

21. Organic electroluminescent device according to one or more of Claims 1 to 17, **characterised in that**, for use as fluorescent dopant for organic electroluminescent devices, the group Ar contains at least one stilbene unit and/or at least one tolan unit and preferably furthermore contains one or more triarylamine units.

22. Use of aromatic boron acid derivatives of the formula (2), as defined in Claim 1, in organic electroluminescent devices.

23. Compounds of the formulae (27), (27a) and (28), 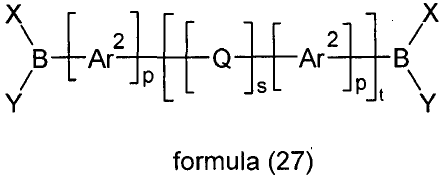 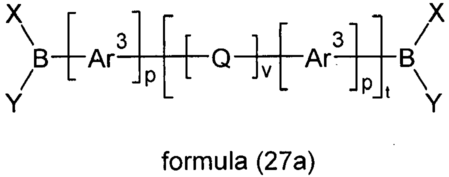 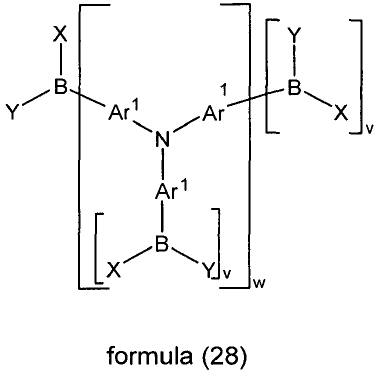 where B, X, Y, Ar and R¹ have the same meaning as described in Claim 1 and furthermore the following applies:
Ar¹ is, identically or differently on each occurrence, an aryl or heteroaryl group having 5 to 40 aromatic ring atoms, which may be substituted by R¹;
Ar² is on each occurrence, identically or differently, a condensed aryl or heteroaryl group having 9 to 20 aromatic ring atoms, which may be substituted by R¹;
Ar³ is on each occurrence, identically or differently, a fluorene or spirobifluorene group, which may be substituted by R¹;
Q is on each occurrence, identically or differently, a divalent unit selected from Ar, O, S, SO, SO₂, Se, SeO, SeO₂, Te, TeO, TeO₂, NAr, PAr, P(=O)Ar, AsAr, As(=O)Ar, SbAr, Sb(=O)Ar, C(R¹)₂, C=O, Si(R¹)₂ and O-BAr-O;
p is on each occurrence, identically or differently, 1, 2, 3, 4, 5 or 6;
s is 0 or 1;
t is 1, 2, 3, 4 or 5;
v is on each occurrence, identically or differently, 0 or 1
w is on each occurrence, identically or differently, 1, 2, 3, 4, 5 or 6;
with the proviso that in formula (27) Ar² is not naphthyl on each occurrence if all p = 1 and at the same time s = 0 and t = 1, and furthermore with the proviso that boronic acid esters of the formula (28) formed with pinacol, 1,2-ethanediol, 2,2-dimethyl-1,3-propanediol, 2,3-butanediol and isopropanol are excluded from the invention.

24. Compounds of the formulae (29), (29a) and (29b), 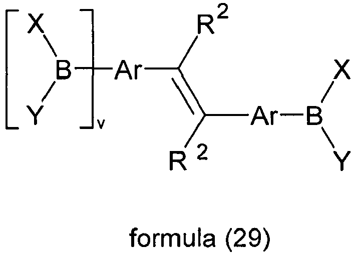 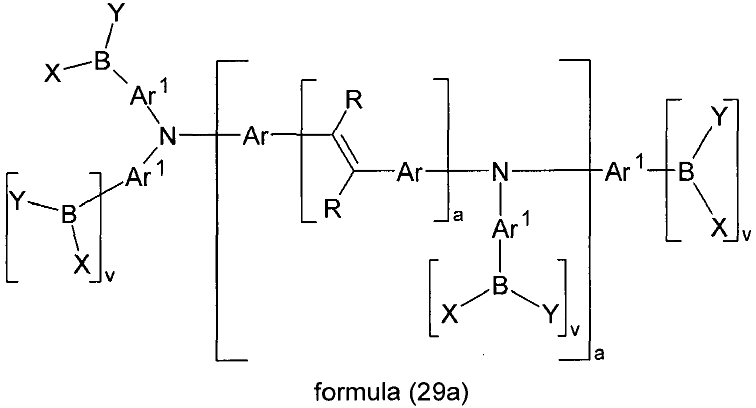 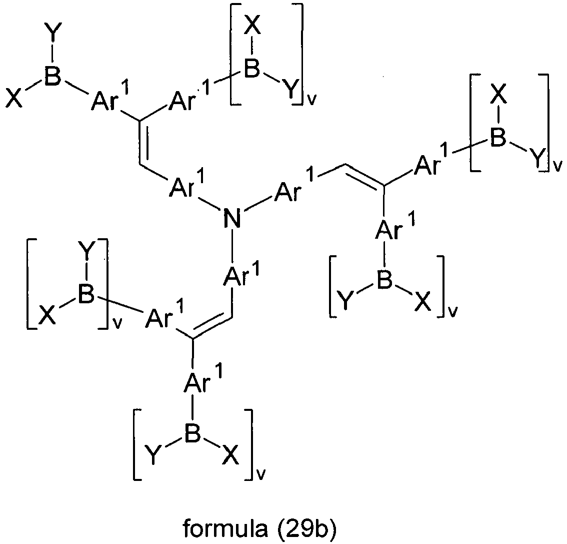 where B, X, Y, Ar, Ar¹, R¹, R² and v have the same meaning as described in Claims 1 and 23, and where a on each occurrence, identically or differently, stands for 1, 2 or 3, with the proviso that structures of the formula (29) are not boronic acid esters of pinacol, glycol and/or 1,3-propanediol.

## Revendications

1. Dispositif électroluminescent organique, comprenant au moins une couche organique qui comprend au moins un dérivé d'acide boronique aromatique, où l'atome de bore est trisubstitué et le dérivé d'acide boronique est un anhydride d'acide boronique cyclique, un ester d'acide boronique, un amide d'acide boronique ou un amidoester d'acide boronique,
**caractérisé en ce que** le dérivé d'acide boronique présente une structure de la formule (2) : 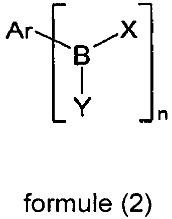 dans laquelle ce qui suit s'applique aux symboles utilisés :
Ar est pour chaque occurrence, de manière identique ou différente, un système de cycle aromatique ou hétéroaromatique comportant 5 à 40 atomes de cycle aromatique, lequel peut être substitué par un radical ou plusieurs radicaux R¹ ;
B représente pour chaque occurrence un atome de bore: ;
X est pour chaque occurrence, de manière identique ou différente, un groupe OR² ou N(R²)₂ ;
Y est pour chaque occurrence, de manière identique ou différente, X ;
R¹ est pour chaque occurrence, de manière identique ou différente, F, CI, Br, I, CN, une chaîne alkyle, alcoxy ou thioalcoxy en chaîne droite comportant 1 à 40 atome(s) de C ou une chaîne alkyle, alcoxy ou thioalcoxy ramifiée ou cyclique comportant 3 à 40 atomes de C, dont chacune peut être substituée par R³ et dans lesquelles un ou plusieurs atome(s) de C non adjacents peut/peuvent être remplacé(s) par N-R³, O, S, CO, O-CO-O, CO-O, -CR³=CR³- ou -C≡C- et dans lesquelles, en outre, un ou plusieurs atome(s) de H peut/peuvent être remplacé(s) par F, CI, Br, I ou CN, ou un système de cycle aromatique ou hétéroaromatique comportant 5 à 40 atomes de cycle aromatique, lequel peut également être substitué par un radical ou plusieurs radicaux R³, ou une combinaison de deux, trois ou quatre de ces systèmes ; deux radicaux R¹ ou plus peuvent ici également former un système de cycle aliphatique ou aromatique monocyclique ou polycyclique l'un avec l'autre ou les uns avec les autres ;
R² est pour chaque occurrence, de manière identique ou différente, une chaîne alkyle en chaîne droite comportant 1 à 40 atome(s) de C ou une chaîne alkyle ramifiée ou cyclique comportant 3 à 40 atomes de C, dont chacune peut être substituée par R³ et dans lesquelles, en outre, un ou plusieurs atome(s) de C non adjacents peut/peuvent être remplacé(s) par N-R³, O, S, CO, O-CO-O, CO-O, -CR³=CR³- ou -C≡C-, étant entendu qu'un hétéroatome n'est pas lié directement à l'oxygène ou au soufre ou à l'azote du groupe X ou Y, et dans lesquelles un ou plusieurs atome(s) de H peut/ peuvent être remplacé(s) par F, CI, Br, I ou CN, ou un système de cycle aromatique ou hétéroaromatique comportant 5 à 40 atomes de cycle aromatique, lequel peut également être substitué par un radical ou plusieurs radicaux R³, ou une combinaison de deux, trois ou quatre de ces systèmes ;
deux radicaux R², ici en association avec B, X et Y, peuvent former un système de cycle aliphatique ou aromatique monocyclique ou polycyclique ;
R³ est pour chaque occurrence, de manière identique ou différente, H ou un radical hydrocarbone aliphatique ou aromatique comportant 1 à 20 atome(s) de C ; et
n est pour chaque occurrence, de manière identique ou différente, 1, 2, 3, 4, 5 ou 6.

2. Dispositif électroluminescent organique selon la revendication 1, **caractérisé en ce que** le dérivé d'acide boronique forme des films similaires à du verre présentant une température de transition vitreuse T_{g} supérieure à 70°C.

3. Dispositif électroluminescent organique selon la revendication 1 ou 2, **caractérisé en ce que** le dérivé d'acide boronique présente un poids moléculaire d'au moins 250 g/mol.

4. Dispositif électroluminescent organique selon une ou plusieurs des revendications 1 à 3, **caractérisé en ce que** le dispositif électroluminescent organique comprend une anode, une cathode et au moins une couche d'émission qui présente une fluorescence ou une phosphorescence.

5. Dispositif électroluminescent organique selon la revendication 4, **caractérisé en ce que** d'autres couches sont présentes, choisies parmi une couche d'injection de trous, une couche de transport de trous, une couche de blocage de trous, une couche de transport d'électrons et/ou une couche d'injection d'électrons.

6. Dispositif électroluminescent organique selon une ou plusieurs des revendications 1 à 5, **caractérisé en ce que** le dérivé d'acide boronique est utilisé dans une couche d'émission en combinaison avec un dopant fluorescent ou phosphorescent.

7. Dispositif électroluminescent organique selon la revendication 6, **caractérisé en ce que** le dopant fluorescent est choisi parmi la classe des monostyrylamines, des distyrylamines, des tristyrylamines, des tétrastyrylamines et des arylamines.

8. Dispositif électroluminescent organique selon la revendication 6, **caractérisé en ce que** le dopant phosphorescent est choisi parmi la classe des complexes métalliques contenant au moins un élément présentant un numéro atomique supérieur à 20, de façon préférable supérieur à 38 et inférieur à 84.

9. Dispositif électroluminescent organique selon une ou plusieurs des revendications 1 à 8, **caractérisé en ce que** le dérivé d'acide boronique est utilisé en tant que matériau de transport d'électrons en tant que substance pure ou selon un mélange dans une couche de transport d'électrons et/ou **en ce que** le dérivé d'acide boronique est utilisé en tant que matériau de blocage de trous en tant que substance pure ou selon un mélange dans une couche de blocage de trous.

10. Dispositif électroluminescent organique selon une ou plusieurs des revendications 1 à 9, **caractérisé en ce que** le dérivé d'acide boronique est utilisé en tant que matériau de transport de trous en tant que substance pure ou selon un mélange dans une couche de transport de trous ou dans une couche d'injection de trous dans un dispositif électroluminescent organique.

11. Dispositif électroluminescent organique selon une ou plusieurs des revendications 1 à 10, **caractérisé en ce que** le dérivé d'acide boronique est utilisé en tant que dopant fluorescent ou phosphorescent, de façon préférable en combinaison avec un matériau hôte, dans une couche d'émission dans un dispositif électroluminescent fluorescent ou phosphorescent.

12. Dispositif électroluminescent organique selon une ou plusieurs des revendications 1 à 11, **caractérisé en ce que** le symbole X dans la formule (2) représente OR².

13. Dispositif électroluminescent organique selon la revendication 12, **caractérisé en ce que**, dans la formule (2), le symbole X représente OR² et le symbole Y représente simultanément OR².

14. Dispositif électroluminescent organique selon une ou plusieurs des revendications 1 à 13, **caractérisé en ce que**, dans la formule (2), les symboles X et Y représentent, de manière identique ou différente pour chaque occurrence, N(R²)₂.

15. Dispositif électroluminescent organique selon une ou plusieurs des revendications 1 à 14, **caractérisé en ce que** les radicaux R¹ pour chaque occurrence, de manière identique ou différente, représentent F, une chaîne alkyle ou alcoxy en chaîne droite comportant 1 à 10 atome(s) de C ou une chaîne alkyle ou alcoxy ramifiée ou cyclique comportant 3 à 10 atomes de C, dont chacune peut être substituée par R³ et dans lesquelles un ou plusieurs atome(s) de C non adjacents peut/peuvent être remplacé(s) par N-R³, O, S, -CR³=CR³- ou -C≡C- et dans lesquelles, en outre, un ou plusieurs atome(s) de H peut/peuvent être remplacé(s) par F ou CN, ou un système de cycle aromatique ou hétéroaromatique comportant 5 à 16 atomes de cycle aromatique, lequel peut également être substitué par un radical ou plusieurs radicaux R³, ou une combinaison de deux ou trois de ces systèmes ; deux radicaux R¹ ou plus peuvent ici également former un système de cycle aliphatique ou aromatique monocyclique ou polycyclique l'un avec l'autre ou les uns avec les autres.

16. Dispositif électroluminescent organique selon une ou plusieurs des revendications 1 à 15, **caractérisé en ce que** les radicaux R² pour chaque occurrence, de manière identique ou différente, représentent une chaîne alkyle en chaîne droite comportant 1 à 10 atome(s) de C ou une chaîne alkyle ramifiée ou cyclique comportant 3 à 10 atomes de C, dont chacune peut être substituée par R³ et dans lesquelles un ou plusieurs atome(s) de C non adjacents peut/peuvent être remplacé(s) par N-R³, O, S, -CR³=CR³- ou -C≡C-, étant entendu qu'un hétéroatome n'est pas lié directement à l'oxygène ou au soufre ou à l'azote du groupe X ou Y, et dans lesquelles, en outre, un ou plusieurs atome(s) de H peut/peuvent être remplacé(s) par F, ou un système de cycle aromatique ou hétéroaromatique comportant 5 à 16 atomes de cycle aromatique, lequel peut également être substitué par un radical ou plusieurs radicaux R³, ou une combinaison de deux ou trois de ces systèmes ; deux radicaux R² ou plus peuvent ici également former un autre système de cycle aliphatique ou aromatique monocyclique ou polycyclique l'un avec l'autre ou les uns avec les autres.

17. Dispositif électroluminescent organique selon une ou plusieurs des revendications 1 à 16, **caractérisé en ce que** deux radicaux R² en association avec B, X et Y forment un cycle à cinq, six ou sept éléments.

18. Dispositif électroluminescent organique selon une ou plusieurs des revendications 1 à 17, **caractérisé en ce que**, pour une utilisation en tant que matériau hôte pour des émetteurs fluorescents, le système de cycle aromatique Ar contient au moins un groupe aryle ou hétéroaryle condensé, lequel est de façon préférable lié directement à l'atome de bore.

19. Dispositif électroluminescent organique selon une ou plusieurs des revendications 1 à 17, **caractérisé en ce que**, pour une utilisation en tant que matériau hôte pour des émetteurs phosphorescents, le système de cycle aromatique Ar, selon un mode de réalisation préféré, contient seulement des groupes aryle ou hétéroaryle comportant 5 à 14 atomes de cycle aromatique.

20. Dispositif électroluminescent organique selon une ou plusieurs des revendications 1 à 17, **caractérisé en ce que**, pour une utilisation en tant que matériau de transport de trous pour des dispositifs électroluminescents organiques fluorescents ou phosphorescents ou pour d'autres dispositifs électroniques organiques, le groupe Ar contient au moins une unité de triarylamine et/ou au moins un dérivé de thiophène.

21. Dispositif électroluminescent organique selon une ou plusieurs des revendications 1 à 17, **caractérisé en ce que**, pour une utilisation en tant que dopant fluorescent pour des dispositifs électroluminescents organiques, le groupe Ar contient au moins une unité de stilbène et/ou au moins une unité de tolane et de façon encore plus préférable, contient une ou plusieurs unités de triarylamine.

22. Utilisation de dérivés d'acide boronique aromatique de la formule (2), comme défini selon la revendication 1, dans des dispositifs électroluminescents organiques.

23. Composés des formules (27), (27a) et (28) : 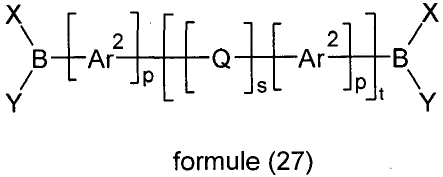 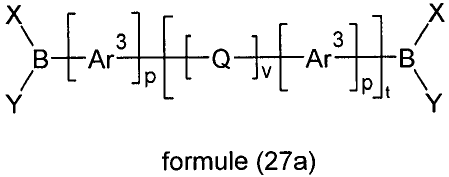 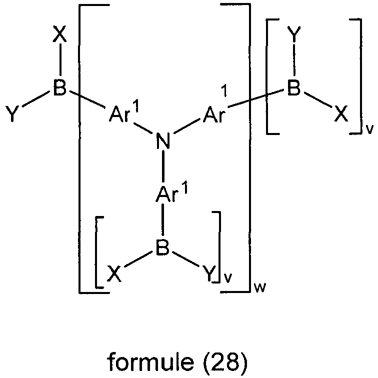 dans lesquelles B, X, Y, Aret R¹ présentent la même signification que décrit selon la revendication 1 et en outre, ce qui suit s'applique :
Ar¹ est, de manière identique ou différente pour chaque occurrence, un groupe aryle ou hétéroaryle comportant 5 à 40 atomes de cycle aromatique, lequel peut être substitué par R¹ ;
Ar² est pour chaque occurrence, de manière identique ou différente, un groupe aryle ou hétéroaryle condensé comportant 9 à 20 atomes de cycle aromatique, lequel peut être substitué par R¹ ;
Ar³ est pour chaque occurrence, de manière identique ou différente, un groupe fluorène ou spirobifluorène, lequel peut être substitué par R¹ ;
Q est pour chaque occurrence, de manière identique ou différente, une unité divalente choisie parmi Ar, O, S, SO, SO₂, Se, SeO, SeO₂, Te, TeO, TeO₂, NAr, PAr, P(=O)Ar, AsAr, As(=O)Ar, SbAr, Sb(=O)Ar, C(R¹)₂, C=O, Si(R¹)₂ et O-BAr-O ;
p est pour chaque occurrence, de manière identique ou différente, 1, 2, 3, 4, 5 ou 6 ;
s est 0 ou 1 ;
t est 1, 2, 3, 4 ou 5 ;
v est pour chaque occurrence, de manière identique ou différente, 0 ou 1 ;
w est pour chaque occurrence, de manière identique ou différente, 1, 2, 3, 4, 5 ou 6;
étant entendu que dans la formule (27), Ar² n'est pas naphtyle pour chaque occurrence si tous les p = 1 et que dans le même temps, s = 0 et t = 1, et en outre étant entendu que des esters d'acide boronique de la formule (28) formés avec pinacol, 1,2-éthanediol, 2,2-diméthyl-1,3-propanediol, 2,3-butanediol et isopropanol sont exclus de l'invention.

24. Composés des formules (29), (29a) et (29b) ; 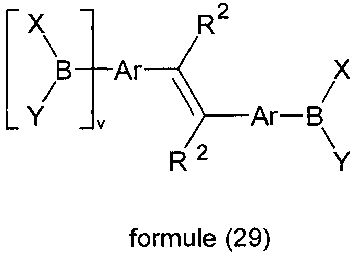 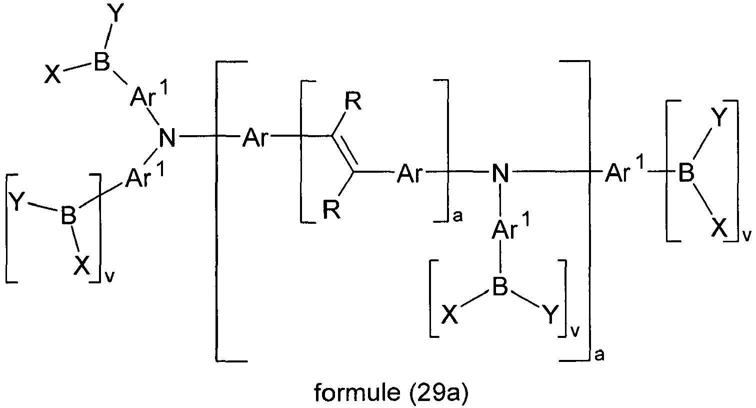 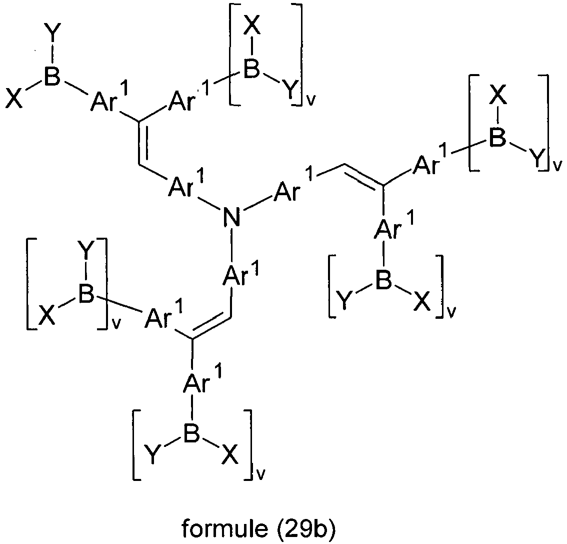 dans lesquelles B, X, Y, Ar, Ar¹, R¹, R² et v présentent la même signification que décrit selon les revendications 1 et 23, et dans lesquelles a, pour chaque occurrence, de manière identique ou différente, représente 1, 2 ou 3, étant entendu que les structures de la formule (29) ne sont pas des esters d'acide boronique de pinacol, glycol et/ou 1,3-propanediol.
